(19)

Europäisches Patentamt

European Patent Office

Office européen des brevets

(11) **EP 1 930 960 A1**

(12) **EUROPEAN PATENT APPLICATION**

(43) Date of publication:
   **11.06.2008 Bulletin 2008/24**

(51) Int Cl.:
   **H01L 35/18** (2006.01)

(21) Application number: **06125354.8**

(22) Date of filing: **04.12.2006**

(84) Designated Contracting States:
   **AT BE BG CH CY CZ DE DK EE ES FI FR GB GR HU IE IS IT LI LT LU LV MC NL PL PT RO SE SI SK TR**
   Designated Extension States:
   **AL BA HR MK RS**

(71) Applicants:
   • **Aarhus Universitet**
      **8000 Aarhus C (DK)**
   • **Max-Planck-Gesellschaft zur Förderung der Wissenschaften e.V.**
      **80539 München (DE)**

(72) Inventors:
   • **Bentien, Anders**
      **8541 Skodstrup (DK)**

   • **Johsen, Simon**
      **8210 Århus V (DK)**
   • **Madsen, Georg Kent Hellerup**
      **8200 Arhus N (DK)**
   • **Iversen, Bo Brummerstedt**
      **8541 Skødstrup (DK)**
   • **Steglich, Frank**
      **01069 Dresden (DE)**

(74) Representative: **Nielsen, Leif et al**
   **Patrade A/S**
   **Fredens Torv 3A**
   **8000 Århus C (DK)**

(54) **Use of thermoelectric materials for low temperature thermoelectric purposes**

(57)   The invention relates to the use of a thermoelectric material for thermoelectric purposes at a temperature of 150 K or less. The thermoelectric material is a material corresponding to the stoichiometric formula $FeSb_2$, wherein all or part of the Fe atoms optionally being substituted by one or more elements selected from the group comprising: Sc, Ti, V, Cr, Mn, Co, Ni, Cu, Zn, Y, Zr, Nb, Mo, Tc, Ru, Rh, Pd, Ag, Cd, La, Hf, Ta, W, Re, Os, Ir, Pt, Au, Hg, Ce, Pr, Nd, Pm, Sm, Eu, Gd, Tb, Dy, Ho, Er, Tm, Yb, Lu and a vacancy; and wherein all or part of the Sb atoms optionally being substituted by one or more elements selected from the group comprising: P, As, Bi, S, Se, Te, B, Al, Ga, In, Tl, C, Si, Ge, Sn, Pb and a vacancy; with the proviso that neither one of the elements Fe and Sb in the formula $FeSb_2$ is fully substituted with a vacancy. The invention also relates to thermoelectric materials per se falling within the above definition.

Fig. 7

**EP 1 930 960 A1**

**Description**

**Field of the Invention**

The present invention relates to use of thermoelectric materials for thermoelectric purposes at a temperature of 150 K or less.

Moreover, the present invention relates to a thermoelectric material having a stoichiometry corresponding to the stoichiometric formula $FeSb_2$, wherein all or part of the Fe atoms optionally being substituted by one or more elements selected from the group comprising: Sc, Ti, V, Cr, Mn, Co, Ni, Cu, Zn, Y, Zr, Nb, Mo, Tc, Ru, Rh, Pd, Ag, Cd, La, Hf, Ta, W, Re, Os, Ir, Pt, Au, Hg, Ce, Pr, Nd, Pm, Sm, Eu, Gd, Tb, Dy, Ho, Er, Tm, Yb, Lu and a vacancy; and wherein all or part of the Sb atoms optionally being substituted by one or more elements selected from the group comprising: P, As, Bi, S, Se, Te, B, Al, Ga, In, Tl, C, Si, Ge, Sn, Pn and a vacancy; with the proviso that neither one of the elements Fe and Sb in the formula $FeSb_2$ is fully substituted with a vacancy; and with the proviso that the thermoelectric material is not a binary composition; and with the proviso that the thermoelectric material is not a non-alloy ternary composition of the stoichiometric formula: $TXY$, wherein $T$ is an element selected from the group comprising: Sc, Ti, V, Cr, Mn, Fe, Co, Ni, Cu, Zn, Y, Zr, Nb, Mo, Tc, Ru, Rh, Pd, Ag, Cd, La, Hf, Ta, W, Re, Os, Ir, Pt, Au, Hg; and wherein $X$ is an element selected from the group comprising: P, As, Sb, Bi; and wherein $Y$ is an element selected from the group comprising: S, Se, Te.

Furthermore the present invention relates to a process for the manufacture of the thermoelectric materials according to the invention, to thermocouples comprising such thermoelectric materials, use of thermocouples for the manufacture of a thermoelectric device, thermoelectric devices comprising such thermocouples.

**Background of the Invention**

Thermoelectric materials have been known for decades. By arranging a *p*-type thermoelectric material and an *n*-type thermoelectric material in couples, termed thermocouples, it is possible to convert heat into electric power or to create a temperature gradient by applying electric power.

A thermocouple accordingly comprises a *p*-type thermoelectric material and an *n*-type thermoelectric material electrically connected so as to form an electric circuit. By applying a temperature gradient to this circuit an electric current will flow in the circuit making such a thermocouple a power source.

Alternatively electric current may be applied to the circuit resulting in one side of the thermocouple being heated and the other side of the thermocouple being cooled. In such a set-up the circuit accordingly functions as a device which is able to create a temperature gradient by applying an electrical current. The physical principles involved in these above phenomena are the Seebeck effect and the Peltier effect respectively.

In order to evaluate the efficiency of a thermoelectric material a dimensionless coefficient is introduced. This coefficient, the figure of merit, $ZT$ is defined as:

$$ZT = S^2\sigma T/\kappa,$$

where $S$ is the Seebeck coefficient, $\sigma$ is the electrical conductivity, $T$ is the absolute temperature, and $\kappa$ is the thermal conductivity. The figure of merit, $ZT$ is thus related to the coupling between electrical and thermal effects in a material; a high figure of merit of a thermoelectric material corresponds to an efficient thermoelectric material and vice versa.

The Seebeck coefficient, $S$ of a material is defined as: $S(T) = dV/dT$, and thus expresses the ability of the material to respond to a temperature gradient by exhibiting a potential difference between points of the material having different temperatures. A material having a high Seebeck coefficient is able to respond to small temperature gradient by exhibiting a relatively large potential difference. This implies that in order to be able to utilise a thermoelectric material as an accurate temperature probe, it is imperative that the material exhibits a high Seebeck coefficient at the temperature of the measurement.

The techniques relating to the manufacture of thermocouples from thermoelectric materials as well as the manufacture of thermoelectric devices from such thermocouples are well documented in the art. See for example CRC Handbook of Thermoelectrics (ed. Rowe, M.), CRC Press, Boca Raton, 1995 and Thermoelectrics - Basic Principles and new Materials Developments, Springer Verlag, Berlin, 2001, which are hereby included as references.

Traditionally thermoelectric materials have been composed of alloys, such as $Bi_2Te_3$, PbTe, BiSb and SiGe. These materials have a figure of merit of approximately $ZT = 1$ and operate at temperatures of 200 to 1300 K.

Further improvements appeared with the introduction of alloys of the Te-Ag-Ge-Sb (TAGS) type which exhibit $ZT$-values of approximately 1.2 in the temperature range of 670-720 K.

New types of materials were recently made with alloys of the $Zn_4Sb_3$ type. See for example Caillat *et al.* in US 6,458,319 B1. These $Zn_4Sb_3$ type materials are suitable for applications in the temperature range of 500 - 750 K.

At lowest temperatures Bi-Sb based alloys are the best materials known to date with a maximum $ZT$ = 0.5 at approximately 150 K, which, however, is too low for commercial thermoelectric utilisations (Rowe D.M., MTS Journal, 27 (3), 43-48, 1997).

$CsBi_4Te_6$ is another recently discovered (Duck-Young Chung, et al. Science 287, 1024 (2000)) low-temperature thermoelectric with $ZT$ = 0.8 at approximately 225 K.

Recently also so-called strongly correlated electron systems (e.g. strongly correlated semiconductors, Kondo insulators, heavy fermion systems etc.) are being considered as low temperature thermoelectric materials. However, so far none of these compounds have shown excellent thermoelectric properties (Mahan, G. D. in Solid State Physics, Vol. 51, p. 81-157 (1998) and Thermoelectrics Handbook, Macro to Nano, CRC Press, 2005).

Thin-film/superlattice $Bi_2Te_3/Sb_2Te_3$-based thermoelectric materials have recently shown very good thermoelectric properties with $ZT$ = 2.4 at room temperature. The enhancement of the $ZT$-value compared to the bulk material is mainly due to a reduction of the thermal conductivity caused by the superlattice (Venkatasubramanian et al. Nature 413, 597-602 (2001)).

Various technical and scientific disciplines involves the features of setting up environments at very low temperatures, e.g. below 150 K. Such low temperature environments are inter alia necessary i) for devices/instruments based on super-conductor technology i.e. in the field of NMR technology that includes both NMR spectrometers at research institutions and MR scanners at hospitals. ii) photon detector technology where efficiency and sensibility increases upon cooling the detector material. It would be desirably to be able to utilise the special properties of thermoelectric materials in such low temperature environments. Such applications may comprise utilising the Seebeck effect of a thermoelectric material for e.g. accurate temperature measurements at temperatures of 150 K or below; or utilising the Peltier effect for low temperature cooling (i.e. at a temperature of 150 K or below).

However, until now no thermoelectric materials are known which are suitable for applications at a temperature of 150 K or less.

Hence, a need for thermoelectric materials, which are effective and suitable for low temperature applications (i.e. temperatures of 150 K or below), exists.

## Object of the Invention

Accordingly it is an object according to one aspect of the present invention to provide a low-temperature use of a thermoelectric material.

Another object according to a second aspect of the present invention is to provide a thermoelectric material suitable for low-temperature uses.

Another object according to a third aspect of the present invention is to provide a process for the manufacture of such a thermoelectric material.

Yet another object according to a fourth aspect of the present invention is the provision of thermocouples comprising such thermoelectric materials.

Still another object according to a fifth aspect of the present invention is the use of such thermocouples for the manufacture of thermoelectric devices.

Yet a still further object according to a sixth aspect of the present invention is such thermoelectric devices per se.

## Brief Description of the Invention

The above objects are addressed according to:

In a first aspect by the use of a thermoelectric material for a thermoelectric purpose at a temperature of 150 K or less.

In a second aspect by a thermoelectric material having a stoichiometry corresponding to the stoichiometric formula $FeSb_2$, wherein all or part of the Fe atoms optionally being substituted by one or more elements selected from the group comprising: Sc, Ti, V, Cr, Mn, Co, Ni, Cu, Zn, Y, Zr, Nb, Mo, Tc, Ru, Rh, Pd, Ag, Cd, La, Hf, Ta, W, Re, Os, Ir, Pt, Au, Hg, Ce, Pr, Nd, Pm, Sm, Eu, Gd, Tb, Dy, Ho, Er, Tm, Yb, Lu and a vacancy; and wherein all or part of the Sb atoms optionally being substituted by one or more elements selected from the group comprising: P, As, Bi, S, Se, Te, B, Al, Ga, In, Tl, C, Si, Ge, Sn, Pn and a vacancy; with the proviso that neither one of the elements Fe and Sb in the formula $FeSb_2$ is fully substituted with a vacancy; and with the proviso that the thermoelectric material is not a binary composition; and with the proviso that the thermoelectric material is not a non-alloy ternary composition of the stoichiometric formula: *TXY,* wherein *T* is an element selected from the group comprising: Sc, Ti, V, Cr, Mn, Fe, Co, Ni, Cu, Zn, Y, Zr, Nb, Mo, Tc, Ru, Rh, Pd, Ag, Cd, La, Hf, Ta, W, Re, Os, Ir, Pt, Au, Hg; and wherein *X* is an element selected from the group comprising: P, As, Sb, Bi; and wherein *Y* is an element selected from the group comprising: S, Se, Te.

In a third aspect by a process for the preparation of such thermoelectric material comprising the steps:

i) weighing out a desired amount of each constituent element; and mixing these elements:

ii) heating the mixture of constituent elements in an ampoule in order to obtain a melt; and

iii) cooling the melt obtained in ii) in order to obtain the thermoelectric material.

In a fourth aspect by a thermocouple comprising one or more thermoelectric materials according to the invention.
In a fifth aspect by the use of such a thermocouple for the manufacture of a thermoelectric device, and finally:
In sixth aspect by a thermoelectric device comprising one or more such thermocouples.

**Description of the Drawings**

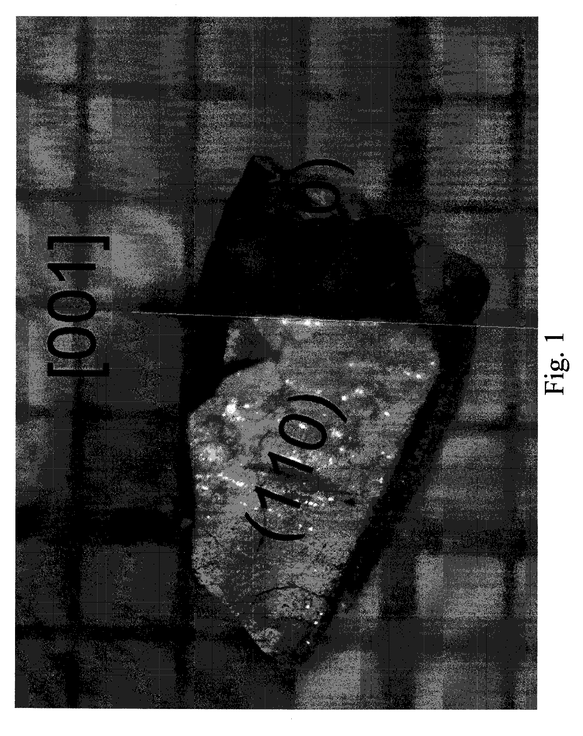

Fig. 1 is a photograph showing a typical $FeSb_2$ single crystal sample after removal of Sb-flux and washing in aqua regia.

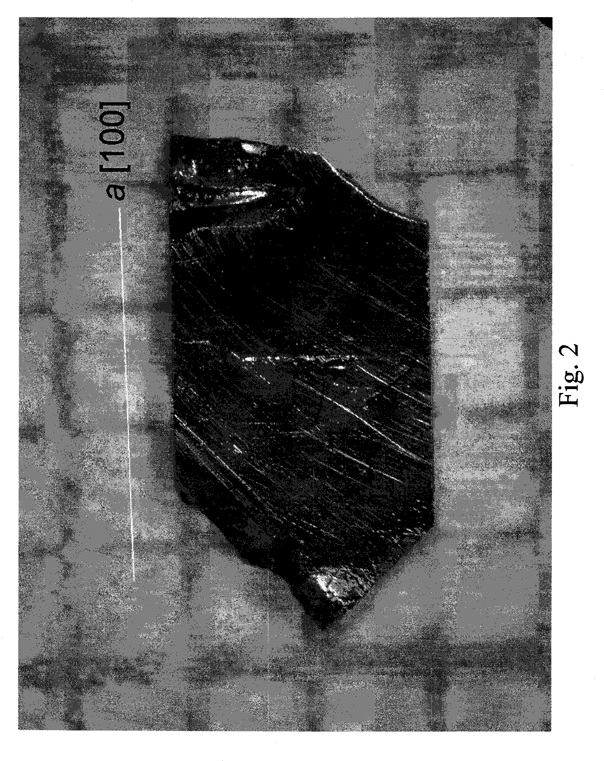

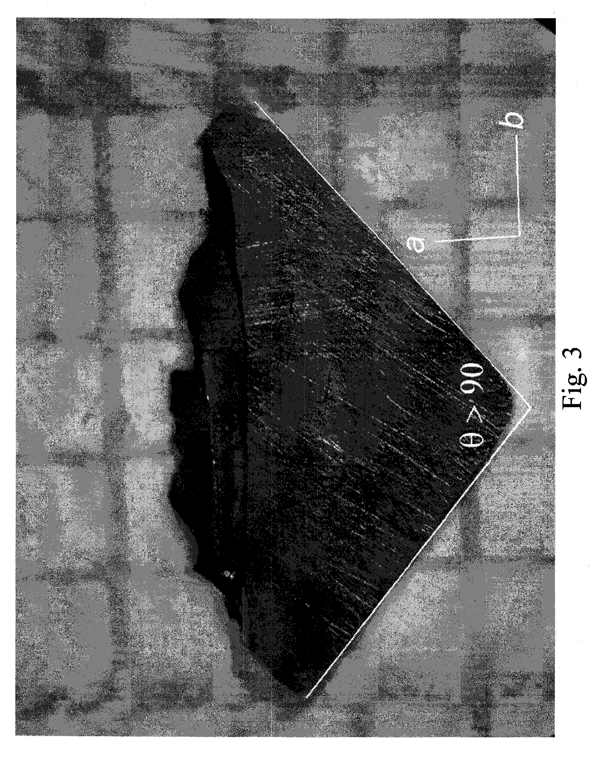

Fig. 2 and 3 are photographs showing a typical $FeSb_2$ single crystal after polishing.

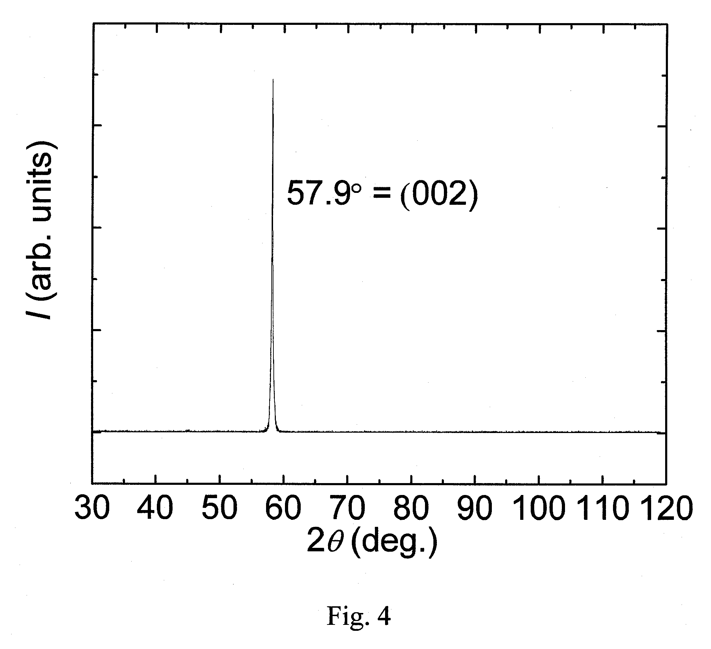

Fig. 4 shows reflection X-ray intensity on a powder diffractometer using $\theta$, $2\theta$ geometry measured on the plane of the single crystal of Fig. 3. Before polishing the crystal in Fig. 3 was oriented with Laue photographs and the diffraction pattern serves as a check that the c-axis is perpendicular to the plane.

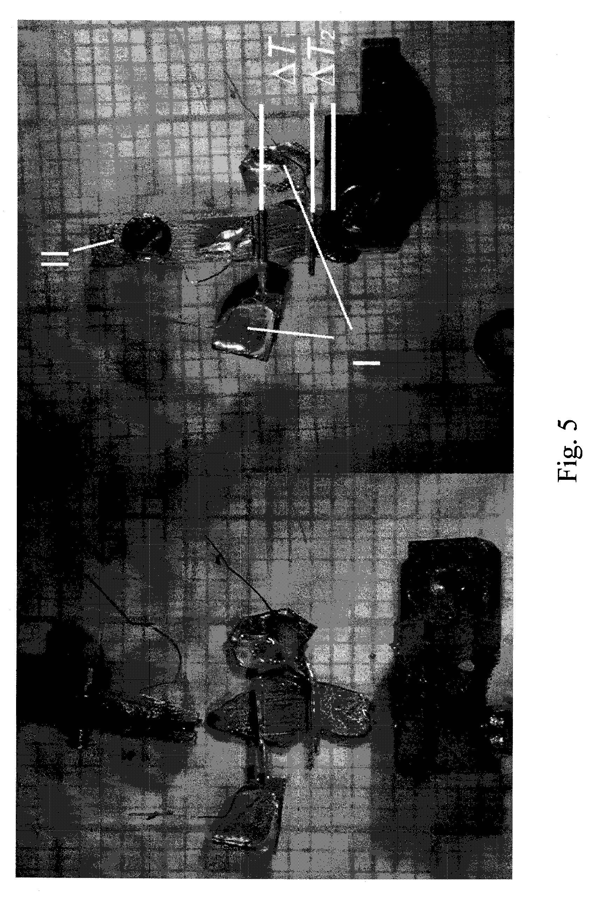

Fig. 5 is a photograph showing the sample holder and sample mounted with holders for thermometers. $\Delta T_1$ is the temperature difference between the two thermometers, which are used for determining $S$ and $\kappa$. $\Delta T_2$ is the temperature difference between the sample and the sample holder mainly due thermal contact resistance between the two. I are the thermometer holders and II is the heater holder. The sample holder is mounted into the PPMS-TTO puck.

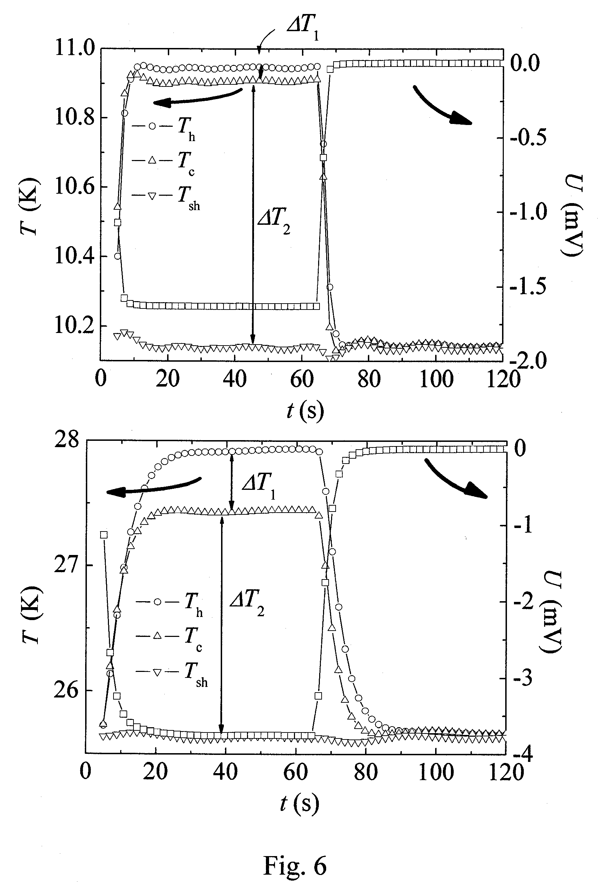

Fig. 6 shows the temperatures ($T$) of the thermometers and the voltage ($U$) as functions of time ($t$) during a measurement at approximately 10.5 K and 27 K, respectively. When temperature stability is obtained, the heater is switched on, and after approximately 60 s the heater is switched off again. It is then checked that both thermometers and the voltage regain the values they had before the heater was switched on.

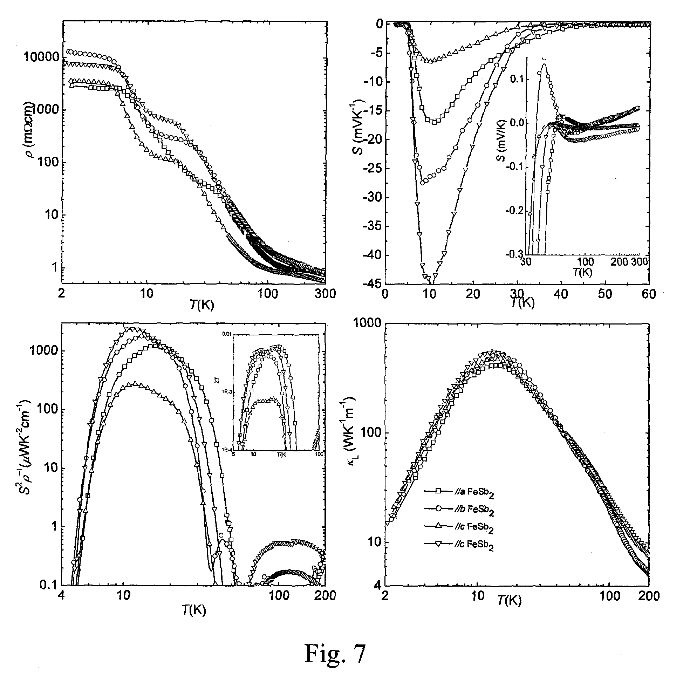

Fig. 7 shows graphs representing the electrical resistivity ($\rho$), thermoelectric power ($S$), thermoelectric power factor ($PF = S^2 \cdot \rho^{-1}$) and lattice thermal conductivity ($\kappa_L$) as a function of temperature ($T$) in the upper left, upper right, lower left and lower right panel, respectively for $FeSb_2$. Inset in upper right panel is $S(T)$ from 30 K to 300 K. Inset in lower left panel is the thermoelectric figure of merit $ZT = S^2 \cdot \rho^{-1} \cdot \kappa^{-1} \cdot T$.

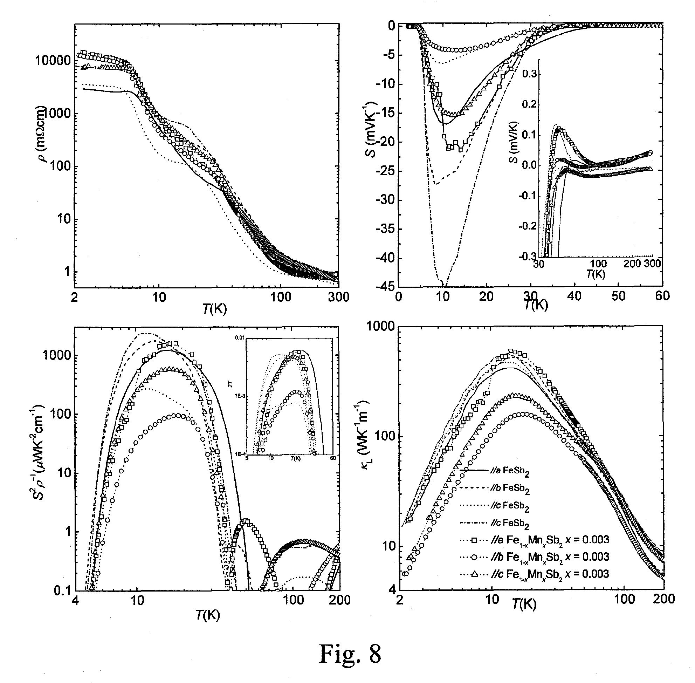

Fig. 8 shows graphs representing the electrical resistivity ($\rho$), thermoelectric power ($S$), thermoelectric power factor ($PF = S^2 \cdot \rho^{-1}$) and lattice thermal conductivity ($\kappa_L$) as a function of temperature ($T$) in the upper left, upper right, lower left and lower right panel, respectively for $Fe_{1-x}Mn_xSb_2$, x = 0.003. Inset in upper right panel is $S(T)$ from 30 K to 300 K. Inset in lower left panel is the thermoelectric figure of merit $ZT = S^2 \cdot \rho^{-1} \cdot \kappa^{-1} \cdot T$. The curves are the data for pure $FeSb_2$.

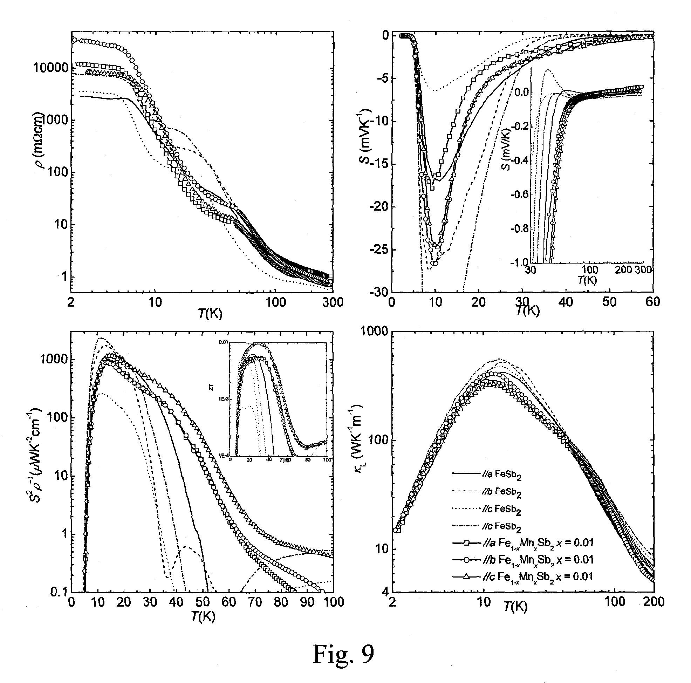

Fig. 9 shows graphs representing the electrical resistivity ($\rho$), thermoelectric power ($S$), thermoelectric power factor ($PF = S^2 \cdot \rho^{-1}$) and lattice thermal conductivity ($\kappa_L$) as a function of temperature ($T$) in the upper left, upper right, lower left and lower right panel, respectively for $Fe_{1-x}Mn_xSb_2$, x = 0.01. Inset in upper right panel is $S(T)$ from 30 K to 300 K. Inset in lower left panel is the thermoelectric figure of merit $ZT = S^2 \cdot \rho^{-1} \cdot \kappa^{-1} \cdot T$. The curves are the data for pure $FeSb_2$.

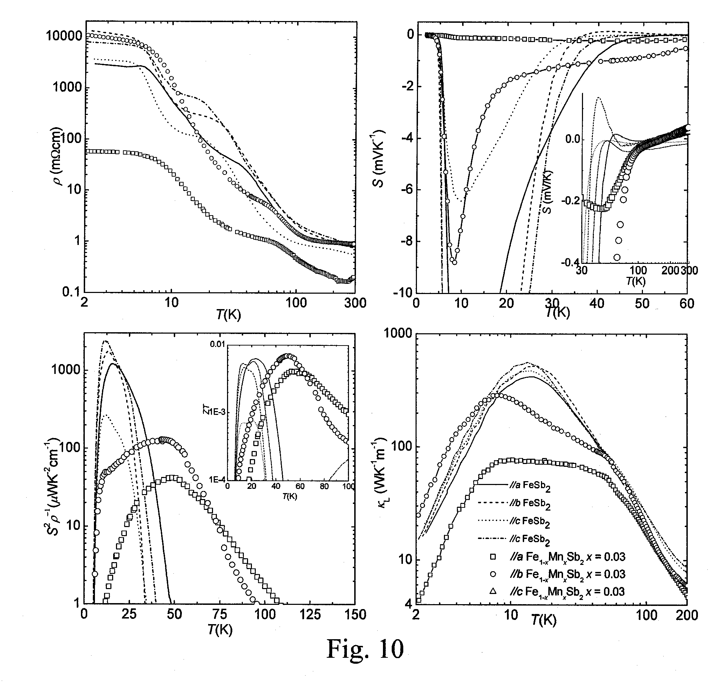

Fig. 10 shows graphs representing the electrical resistivity ($\rho$), thermoelectric power ($S$), thermoelectric power factor ($PF = S^2 \cdot \rho^{-1}$) and lattice thermal conductivity ($\kappa_L$) as a function of temperature ($T$) in the upper left, upper right, lower left and lower right panel, respectively for $Fe_{1-x}Mn_xSb_2$, x = 0.03. Inset in upper right panel is $S(T)$ from 30 K to 300 K. Inset in lower left panel is the thermoelectric figure of merit $ZT = S^2 \cdot \rho^{-1} \cdot \kappa^{-1} \cdot T$. The curves are the data for pure $FeSb_2$.

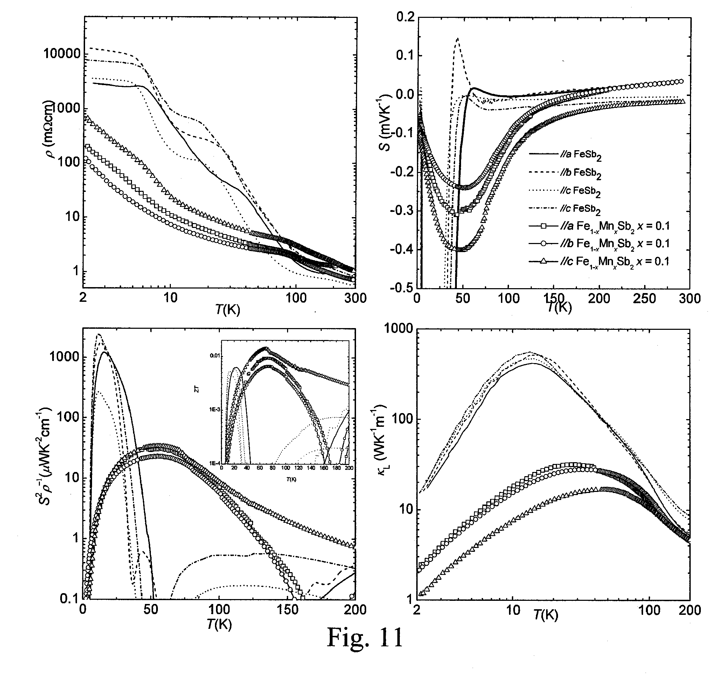

Fig. 11 shows graphs representing the electrical resistivity ($\rho$), thermoelectric power (S), thermoelectric power factor ($PF = S^2 \cdot \rho^{-1}$) and lattice thermal conductivity ($\kappa_L$) as a function of temperature ($T$) in the upper left, upper right, lower left and lower right panel, respectively for $Fe_{1-x}Mn_xSb_2$, $x = 0.1$. Inset in lower left panel is the thermoelectric figure of merit $ZT = S^2 \cdot \rho^{-1} \cdot \kappa^{-1} \cdot T$. The curves are the data for pure $FeSb_2$.

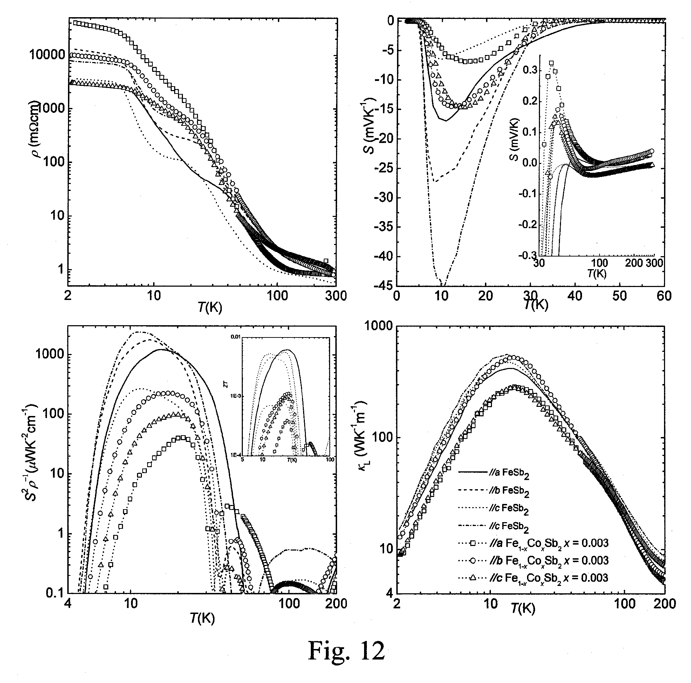

Fig. 12 shows graphs representing the electrical resistivity ($\rho$), thermoelectric power ($S$), thermoelectric power factor ($PF = S^2 \cdot \rho^{-1}$) and lattice thermal conductivity ($\kappa_L$) as a function of temperature ($T$) in the upper left, upper right, lower left and lower right panel, respectively for $Fe_{1-x}Co_xSb_2$, $x = 0.003$. Inset in upper right panel is $S(T)$ from 30 K to 300 K. Inset in lower left panel is the thermoelectric figure of merit $ZT = S^2 \cdot \rho^{-1} \cdot \kappa^{-1} \cdot T$. The curves are the data for pure $FeSb_2$.

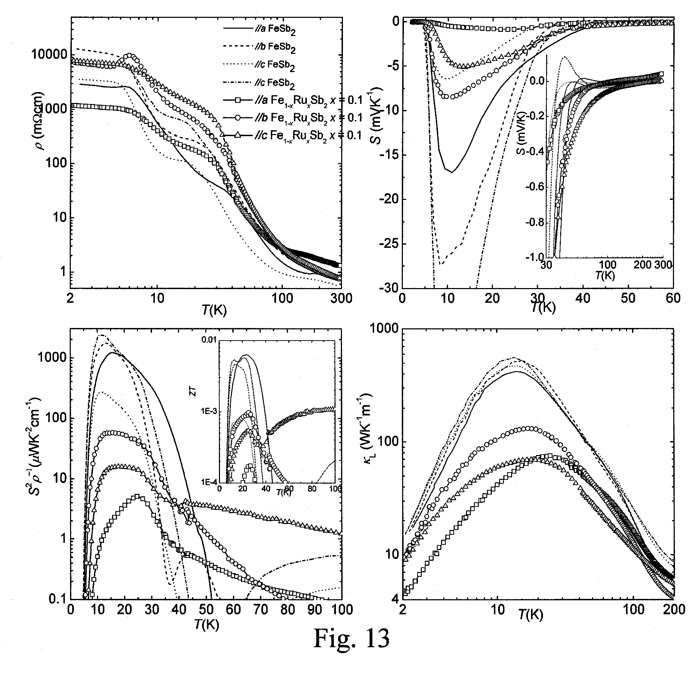

Fig. 13 shows graphs representing the electrical resistivity ($\rho$), thermoelectric power (S), thermoelectric power factor ($PF = S^2 \cdot \rho^{-1}$) and lattice thermal conductivity ($\kappa_L$) as a function of temperature ($T$) in the upper left, upper right, lower left and lower right panel, respectively for $Fe_{1-x}Ru_xSb_2$, $x = 0.1$. Inset in upper right panel is $S(T)$ from 30 K to 300 K. Inset in lower left panel is the thermoelectric figure of merit $ZT = S^2 \cdot \rho^{-1} \cdot \kappa^{-1} \cdot T$. The curves are the data for pure $FeSb_2$.

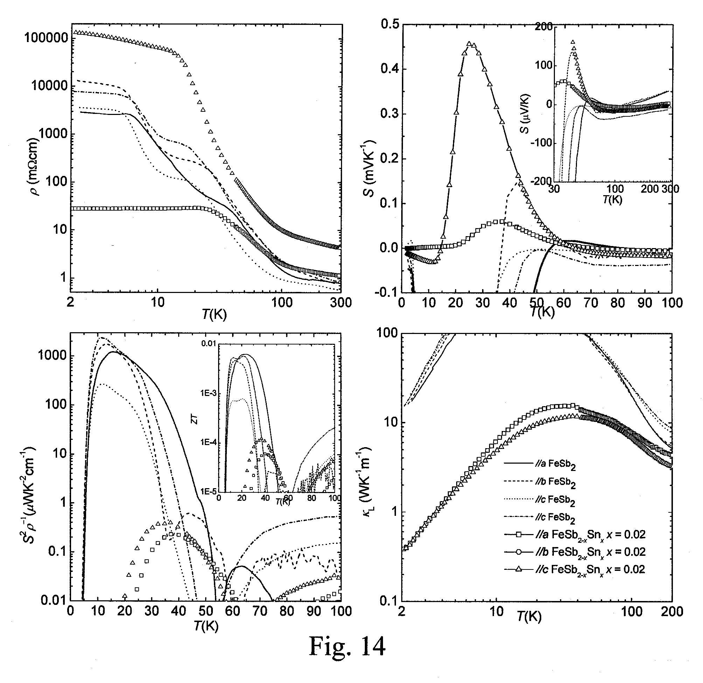

Fig. 14 shows graphs representing the electrical resistivity ($\rho$), thermoelectric power ($S$), thermoelectric power factor ($PF = S^2 \cdot \rho^{-1}$) and lattice thermal conductivity ($\kappa_L$) as a function of temperature ($T$) in the upper left, upper right, lower left and lower right panel, respectively for $FeSb_{2-x}Sn_x$, $x = 0.02$. Inset in upper right panel is $S(T)$ from 30 K to 300 K. Inset in lower left panel is the thermoelectric figure of merit $ZT = S^2 \cdot \rho^{-1} \cdot \kappa^{-1} \cdot T$. The curves are the data for pure $FeSb_2$.

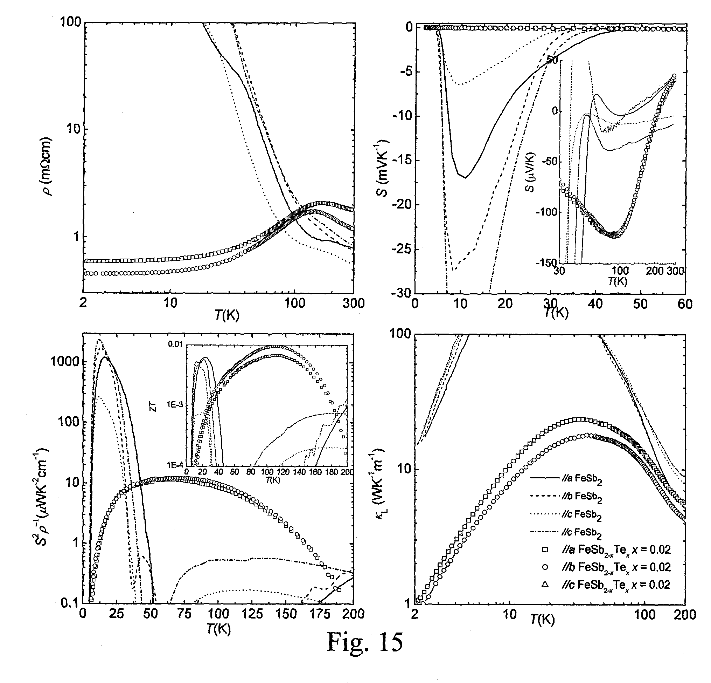

Fig. 15 shows graphs representing the electrical resistivity ($\rho$), thermoelectric power ($S$), thermoelectric power factor ($PF = S^2 \cdot \rho^{-1}$) and lattice thermal conductivity ($\kappa_L$) as a function of temperature ($T$) in the upper left, upper right, lower left and lower right panel, respectively for $FeSb_{2-x}Te_x$, $x = 0.02$. Inset in upper right panel is $S(T)$ from 30 K to 300 K. Inset in lower left panel is the thermoelectric figure of merit $ZT = S^2 \cdot \rho^{-1} \cdot \kappa^{-1} \cdot T$. The curves are the data for pure $FeSb_2$.

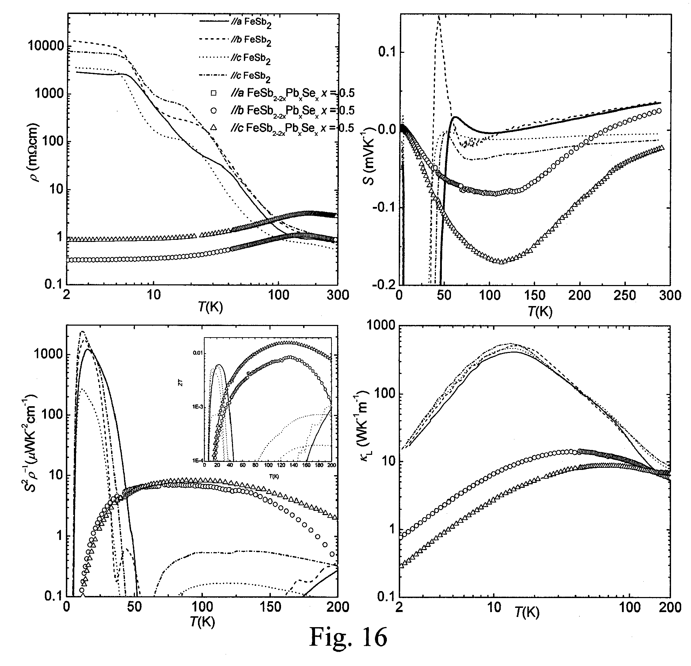

Fig. 16 shows graphs representing the electrical resistivity ($\rho$), thermoelectric power ($S$), thermoelectric power factor ($PF = S^2 \cdot \rho^{-1}$) and lattice thermal conductivity ($\kappa_L$) as a function of temperature ($T$) in the upper left, upper right, lower left and lower right panel, respectively for $FeSb_{2-2x}Pb_xSe_x$, $x = 0.5$. Inset in upper right panel is $S(T)$ from 30 K to 300 K. Inset in lower left panel is the thermoelectric figure of merit $ZT = S^2 \cdot \rho^{-1} \cdot \kappa^{-1} \cdot T$. The curves are the data for pure $FeSb_2$.

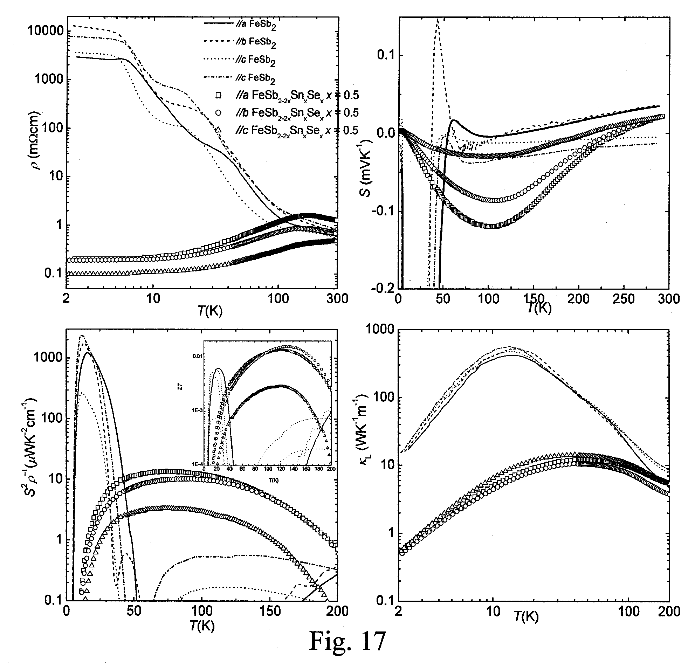

Fig. 17 shows graphs representing the electrical resistivity ($\rho$), thermoelectric power ($S$), thermoelectric power factor ($PF = S^2 \cdot \rho^{-1}$) and lattice thermal conductivity ($\kappa_L$) as a function of temperature ($T$) in the upper left, upper right, lower left and lower right panel, respectively for $FeSb_{2-2x}Sn_xSe_x$, $x = 0.5$. Inset in upper right panel is $S(T)$ from 30 K to 300 K. Inset in lower left panel is the thermoelectric figure of merit $ZT = S^2 \cdot \rho^{-1} \cdot \kappa^{-1} \cdot T$. The curves are the data for pure $FeSb_2$.

## Detailed Description of the Invention

I - The low-temperature use of a thermoelectric material

In a general aspect the present relates to the use of a thermoelectric material for a thermoelectric purpose at a temperature of 150 K or less.

In one embodiment of the use according to the present invention the thermoelectric material employed corresponds to the stoichiometric formula $FeSb_2$, wherein all or part of the Fe atoms optionally being substituted by one or more elements selected from the group comprising: Sc, Ti, V, Cr, Mn, Co, Ni, Cu, Zn, Y, Zr, Nb, Mo, Tc, Ru, Rh, Pd, Ag, Cd, La, Hf, Ta, W, Re, Os, Ir, Pt, Au, Hg, Ce, Pr, Nd, Pm, Sm, Eu, Gd, Tb, Dy, Ho, Er, Tm, Yb, Lu and a vacancy; and wherein all or part of the Sb atoms optionally being substituted by one or more elements selected from the group comprising: P, As, Bi, S, Se, Te, B, Al, Ga, In, Tl, C, Si, Ge, Sn, Pb and a vacancy; with the proviso that neither one of the elements Fe and Sb in the formula $FeSb_2$ is fully substituted with a vacancy.

In one embodiment of the use according to the present invention, the thermoelectric material is a material having the formula $FeSb_2$, wherein part of the Fe atoms optionally being substituted by one or more elements selected from the group comprising: Sc, Ti, V, Cr, Mn, Co, Ni, Cu, Zn, Y, Zr, Nb, Mo, Tc, Ru, Rh, Pd, Ag, Cd, La, Hf, Ta, W, Re, Os, Ir, Pt, Au and Hg and a vacancy; and wherein part of the Sb atoms optionally being substituted by one or more elements selected from the group comprising: P, As, Bi, S, Se, Te and a vacancy.

In another embodiment of the use according to the present invention, the thermoelectric material is a material having the formula $FeSb_2$, wherein part of the Fe atoms optionally being substituted by one or more elements selected from the group comprising: Sc, Ti, V, Cr, Mn, Co, Ni, Cu, Zn, Y, Zr, Nb, Mo, Tc, Ru, Rh, Pd, Ag, Cd, La, Hf, Ta, W, Re, Os, Ir, Pt, Au and Hg and a vacancy; and wherein part of the Sb atoms optionally being substituted by one or more elements selected from the group comprising: B, Al, Ga, In, Tl, C, Si, Ge, Sn, Pb and a vacancy.

In yet another embodiment of the use according to the present invention, the thermoelectric material is a material having the formula $FeSb_2$, wherein part of the Fe atoms optionally being substituted by one or more elements selected from the group comprising: Ce, Pr, Nd, Pm, Sm, Eu, Gd, Tb, Dy, Ho, Er, Tm, Yb, Lu and a vacancy; and wherein part of the Sb atoms optionally being substituted by one or more elements selected from the group comprising: P, As, Bi, S, Se, Te and a vacancy.

In still another embodiment of the use according to the present invention, the thermoelectric material is a material having the formula $FeSb_2$, wherein part of the Fe atoms optionally being substituted by one or more elements selected from the group comprising: Ce, Pr, Nd, Pm, Sm, Eu, Gd, Tb, Dy, Ho, Er, Tm, Yb, Lu and a vacancy; and wherein part of the Sb atoms optionally being substituted by one or more elements selected from the group comprising: B, Al, Ga, In, Tl, C, Si, Ge, Sn, Pb and a vacancy.

Depending on the number of different elements substituted for Fe and Sb respectively in the formula $FeSb_2$, different types of thermoelectric materials appear. Accordingly, in the low-temperature use according to the present invention, a thermoelectric material is employed which may be binary (i.e. consisting of two different elements), ternary (i.e. consisting of three different elements), quaternary (i.e. consisting of four different elements), quinary (i.e. consisting of five different elements), or even of higher order (i.e. consisting of more than five different elements).

It should be noted that the use according to the present invention does not comprise materials of the above type, wherein either one of the elements Fe and Sb in the formula $FeSb_2$ are fully substituted with a vacancy.

The definition of a vacancy follows the normal definition used in the art and is defined as a missing atom in an otherwise periodically ordered 1-, 2- or 3 dimensional array of atoms. It is preferred that the amount of "vacancy substitution", if present, is 10 mol% or less, such as 5 mol% or less, e.g. 1 mol% or less, such as 0.5 mol% or less, e.g. 0.1 mol% or less.

Use of a binary thermoelectric material

As stated above the low-temperature use according to the present invention may employ a binary thermoelectric material.

Hence, in one embodiment of the use according to the present invention, a binary composition is employed. Such binary composition may be any one selected from Table 1 below.

---

**Table 1 - Constituents of binary compounds for use according to the present invention**

**Antimonides:**
Fe-Sb, Sc-Sb, Ti-Sb, V-Sb, Cr-Sb, Mn-Sb, Co-Sb, Ni-Sb, Cu-Sb, Zn-Sb, Y-Sb, Zr-Sb, Nb-Sb, Mo-Sb, Tc-Sb, Ru-Sb, Rh-Sb, Pd-Sb, Ag-Sb, Cd-Sb, La-Sb, Hf-Sb, Ta-Sb, W-Sb, Re-Sb, Os-Sb, Ir-Sb, Pt-Sb, Au-Sb, Hg-Sb, Ce-Sb, Pr-Sb, Nd-Sb, Pm-Sb, Sm-Sb, Eu-Sb, Gd-Sb, Tb-Sb, Dy-Sb, Ho-Sb, Er-Sb, Tm-Sb, Yb-Sb, Lu-Sb

**Arsenides:**
Fe-As, Sc-As, Ti-As, V-As, Cr-As, Mn-As, Co-As, Ni-As, Cu-As, Zn-As, Y-As, Zr-As, Nb-As, Mo-As, Tc-As, Ru-As, Rh-As, Pd-As, Ag-As, Cd-As, La-As, Hf-As, Ta-As, W-As, Re-As, Os-As, Ir-As, Pt-As, Au-As, Hg-As, Ce-As, Pr-As, Nd-As, Pm-As, Sm-As, Eu-As, Gd-As, Tb-As, Dy-As, Ho-As, Er-As, Tm-As, Yb-As, Lu-As

**Bismuthides:**
Fe-Bi, Sc-Bi, Ti-Bi, V-Bi, Cr-Bi, Mn-Bi, Co-Bi, Ni-Bi, Cu-Bi, Zn-Bi, Y-Bi, Zr-Bi, Nb-Bi, Mo-Bi, Tc-Bi, Ru-Bi, Rh-Bi, Pd-Bi, Ag-Bi, Cd-Bi, La-Bi, Hf-Bi, Ta-Bi, W-Bi, Re-Bi, O-S-Bi, Ir-Bi, Pt-Bi, Au-Bi, Hg-Bi, Ce-Bi, Pr-Bi, Nd-Bi, Pm-Bi, Sm-Bi, Eu-Bi, Gd-Bi, Tb-Bi, Dy-Bi, Ho-Bi, Er-Bi, Tm-Bi, Yb-Bi, Lu-Bi

**Sulfides:**
Fe-S, Sc-S, Ti-S, V-S, Cr-S, Mn-S, Co-S, Ni-S, Cu-S, Zn-S, Y-S, Zr-S, Nb-S, Mo-S, Tc-S, Ru-S, Rh-S, Pd-S, Ag-S, Cd-S, La-S, Hf-S, Ta-S, W-S, Re-S, Os-S, Ir-S, Pt-S, Au-S, Hg-S, Ce-S, Pr-S, Nd-S, Pm-S, Sm-S, Eu-S, Gd-S, Tb-S, Dy-S, Ho-S, Er-S, Tm-S, Yb-S, Lu-S

**Selenides:**
Fe-Se, Sc-Se, Ti-Se, V-Se, Cr-Se, Mn-Se, Co-Se, Ni-Se, Cu-Se, Zn-Se, Y-Se, Zr-Se, Nb-Se, Mo-Se, Tc-Se, Ru-Se, Rh-Se, Pd-Se, Ag-Se, Cd-Se, La-Se, Hf-Se, Ta-Se, W-Se, Re-Se, Os-Se, Ir-Se, Pt-Se, Au-Se, Hg-Se, Ce-Se, Pr-Se, Nd-Se, Pm-Se, Sm-Se, Eu-Se, Gd-Se, Tb-Se, Dy-Se, Ho-Se, Er-Se, Tm-Se, Yb-Se, Lu-Se

(continued)

| Table 1 - Constituents of binary compounds for use according to the present invention |
|---|
| **Tellurides:**<br>Fe-Te, Sc-Te, Ti-Te, V-Te, Cr-Te, Mn-Te, Co-Te, Ni-Te, Cu-Te, Zn-Te, Y-Te, Zr-Te, Nb-Te, Mo-Te, Tc-Te, Ru-Te, Rh-Te, Pd-Te, Ag-Te, Cd-Te, La-Te, Hf-Te, Ta-Te, W-Te, Re-Te, Os-Te, Ir-Te, Pt-Te, Au-Te, Hg-Te, Ce-Te, Pr-Te, Nd-Te, Pm-Te, Sm-Te, Eu-Te, Gd-Te, Tb-Te, Dy-Te, Ho-Te, Er-Te, Tm-Te, Yb-Te, Lu-Te |
| **Borides:**<br>Fe-B, Sc-B, Ti-B, V-B, Cr-B, Mn-B, Co-B, Ni-B, Cu-B, Zn-B, Y-B, Zr-B, Nb-B, Mo-B, Tc-B, Ru-B, Rh-B, Pd-B, Ag-B, Cd-B, La-B, Hf-B, Ta-B, W-B, Re-B, O-Sb, Ir-B, Pt-B, Au-B, Hg-B, Ce-B, Pr-B, Nd-B, Pm-B, Sm-B, Eu-B, Gd-B, Tb-B, Dy-B, Ho-B, Er-B, Tm-B, Yb-B, Lu-B |
| **Compositions with aluminium:**<br>Fe-Al, Sc-Al, Ti-Al, V-Al, Cr-Al, Mn-Al, Co-Al, Ni-Al, Cu-Al, Zn-Al, Y-Al, Zr-Al, Nb-Al, Mo-Al, Tc-Al, Ru-Al, Rh-Al, Pd-Al, Ag-Al, Cd-Al, La-Al, Hf-Al, Ta-Al, W-Al, Re-Al, Os-Al, Ir-Al, Pt-Al, Au-Al, Hg-Al, Ce-Al, Pr-Al, Nd-Al, Pm-Al, Sm-Al, Eu-Al, Gd-Al, Tb-Al, Dy-Al, Ho-Al, Er-Al, Tm-Al, Yb-Al, Lu-Al |
| **Compositions with gallium:**<br>Fe-Ga, Sc-Ga, Ti-Ga, V-Ga, Cr-Ga, Mn-Ga, Co-Ga, Ni-Ga, Cu-Ga, Zn-Ga, Y-Ga, Zr-Ga, Nb-Ga, Mo-Ga, Tc-Ga, Ru-Ga, Rh-Ga, Pd-Ga, Ag-Ga, Cd-Ga, La-Ga, Hf-Ga, Ta-Ga, W-Ga, Re-Ga, Os-Ga, Ir-Ga, Pt-Ga, Au-Ga, Hg-Ga, Ce-Ga, Pr-Ga, Nd-Ga, Pm-Ga, Sm-Ga, Eu-Ga, Gd-Ga, Tb-Ga, Dy-Ga, Ho-Ga, Er-Ga, Tm-Ga, Yb-Ga, Lu-Ga |
| **Compositions with indium:**<br>Fe-In, Sc-In, Ti-In, V-In, Cr-In, Mn-In, Co-In, Ni-In, Cu-In, Zn-In, Y-In, Zr-In, Nb-In, Mo-In, Tc-In, Ru-In, Rh-In, Pd-In, Ag-In, Cd-In, La-In, Hf-In, Ta-In, W-In, Re-In, Os-In, Ir-In, Pt-In, Au-In, Hg-In, Ce-In, Pr-In, Nd-In, Pm-In, Sm-In, Eu-In, Gd-In, T-B-In, Dy-In, Ho-In, Er-In, Tm-In, Y-B-In, Lu-In |
| **Compositions with thallium:**<br>Fe-Tl, Sc-Tl, Ti-Tl, V-Tl, Cr-Tl, Mn-Tl, Co-Tl, Ni-Tl, Cu-Tl, Zn-Tl, Y-Tl, Zr-Tl, Nb-Tl, Mo-Tl, Tc-Tl, Ru-Tl, Rh-Tl, Pd-Tl, Ag-Tl, Cd-Tl, La-Tl, Hf-Tl, Ta-Tl, W-Tl, Re-Tl, Os-Tl, Ir-Tl, Pt-Tl, Au-Tl, Hg-Tl, Ce-Tl, Pr-Tl, Nd-Tl, Pm-Tl, Sm-Tl, Eu-Tl, Gd-Tl, Tb-Tl, Dy-Tl, Ho-Tl, Er-Tl, Tm-Tl, Yb-Tl, Lu-Tl |
| **Compositions with carbon:**<br>Fe-C, S-C, Ti-C, V-C, Cr-C, Mn-C, Co-C, Ni-C, Cu-C, Zn-C, Y-C, Zr-C, Nb-C, Mo-C, Tc-C, Ru-C, Rh-C, Pd-C, Ag-C, Cd-C, La-C, Hf-C, Ta-C, W-C, Re-C, Os-C, Ir-C, Pt-C, Au-C, Hg-C, Ce-C, Pr-C, Nd-C, Pm-C, Sm-C, Eu-C, Gd-C, Tb-C, Dy-C, Ho-C, Er-C, Tm-C, Yb-C, Lu-C |
| **Compositions with silicon:**<br>Fe-Si, Sc-Si, Ti-Si, V-Si, Cr-Si, Mn-Si, Co-Si, Ni-Si, Cu-Si, Zn-Si, Y-Si, Zr-Si, Nb-Si, Mo-Si, Tc-Si, Ru-Si, Rh-Si, Pd-Si, Ag-Si, Cd-Si, L-A-Si, Hf-Si, T-A-Si, W-Si, Re-Si, Os-Si, Ir-Si, Pt-Si, Au-Si, Hg-Si, Ce-Si, Pr-Si, Nd-Si, Pm-Si, Sm-Si, Eu-Si, Gd-Si, Tb-Si, Dy-Si, Ho-Si, Er-Si, Tm-Si, Yb-Si, Lu-Si |
| **Compositions with germanium:**<br>Fe-Ge, Sc-Ge, Ti-Ge, V-Ge, Cr-Ge, Mn-Ge, Co-Ge, Ni-Ge, Cu-Ge, Zn-Ge, Y-Ge, Zr-Ge, Nb-Ge, Mo-Ge, Tc-Ge, Ru-Ge, Rh-Ge, Pd-Ge, Ag-Ge, Cd-Ge, La-Ge, Hf-Ge, Ta-Ge, W-Ge, Re-Ge, Os-Ge, Ir-Ge, Pt-Ge, Au-Ge, Hg-Ge, Ce-Ge, Pr-Ge, Nd-Ge, Pm-Ge, Sm-Ge, Eu-Ge, Gd-Ge, Tb-Ge, Dy-Ge, Ho-Ge, Er-Ge, Tm-Ge, Yb-Ge, Lu-Ge |
| **Compositions with tin:**<br>Fe-Sn, Sc-Sn, Ti-Sn, V-Sn, Cr-Sn, Mn-Sn, Co-Sn, Ni-Sn, Cu-Sn, Zn-Sn, Y-Sn, Zr-Sn,<br>Nb-Sn, Mo-Sn, Tc-Sn, Ru-Sn, Rh-Sn, Pd-Sn, Ag-Sn, Cd-Sn, L-A-Sn, Hf-Sn, T-A-Sn, W-Sn, Re-Sn, Os-Sn, Ir-Sn, Pt-Sn, Au-Sn, Hg-Sn, Ce-Sn, Pr-Sn, Nd-Sn, Pm-Sn, Sm-Sn, Eu-Sn, Gd-Sn, Tb-Sn, Dy-Sn, Ho-Sn, Er-Sn, Tm-Sn, Yb-Sn, Lu-Sn |

(continued)

| Table 1 - Constituents of binary compounds for use according to the present invention |
| --- |
| **Compositions with lead:**<br>Fe-Pb, Sc-Pb, Ti-Pb, V-Pb, Cr-Pb, Mn-Pb, Co-Pb, Ni-Pb, Cu-Pb, Zn-Pb, Y-Pb, Zr-Pb, Nb-Pb, Mo-Pb, Tc-Pb, Ru-Pb, Rh-Pb, Pd-Pb, Ag-Pb, Cd-Pb, La-Pb, Hf-Pb, Ta-Pb, W-Pb, Re-Pb, Os-Pb, Ir-Pb, Pt-Pb, Au-Pb, Hg-Pb, Ce-Pb, Pr-Pb, Nd-Pb, Pm-Pb, Sm-Pb, Eu-Pb, Gd-Pb, Tb-Pb, Dy-Pb, Ho-Pb, Er-Pb, Tm-Pb, Yb-Pb, Lu-Pb |

In Table 1 above a composition denoted *X-Y* means a binary composition comprising the elements *X* and *Y*.

A preferred binary thermoelectric material for use in accordance with the present invention is a material comprising the combinations of elements selected from the group: Fe-Sb, Fe-Bi, Fe-As and Fe-P.

Use of a ternary thermoelectric material

In another embodiment of the use according to the present invention the thermoelectric material employed, is a material having a ternary composition.

The compositions of such ternary compositions can be constructed from the formula $FeSb_2$ by:

- substituting part of the Fe with one element selected form the group comprising: Sc, Ti, V, Cr, Mn, Co, Ni, Cu, Zn, Y, Zr, Nb, Mo, Tc, Ru, Rh, Pd, Ag, Cd, La, Hf, Ta, W, Re, Os, Ir, Pt, Au, Hg, Ce, Pr, Nd, Pm, Sm, Eu, Gd, Tb, Dy, Ho, Er, Tm, Yb, Lu; or by

- fully substituting the Fe with two different elements selected form the group comprising: Sc, Ti, V, Cr, Mn, Co, Ni, Cu, Zn, Y, Zr, Nb, Mo, Tc, Ru, Rh, Pd, Ag, Cd, La, Hf, Ta, W, Re, Os, Ir, Pt, Au, Hg, Ce, Pr, Nd, Pm, Sm, Eu, Gd, Tb, Dy, Ho, Er, Tm, Yb, Lu; or by

- substituting part of the Sb with one element selected form the group comprising: P, As, Bi, S, Se, Te, B, Al, Ga, In, Tl, C, Si, Ge, Sn, Pb; or by

- fully substituting the Sb with two different elements selected form the group comprising: P, As, Bi, S, Se, Te, B, Al, Ga, In, Tl, C, Si, Ge, Sn, Pb.

In one embodiment according to the use according to the present invention, the material employed is a ternary composition comprising Fe.

Table 2 below lists an array of combinations of constituent elements of a ternary thermoelectric material according to the use according to the present invention. The combinations listed in Table 2 are obtained by partly substituting Fe in $FeSb_2$ with one element selected form the group comprising: Sc, Ti, V, Cr, Mn, Co, Ni, Cu, Zn, Y, Zr, Nb, Mo, Tc, Ru, Rh, Pd, Ag, Cd, La, Hf, Ta, W, Re, Os, Ir, Pt, Au, Hg, Ce, Pr, Nd, Pm, Sm, Eu, Gd, Tb, Dy, Ho, Er, Tm, Yb, Lu.

| Table 2 - Constituents of ternary compositions comprising Fe for use in the present invention |
| --- |
| Fe-Sc-Sb, Fe-Sc-P, Fe-Sc-As, Fe-Sc-Bi, Fe-Sc-S, Fe-Sc-Se, Fe-Sc-Te, Fe-Sc-B, Fe-Sc-Al, Fe-Sc-Ga, Fe-Sc-In, Fe-Sc-Tl, Fe-Sc-C, Fe-Sc-Si, Fe-Sc-Ge, Fe-Sc-Sn, Fe-Sc-Pb |
| Fe-Ti-Sb, Fe-Ti-P, Fe-Ti-As, Fe-Ti -Bi, Fe-Ti-S, Fe-Ti-Se, Fe-Ti-Te, Fe-Ti-B, Fe-Ti-Al, Fe-Ti-Ga, Fe-Ti-In, Fe-Ti-Tl, Fe-Ti-C, Fe-Ti-Si, Fe-Ti-Ge, Fe-Ti-Sn, Fe-Ti-Pb |
| Fe-V-Sb, Fe-V-P, Fe-V-As, Fe-V -Bi, Fe-V-S, Fe-V-Se, Fe-V-Te, Fe-V-B, Fe-V-Al, Fe-V-Ga, Fe-V-In, Fe-V-Tl, Fe-V-C, Fe-V-Si, Fe-V-Ge, Fe-V-Sn, Fe-V-Pb |
| Fe-Cr-Sb, Fe-Cr-P, Fe-Cr-As, Fe-Cr-Bi, Fe-Cr-S, Fe-Cr-Se, Fe-Cr-Te, Fe-Cr-B, Fe-Cr-Al, Fe-Cr-Ga, Fe-Cr-In, Fe-Cr-Tl, Fe-Cr-C, Fe-Cr-Si, Fe-Cr-Ge, Fe-Cr-Sn, Fe-Cr-Pb |
| Fe-Mn-Sb, Fe-Mn-P, Fe-Mn-As, Fe-Mn-Bi, Fe-Mn-S, Fe-Mn-Se, Fe-Mn-Te, Fe-Mn-B, Fe-Mn-Al, Fe-Mn-Ga, Fe-Mn-In, Fe-Mn-Tl, Fe-Mn-C, Fe-Mn-Si, Fe-Mn-Ge, Fe-Mn-Sn, Fe-Mn-Pb |

(continued)

| Table 2 - Constituents of ternary compositions comprising Fe for use in the present invention |
| --- |
| Fe-Co-Sb, Fe-Co-P, Fe-Co-As, Fe-Co-Bi, Fe-Co-S, Fe-Co-Se, Fe-Co-Te, Fe-Co-B, Fe-Co-Al, Fe-Co-Ga, Fe-Co-In, Fe-Co-Tl, Fe-Co-C, Fe-Co-Si, Fe-Co-Ge, Fe-Co-Sn, Fe-Co-Pb |
| Fe-Ni-Sb, Fe-Ni-P, Fe-Ni-As, Fe-Ni-Bi, Fe-Ni-S, Fe-Ni-Se, Fe-Ni-Te, Fe-Ni-B, Fe-Ni-Al, Fe-Ni-Ga, Fe-Ni-In, Fe-Ni-Tl, Fe-Ni-C, Fe-Ni-Si, Fe-Ni-Ge, Fe-Ni-Sn, Fe-Ni-Pb |
| Fe-Cu-Sb, Fe-Cu-P, Fe-Cu-As, Fe-Cu-Bi, Fe-Cu-S, Fe-Cu-Se, Fe-Cu-Te, Fe-Cu-B, Fe-Cu-Al, Fe-Cu-Ga, Fe-Cu-In, Fe-Cu-Tl, Fe-Cu-C, Fe-Cu-Si, Fe-Cu-Ge, Fe-Cu-Sn, Fe-Cu-Pb |
| Fe-Zn-Sb, Fe-Zn-P, Fe-Zn-As, Fe-Zn-Bi, Fe-Zn-S, Fe-Zn-Se, Fe-Zn-Te, Fe-Zn-B, Fe-Zn-Al, Fe-Zn-Ga, Fe-Zn-In, Fe-Zn-Tl, Fe-Zn-C, Fe-Zn-Si, Fe-Zn-Ge, Fe-Zn-Sn, Fe-Zn-Pb |
| Fe-Y-Sb, Fe-Y-P, Fe-Y-As, Fe-Y-Bi, Fe-Y-S, Fe-Y-Se, Fe-Y-Te, Fe-Y-B, Fe-Y-Al, Fe-Y-Ga, Fe-Y-In, Fe-Y-Tl, Fe-Y-C, Fe-Y-Si, Fe-Y-Ge, Fe-Y-Sn, Fe-Y-Pb |
| Fe-Zr-Sb, Fe-Zr-P, Fe-Zr-As, Fe-Zr-Bi, Fe-Zr-S, Fe-Zr-Se, Fe-Zr-Te, Fe-Zr-B, Fe-Zr-Al, Fe-Zr-Ga, Fe-Zr-In, Fe-Zr-Tl, Fe-Zr-C, Fe-Zr-Si, Fe-Zr-Ge, Fe-Zr-Sn, Fe-Zr-Pb |
| Fe-Nb-Sb, Fe-Nb-P, Fe-Nb-As, Fe-Nb-Bi, Fe-Nb-S, Fe-Nb-Se, Fe-Nb-Te, Fe-Nb-B, Fe-Nb-Al, Fe-Nb-Ga, Fe-Nb-In, Fe-Nb-Tl, Fe-Nb-C, Fe-Nb-Si, Fe-Nb-Ge, Fe-Nb-Sn, Fe-Nb-Pb |
| Fe-Mo-Sb, Fe-Mo-P, Fe-Mo-As, Fe-Mo-Bi, Fe-Mo-S, Fe-Mo-Se, Fe-Mo-Te, Fe-Mo-B, Fe-Mo-Al, Fe-Mo-Ga, Fe-Mo-In, Fc-Mo-Tl, Fe-Mo-C, Fe-Mo-Si, Fe-Mo-Ge, Fe-Mo-Sn, Fe-Mo-Pb |
| Fe-Tc-Sb, Fe-Tc-P, Fe-Tc-As, Fe-Tc-Bi, Fe-Tc-S, Fe-Tc-Se, Fe-Tc-Te, Fe-Tc-B, Fe-Tc-Al, Fe-Tc-Ga, Fe-Tc-In, Fe-Tc-Tl, Fe-Tc-C, Fe-Tc-Si, Fe-Tc-Ge, Fe-Tc-Sn, Fe-Tc-Pb |
| Fe-Ru-Sb, Fe-Ru-P, Fe-Ru-As, Fe-Ru-Bi, Fe-Ru-S, Fe-Ru-Se, Fe-Ru-Te, Fe-Ru-B, Fe-Ru-Al, Fe-Ru-Ga, Fe-Ru-In, Fe-Ru-Tl, Fe-Ru-C, Fe-Ru-Si, Fe-Ru-Ge, Fe-Ru-Sn, Fe-Ru-Pb |
| Fe-Rh-Sb, Fe-Rh-P, Fe-Rh-As, Fe-Rh-Bi, Fe-Rh-S, Fe-Rh-Se, Fe-Rh-Te, Fe-Rh-B, Fe-Rh-Al, Fe-Rh-Ga, Fe-Rh-In, Fe-Rh-Tl, Fe-Rh-C, Fe-Rh-Si, Fe-Rh-Ge, Fe-Rh-Sn, Fe-Rh-Pb |
| Fe-Pd-Sb, Fe-Pd-P, Fe-Pd-As, Fe-Pd-Bi, Fe-Pd-S, Fe-Pd-Se, Fe-Pd-Te, Fe-Pd-B, Fe-Pd-Al, Fe-Pd-Ga, Fe-Pd-In, Fe-Pd-Tl, Fe-Pd-C, Fe-Pd-Si, Fe-Pd-Ge, Fe-Pd-Sn, Fe-Pd-Pb |
| Fe-Ag-Sb, Fe-Ag-P, Fe-Ag-As, Fe-Ag-Bi, Fe-Ag-S, Fe-Ag-Se, Fe-Ag-Te, Fe-Ag-B, Fe-Ag-Al, Fe-Ag-Ga, Fe-Ag-In, Fe-Ag-Tl, Fe-Ag-C, Fe-Ag-Si, Fe-Ag-Ge, Fe-Ag-Sn, Fe-Ag-Pb |
| Fe-Cd-Sb, Fe-Cd-P, Fe-Cd-As, Fe-Cd-Bi, Fe-Cd-S, Fe-Cd-Se, Fe-Cd-Te, Fe-Cd-B, Fe-Cd-Al, Fe-Cd-Ga, Fe-Cd-In, Fe-Cd-Tl, Fe-Cd-C, Fe-Cd-Si, Fe-Cd-Ge, Fe-Cd-Sn, Fe-Cd-Pb |
| Fe-La-Sb, Fe-La-P, Fe-La-As, Fe-La-Bi, Fe-La-S, Fe-La-Se, Fe-La-Te, Fe-La-B, Fe-La-Al, Fe-La-Ga, Fe-La-In, Fe-La-Tl, Fe-La-C, Fe-La-Si, Fe-La-Ge, Fe-La-Sn, Fe-La-Pb |
| Fe-Hf-Sb, Fe-Hf-P, Fe-Hf-As, Fe-Hf-Bi, Fe-Hf-S, Fe-Hf-Se, Fe-Hf-Te, Fe-Hf-B, Fe-Hf-Al, Fe-Hf-Ga, Fe-Hf-In, Fe-Hf-Tl, Fe-Hf-C, Fe-Hf-Si, Fe-Hf-Ge, Fe-Hf-Sn, Fe-Hf-Pb |
| Fe-Ta-Sb, Fe-Ta-P, Fe-Ta-As, Fe-Ta-Bi, Fe-Ta-S, Fe-Ta-Se, Fe-Ta-Te, Fe-Ta-B, Fe-Ta-Al, Fe-Ta-Ga, Fe-Ta-In, Fe-Ta-Tl, Fe-Ta-C, Fe-Ta-Si, Fe-Ta-Ge, Fe-Ta-Sn, Fe-Ta-Pb |

| Table 2 - Constituents of ternary compositions comprising Fe for use in the present invention |
|---|
| Fe-W-Sb, Fe-W-P, Fe-W-As, Fe-W-Bi, Fe-W-S, Fe-W-Se, Fe-W-Te, Fe-W-B, Fe-W-Al, Fe-W-Ga, Fe-W-In, Fe-W-Tl, Fe-W-C, Fe-W-Si, Fe-W-Ge, Fe-W-Sn, Fe-W-Pb |
| Fe-Re-Sb, Fe-Re-P, Fe-Re-As, Fe-Re-Bi, Fe-Re-S, Fe-Re-Se, Fe-Re-Te, Fe-Re-B, Fe-Re-Al, Fe-Re-Ga, Fe-Re-In, Fe-Re-Tl, Fe-Re-C, Fe-Re-Si, Fe-Re-Ge, Fe-Re-Sn, Fe-Re-Pb |
| Fe-Os-Sb, Fe-Os-P, Fe-Os-As, Fe-Os-Bi, Fe-Os-S, Fe-Os-Se, Fe-Os-Te, Fe-Os-B, Fe-Os-Al, Fe-Os-Ga, Fe-Os-In, Fe-Os-Tl, Fe-Os-C, Fe-Os-Si, Fe-Os-Ge, Fe-Os-Sn, Fe-Os-Pb |
| Fe-Ir-Sb, Fe-Ir-P, Fe-Ir-As, Fe-Ir-Bi, Fe-Ir-S, Fe-Ir-Se, Fe-Ir-Te, Fe-Ir-B, Fe-Ir-Al, Fe-Ir-Ga, Fe-Ir-In, Fe-Ir-Tl, Fe-Ir-C, Fe-Ir-Si, Fe-Ir-Ge, Fe-Ir-Sn, Fe-Ir-Pb |
| Fe-Pt-Sb, Fe-Pt-P, Fe-Pt-As, Fe-Pt-Bi, Fe-Pt-S, Fe-Pt-Se, Fe-Pt-Te, Fe-Pt-B, Fe-Pt-Al, Fe-Pt-Ga, Fe-Pt-In, Fe-Pt-Tl, Fe-Pt-C, Fe-Pt-Si, Fe-Pt-Ge, Fe-Pt-Sn, Fe-Pt-Pb |
| Fe-Au-Sb, Fe-Au-P, Fe-Au-As, Fe-Au-Bi, Fe-Au-S, Fe-Au-Se, Fe-Au-Te, Fe-Au-B, Fe-Au-Al, Fe-Au-Ga, Fe-Au-In, Fe-Au-Tl, Fe-Au-C, Fe-Au-Si, Fe-Au-Ge, Fe-Au-Sn, Fe-Au-Pb |
| Fe-Hg-Sb, Fe-Hg-P, Fe-Hg-As, Fe-Hg-Bi, Fe-Hg-S, Fe-Hg-Se, Fe-Hg-Te, Fe-Hg-B, Fe-Hg-Al, Fe-Hg-Ga, Fe-Hg-In, Fe-Hg-Tl, Fe-Hg-C, Fe-Hg-Si, Fe-Hg-Ge, Fe-Hg-Sn, Fe-Hg-Pb |
| Fe-Al-Sb, Fe-Ce-P, Fe-Ce-As, Fe-Ce-Bi, Fe-Ce-S, Fe-Ce-Se, Fe-Ce-Te, Fe-Ce-B, Fe-Ce-Al, Fe-Ce-Ga, Fe-Ce-In, Fe-Ce-Tl, Fe-Ce-C, Fe-Ce-Si, Fe-Ce-Ge, Fe-Ce-Sn, Fe-Ce-Pb |
| Fe-Pr-Sb, Fe-Pr-P, Fe-Pr-As, Fe-Pr-Bi, Fe-Pr-S, Fe-Pr-Se, Fe-Pr-Te, Fe-Pr-B, Fe-Pr-Al, Fe-Pr-Ga, Fe-Pr-In, Fe-Pr-Tl, Fe-Pr-C, Fe-Pr-Si, Fe-Pr-Ge, Fe-Pr-Sn, Fe-Pr-Pb |
| Fe-Nd-Sb, Fe-Nd-P, Fe-Nd-As, Fe-Nd-Bi, Fe-Nd-S, Fe-Nd-Se, Fe-Nd-Te, Fe-Nd-B, Fe-Nd-Al, Fe-Nd-Ga, Fe-Nd-In, Fe-Nd-Tl, Fe-Nd-C, Fe-Nd-Si, Fe-Nd-Ge, Fe-Nd-Sn, Fe-Nd-Pb |
| Fe-Pm-Sb, Fe-Pm-P, Fe-Pm-As, Fe-Pm-Bi, Fe-Pm-S, Fe-Pm-Se, Fe-Pm-Te, Fe-Pm-B, Fe-Pm-Al, Fe-Pm-Ga, Fe-Pm-In, Fe-Pm-Tl, Fe-Pm-C, Fe-Pm-Si, Fe-Pm-Ge, Fe-Pm-Sn, Fe-Pm-Pb |
| Fe-Sm-Sb, Fe-Sm-P, Fe-Sm-As, Fe-Sm-Bi, Fe-Sm-S, Fe-Sm-Se, Fe-Sm-Te, Fe-Sm-B, Fe-Sm-Al, Fe-Sm-Ga, Fe-Sm-In, Fe-Sm-Tl, Fe-Sm-C, Fe-Sm-Si, Fe-Sm-Ge, Fe-Sm-Sn, Fe-Sm-Pb |
| Fe-Al-Sb, Fe-Eu-P, Fe-Eu-As, Fe-Eu-Bi, Fe-Eu-S, Fe-Eu-Se, Fe-Eu-Te, Fe-Eu-B, Fe-Eu-Al, Fe-Eu-Ga, Fe-Eu-In, Fe-Eu-Tl, Fe-Eu-C, Fe-Eu-Si, Fe-Eu-Ge, Fe-Eu-Sn, Fe-Eu-Pb |
| Fe-Gd-Sb, Fe-Gd-P, Fe-Gd-As, Fe-Gd-Bi, Fe-Gd-S, Fe-Gd-Se, Fe-Gd-Te, Fe-Gd-B, Fe-Gd-Al, Fe-Gd-Ga, Fe-Gd-In, Fe-Gd-Tl, Fe-Gd-C, Fe-Gd-Si, Fe-Gd-Ge, Fe-Gd-Sn, Fe-Gd-Pb |
| Fe-Tb-Sb, Fe-Tb-P, Fe-Tb-As, Fe-Tb-Bi, Fe-Tb-S, Fe-Tb-Se, Fe-Tb-Te, Fe-Tb-B, Fe-Tb-Al, Fe-Th-Ga, Fe-Tb-In, Fe-Tb-Tl, Fe-Tb-C, Fe-Tb-Si, Fe-Tb-Ge, Fe-Tb-Sn, Fe-Tb-Pb |
| Fe-Dy-Sb, Fe-Dy-P, Fe-Dy-As, Fe-Dy-Bi, Fe-Dy-S, Fe-Dy-Se, Fe-Dy-Te, Fe-Dy-B, Fe-Dy-Al, Fe-Dy-Ga, Fe-Dy-In, Fe-Dy-Tl, Fe-Dy-C, Fe-Dy-Si, Fe-Dy-Ge, Fe-Dy-Sn, Fe-Dy-Pb |
| Fe-Ho-Sb, Fe-Ho-P, Fe-Ho-As, Fe-Ho-Bi, Fe-Ho-S, Fe-Ho-Se, Fe-Ho-Te, Fe-Ho-B, Fe-Ho-Al, Fe-Ho-Ga, Fe-Ho-In, Fe-Ho-Tl, Fe-Ho-C, Fe-Ho-Si, Fe-Ho-Ge, Fe-Ho-Sn, Fe-Ho-Pb |

(continued)

| Table 2 - Constituents of ternary compositions comprising Fe for use in the present invention |
|---|
| Fe-Er-Sb, Fe-Er-P, Fe-Er-As, Fe-Er-Bi, Fe-Er-S, Fe-Er-Se, Fe-Er-Te, Fe-Er-B, Fe-Er-Al, Fe-Er-Ga, Fe-Er-In, Fe-Er-Tl, Fe-Er-C, Fe-Er-Si, Fe-Er-Ge, Fe-Er-Sn, Fe-Er-Pb<br><br>Fe-Tm-Sb, Fe-Tm-P, Fe-Tm-As, Fe-Tm-Bi, Fe-Tm-S, Fe-Tm-Se, Fe-Tm-Te, Fe-Tm-B, Fe-Tm-Al, Fe-Tm-Ga, Fe-Tm-In, Fe-Tm-Tl, Fe-Tm-C, Fe-Tm-Si, Fe-Tm-Ge, Fe-Tm-Sn, Fe-Tm-Pb<br><br>Fe-Yb-Sb, Fe-Yb-P, Fe-Yb-As, Fe-Yb-Bi, Fe-Yb-S, Fe-Yb-Se, Fe-Yb-Te, Fe-Yb-B, Fe-Yb-Al, Fe-Yb-Ga, Fe-Yb-In, Fe-Yb-Tl, Fe-Yb-C, Fe-Yb-Si, Fe-Yb-Ge, Fe-Yb-Sn, Fe-Yb-Pb<br><br>Fe-Lu-Sb, Fe-Lu-P, Fe-Lu-As, Fe-Lu-Bi, Fe-Lu-S, Fe-Lu-Se, Fe-Lu-Te, Fe-Lu-B, Fe-Lu-Al, Fe-Lu-Ga, Fe-Lu-In, Fe-Lu-Tl, Fe-Lu-C, Fe-Lu-Si, Fe-Lu-Ge, Fe-Lu-Sn, Fe-Lu-Pb |

Alternatively, the use according to the present invention employs a thermoelectric material comprising a ternary composition which corresponds to a composition having the formula $FeSb_2$ in which Sb is fully or partly substituted.

Table 3 below lists an array of combinations of constituent elements of a ternary thermoelectric material according to the use according to the present invention. The combinations listed in Table 3 are obtained either by partly substituting Sb in the formula $FeSb_2$ with one element selected from the group comprising: P, As, Bi, S, Se, Te, B, Al, Ga, In, Tl, C, Si, Ge, Sn, Pb; or by fully substituting Sb in the formula $FeSb_2$ with two different elements selected from the group comprising: P, As, Bi, S, Se, Te, B, Al, Ga, In, Tl, C, Si, Ge, Sn, Pb.

| Table 3 - Constituents of ternary compositions comprising Fe for use in the present invention |
|---|
| Fe-Sb-P, Fe-Sb-As, Fe-Sb-Bi, Fe-Sb-S, Fe-Sb-Se, Fe-Sb-Te, Fe-Sb-B, Fe-Sb-Al, Fe-Sb-Ga, Fe-Sb-In, Fe-Sb-Tl, Fe-Sb-C, Fe-Sb-Si, Fe-Sb-Ge, Fe-Sb-Sn, Fe-Sb-Pb<br><br>Fe-P-Sb, Fe-P-As, Fe-P-Bi, Fe-P-S, Fe-P-Se, Fe-P-Te, Fe-P-B, Fe-P-Al, Fe-P-Ga, Fe-P-In, Fe-P-Tl, Fe-P-C, Fe-P-Si, Fe-P-Ge, Fe-P-Sn, Fe-P-Pb<br><br>Fe-As-Sb, Fe-As-P, Fe-As-Bi, Fe-As-S, Fe-As-Se, Fe-As-Te, Fe-As-B, Fe-As-Al, Fe-As-Ga, Fe-As-In, Fe-As-Tl, Fe-As-C, Fe-As-Si, Fe-As-Ge, Fe-As-Sn, Fe-As-Pb<br><br>Fe-Bi-Sb, Fe-Bi-P, Fe-Bi-As, Fe-Bi-S, Fe-Bi-Se, Fe-Bi-Te, Fe-Bi-B, Fe-Bi-Al, Fe-Bi-Ga, Fe-Bi-In, Fe-Bi-Tl, Fe-Bi-C, Fe-Bi-Si, Fe-Bi-Ge, Fe-Bi-Sn, Fe-Bi-Pb<br><br>Fe-S-Sb, Fe-S-P, Fe-S-As, Fe-S-Bi, Fe-S-Se, Fe-S-Te, Fe-S-B, Fe-S-Al, Fe-S-Ga, Fe-S-In, Fe-S-T1, Fe-S-C, Fe-S-Si, Fe-S-Ge, Fe-S-Sn, Fe-S-Pb<br><br>Fe-Se-Sb, Fe-Se-P, Fe-Se-As, Fe-Se-Bi, Fe-Se-S, Fe-Se-Te, Fe-Se-B, Fe-Se-Al, Fe-Se-Ga, Fe-Se-In, Fe-Se-Tl, Fe-Se-C, Fe-Se-Si, Fe-Se-Ge, Fe-Se-Sn, Fe-Se-Pb<br><br>Fe-Te-Sb, Fe-Te-P, Fe-Te-As, Fe-Te-Bi, Fe-Te-S, Fe-Te-Se, Fe-Te-B, Fe-Te-Al, Fe-Te-Ga, Fe-Te-In, Fe-Te-Tl, Fe-Te-C, Fe-Te-Si, Fe-Te-Ge, Fe-Te-Sn, Fe-Te-Pb<br><br>Fe-B-Sb, Fe-B-P, Fe-B-As, Fe-B-Bi, Fe-B-S, Fe-B-Se, Fe-B-Te Fe-B-Al, Fe-B-Ga, Fe-B-In, Fe-B-Tl, Fe-B-C, Fe-B-Si, Fe-B-Ge, Fe-B-Sn, Fe-B-Pb<br><br>Fe-Al-Sb, Fe-Al-P, Fe-Al-As, Fe-Al-Bi, Fe-Al-S, Fe-Al-Se, Fe-Al-Te, Fe-Al-B, Fe-Al-Ga, Fe-Al-In, Fe-Al-Tl, Fe-Al-C, Fe-Al-Si, Fe-Al-Ge, Fe-Al-Sn, Fe-Al-Pb<br><br>Fe-Ga-Sb, Fe-Ga-P, Fe-Ga-As, Fe-Ga-Bi, Fe-Ga-S, Fe-Ga-Se, Fe-Ga-Te, Fe-Ga-B, Fe-Ga-Al, Fe-Ga-In, Fe-Ga-Tl, Fe-Ga-C, Fe-Ga-Si, Fe-Ga-Ge, Fe-Ga-Sn, Fe-Ga-Pb |

(continued)

| Table 3 - Constituents of ternary compositions comprising Fe for use in the present invention |
|---|
| Fe-In-Sb, Fe-In-P, Fe-In-As, Fe-In-Bi, Fe-In-S, Fe-In-Se, Fe-In-Te, Fe-In-B, Fe-In-Al, Fe-In-Ga, Fe-In-Tl, Fe-In-C, Fe-In-Si, Fe-In-Ge, Fe-In-Sn, Fe-In-Pb |
| Fe-Tl-Sb, Fe-Tl-P, Fe-Tl-As, Fe-Tl-Bi, Fe-Tl-S, Fe-Tl-Se, Fe-Tl-Te, Fe-Tl-B, Fe-Tl-Al, Fe-Tl-Ga, Fe-Tl-In, Fe-Tl-C, Fe-Tl-Si, Fe-Tl-Ge, Fe-Tl-Sn, Fe-Tl-Pb |
| Fe-C-Sb, Fe-C-P, Fe-C-As, Fe-C-Bi, Fe-C-S, Fe-C-Se, Fe-C-Te, Fe-C-B, Fe-C-Al, Fe-C-Ga, Fe-C-In, Fe-C-Tl, Fe-C-Si, Fe-C-Ge, Fe-C-Sn, Fe-C-Pb |
| Fe-Si-Sb, Fe-Si-P, Fe-Si-As, Fe-Si-Bi, Fe-Si-S, Fe-Si-Se, Fe-Si-Te, Fe-Si-B, Fe-Si-Al, Fe-Si-Ga, Fe-Si-In, Fe-Si-Tl, Fe-Si-C, Fe-Si-Ge, Fe-Si-Sn, Fe-Si-Pb |
| Fe-Ge-Sb, Fe-Ge-P, Fe-Ge-As, Fe-Ge-Bi, Fe-Ge-S, Fe-Ge-Se, Fe-Ge-Te, Fe-Ge-B, Fe-Ge-Al, Fe-Ge-Ga, Fe-Ge-In, Fe-Ge-Tl, Fe-Ge-C, Fe-Ge-Si, Fe-Ge-Sn, Fe-Ge-Pb |
| Fe-Sn-Sb, Fe-Sn-P, Fe-Sn-As, Fe-Sn-Bi, Fe-Sn-S, Fe-Sn-Se, Fe-Sn-Te, Fe-Sn-B, Fe-Sn-Al, Fe-Sn-Ga, Fe-Sn-In, Fe-Sn-Tl, Fe-Sn-C, Fe-Sn-Si, Fe-Sn-Ge, Fe-Sn-Pb |
| Fe-Pb-Sb, Fe-Pb-P, Fe-Pb-As, Fe-Pb-Bi, Fe-Pb-S, Fe-Pb-Se, Fe-Pb-Te, Fe-Pb-B, Fe-Pb-Al, Fe-Pb-Ga, Fe-Pb-In, Fe-Pb-Tl, Fe-Pb-C, Fe-Pb-Si, Fe-Pb-Ge, Fe-Pb-Sn. |

In the list of combinations of constituent elements appearing in Table 2 and 3, a term denoted "*X-Y-Z*" is to be understood as a composition composed of the constituents *X, Y* and *Z*. (for example the term "Fe-P-Bi" is to be interpreted as a composition consisting of Fe, P and Bi.

It should be noted that the list of combinations of constituent elements of the compounds for use according to the present invention as set out in Table 2 and 3 only relates to possible combination of constituent elements, and not to the exact stoichiometries of these constituent elements. The only restrictions on the exact stoichiometries of the constituent elements of the thermoelectric materials according to the use according to the present invention are those imposed as set out in the appended claims.

In another embodiment the thermoelectric material employed according to the use according to the present invention, may be any ternary combination of constituent elements obtained by fully substituting Fe in any of the combinations of elements listed in Table 2 and 3 with an element selected from the group comprising: Sc, Ti, V, Cr, Mn, Co, Ni, Cu, Zn, Y, Zr, Nb, Mo, Tc, Ru, Rh, Pd, Ag, Cd, La, Hf, Ta, W, Re, Os, Ir, Pt, Au and Hg.

In a one embodiment according to the use according to the present invention, the ternary thermoelectric material is a material having the formula $FeSb_2$, wherein part of or all Fe optionally being substituted by one or two elements selected from the group comprising: Mn, Co, and Ru; and wherein part of or all Sb optionally being substituted by one or two elements selected from the group comprising: Sb, Bi, As and P.

In a preferred embodiment according to the use according to the present invention, the ternary thermoelectric material is a material having a combination of constituents selected form the group of the combinations comprising: Fe-Ru-Sb, Fe-Mn-Sb, Fe-Co-Sb, Fe-Sn-Se, Fe-Pb-Te, Fe-Sn-Te, Fe-Sb-Te, Fe-Sb-Sn, and Fe-Sb-As.

Use of a quaternary or a quinary thermoelectric material

In yet another embodiment of the use according to the present invention, the thermoelectric material is a material having a quaternary or quinary composition. The composition of such a material may be constructed by substituting part of or all of the Fe of one of the constituent combinations listed in Table 2 and 3 with a combination of the elements as set out in Table 4 below.

| Table 4 - Combinations of elements for optional substitution of part or all of the Fe in the materials having the constituents as set out in table 2 - 3 in order to obtain quaternary or quinary combinations of constituent elements |
| --- |

Sc-Fe, Ti-Fe, V-Fe, Cr-Fe, Mn-Fe, Co-Fe, Ni-Fe, Cu-Fe, Zn-Fe, Y-Fe, Zr-Fe, Nb-Fe, Mo-Fe, Tc-Fe, Ru-Fe, Rh-Fe, Pd-Fe, Ag-Fe, Cd-Fe, La-Fe, Hf-Fe, Ta-Fe, W-Fe, Re-Fe, Os-Fe, Ir-Fe, Pt-Fe, Au-Fe, Hg-Fe, Ce-Fe, Pr-Fe, Nd-Fe, Pm-Fe, Sm-Fe, Eu-Fe, Gd-Fe, Tb-Fe, Dy-Fe, Ho-Fe, Er-Fe, Tm-Fe, Yb-Fe, Lu-Fe;

Fe-Sc, Ti-Sc, V-Sc, Cr-Sc, Mn-Sc, Co-Sc, Ni-Sc, Cu-Sc, Zn-Sc, Y-Sc, Zr-Sc, Nb-Sc, Mo-Sc, Tc-Sc, Ru-Sc, Rh-Sc, Pd-Sc, Ag-Sc, Cd-Sc, La-Sc, Hf-Sc, Ta-Sc, W-Sc, Re-Sc, Os-Sc, Ir-Sc, Pt-Sc, Au-Sc, Hg-Sc, Ce-Sc, Pr-Sc, Nd-Sc, Pm-Sc, Sm-Sc, Eu-Sc, Gd-Sc, Tb-Sc, Dy-Sc, Ho-Sc, Er-Sc, Tm-Sc, Yb-Sc, Lu-Sc;

Fe-Ti, Sc-Ti, V-Ti, Cr-Ti, Mn-Ti, Co-Ti, Ni-Ti, Cu-Ti, Zn-Ti, Y-Ti, Zr-Ti, Nb-Ti, Mo-Ti, Tc-Ti, Ru-Ti, Rh-Ti, Pd-Ti, Ag-Ti, Cd-Ti, La-Ti, Hf-Ti, Ta-Ti, W-Ti, Re-Ti, Os-Ti, Ir-Ti, Pt-Ti, Au-Ti, Hg-Ti, Ce-Ti, Pr-Ti, Nd-Ti, Pm-Ti, Sm-Ti, Eu-Ti, Gd-Ti, Tb-Ti, Dy-Ti, Ho-Ti, Er-Ti, Tm-Ti, Yb-Ti, Lu-Ti;

Fe-V, Sc-V, Ti-V, Cr-V, Mn-V, Co-V, Ni-V, Cu-V, Zn-V, Y-V, Zr-V, Nb-V, Mo-V, Tc-V, Ru-V, Rh-V, Pd-V, Ag-V, Cd-V, La-V, Hf-V, Ta-V, W-V, Re-V, Os-V, Ir-V, Pt-V, Au-V, Hg-V, Ce-V, Pr-V, Nd-V, Pm-V, Sm-V, Eu-V, Gd-V, Tb-V, Dy-V, Ho-V, Er-V, Tm-V, Yb-V, Lu-V;

Fe-Cr, Sc-Cr, Ti-Cr, V-Cr, Mn-Cr, Co-Cr, Ni-Cr, Cu-Cr, Zn-Cr, Y-Cr, Zr-Cr, Nb-Cr, Mo-Cr, Tc-Cr, Ru-Cr, Rh-Cr, Pd-Cr, Ag-Cr, Cd-Cr, La-Cr, Hf-Cr, Ta-Cr, W-Cr, Re-Cr, Os-Cr, Ir-Cr, Pt-Cr, Au-Cr, Hg-Cr, Ce-Cr, Pr-Cr, Nd-Cr, Pm-Cr, Sm-Cr, Eu-Cr, Gd-Cr, Tb-Cr, Dy-Cr, Ho-Cr, Er-Cr, Tm-Cr, Yb-Cr, Lu-Cr;

Fe-Mn, Sc-Mn, Ti-Mn, V-Mn, Cr-Mn, Co-Mn, Ni-Mn, Cu-Mn, Zn-Mn, Y-Mn, Zr-Mn, Nb-Mn, Mo-Mn, Tc-Mn, Ru-Mn, Rh-Mn, Pd-Mn, Ag-Mn, Cd-Mn, La-Mn, Hf-Mn, Ta-Mn, W-Mn, Re-Mn, Os-Mn, Ir-Mn, Pt-Mn, Au-Mn, Hg-Mn, Ce-Mn, Pr-Mn, Nd-Mn, Pm-Mn, Sm-Mn, Eu-Mn, Gd-Mn, Tb-Mn, Dy-Mn, Ho-Mn, Er-Mn, Tm-Mn, Yb-Mn, Lu-Mn;

Fe-Co, Sc-Co, Ti-Co, V-Co, Cr-Co, Mn-Co, Ni-Co, Cu-Co, Zn-Co, Y-Co, Zr-Co, Nb-Co, Mo-Co, Tc-Co, Ru-Co, Rh-Co, Pd-Co, Ag-Co, Cd-Co, La-Co, Hf-Co, Ta-Co, W-Co, Re-Co, Os-Co, Ir-Co, Pt-Co, Au-Co, Hg-Co, Ce-Co, Pr-Co, Nd-Co, Pm-Co, Sm-Co, Eu-Co, Gd-Co, Tb-Co, Dy-Co, Ho-Co, Er-Co, Tm-Co, Yb-Co, Lu-Co;

Fe-Ni, Sc-Ni, Ti-Ni, V-Ni, Cr-Ni, Mn-Ni, Co-Ni, Cu-Ni, Zn-Ni, Y-Ni, Zr-Ni, Nb-Ni, Mo-Ni, Tc-Ni, Ru-Ni, Rh-Ni, Pd-Ni, Ag-Ni, Cd-Ni, La-Ni, Hf-Ni, Ta-Ni, W-Ni, Re-Ni, Os-Ni, Ir-Ni, Pt-Ni, Au-Ni, Hg-Ni, Ce-Ni, Pr-Ni, Nd-Ni, Pm-Ni, Sm-Ni, Eu-Ni, Gd-Ni, Tb-Ni, Dy-Ni, Ho-Ni, Er-Ni, Tm-Ni, Yb-Ni, Lu-Ni;

Fe-Cu, Sc-Cu, Ti-Cu, V-Cu, Cr-Cu, Mn-Cu, Co-Cu, Ni-Cu, Zn-Cu, Y-Cu, Zr-Cu, Nb-Cu, Mo-Cu, Tc-Cu, Ru-Cu, Rh-Cu, Pd-Cu, Ag-Cu, Cd-Cu, La-Cu, Hf-Cu, Ta-Cu, W-Cu, Re-Cu, Os-Cu, Ir-Cu, Pt-Cu; Au-Cu, Hg-Cu, Ce-Cu, Pr-Cu, Nd-Cu, Pm-Cu, Sm-Cu, Eu-Cu, Gd-Cu, Tb-Cu, Dy-Cu, Ho-Cu, Er-Cu, Tm-Cu, Yb-Cu, Lu-Cu;

Fe-Zn, Sc-Zn, Ti-Zn, V-Zn, Cr-Zn, Mn-Zn, Co-Zn, Ni-Zn, Cu-Zn, Y-Zn, Zr-Zn, Nb-Zn, Mo-Zn, Tc-Zn, Ru-Zn, Rh-Zn, Pd-Zn, Ag-Zn, Cd-Zn, La-Zn, Hf-Zn, Ta-Zn, W-Zn, Re-Zn, Os-Zn, Ir-Zn, Pt-Zn, Au-Zn, Hg-Zn, Ce-Zn, Pr-Zn, Nd-Zn, Pm-Zn, Sm-Zn, Eu-Zn, Gd-Zn, Tb-Zn, Dy-Zn, Ho-Zn, Er-Zn, Tm-Zn, Yb-Zn, Lu-Zn;

Fe-Y, Sc-Y, Ti-Y, V-Y, Cr-Y, Mn-Y, Co-Y, Ni-Y, Cu-Y, Zn-Y, Zr-Y, Nb-Y, Mo-Y, Tc-Y, Ru-Y, Rh-Y, Pd-Y, Ag-Y, Cd-Y, La-Y, Hf-Y, Ta-Y, W-Y, Re-Y, Os-Y, Ir-Y, Pt-Y, Au-Y, Hg-Y, Ce-Y, Pr-Y, Nd-Y, Pm-Y, Sm-Y, Eu-Y, Gd-Y, Tb-Y, Dy-Y, Ho-Y, Er-Y, Tm-Y, Yb-Y, Lu-Y;

Fe-Zr, Sc-Zr, Ti-Zr, V-Zr, Cr-Zr, Mn-Zr, Co-Zr, Ni-Zr, Cu-Zr, Zn-Zr, Y-Zr, Nb-Zr, Mo-Zr, Tc-Zr, Ru-Zr, Rh-Zr, Pd-Zr, Ag-Zr, Cd-Zr, La-Zr, Hf-Zr, Ta-Zr, W-Zr, Re-Zr, Os-Zr, Ir-Zr, Pt-Zr, Au-Zr, Hg-Zr, Ce-Zr, Pr-Zr, Nd-Zr, Pm-Zr, Sm-Zr, Eu-Zr, Gd-Zr, Tb-Zr, Dy-Zr, Ho-Zr, Er-Zr, Tm-Zr, Yb-Zr, Lu-Zr;

Fe-Nb, Sc-Nb, Ti-Nb, V-Nb, Cr-Nb, Mn-Nb, Co-Nb, Ni-Nb, Cu-Nb, Zn-Nb, Y-Nb, Zr-Nb, Mo-Nb, Tc-Nb, Ru-Nb, Rh-Nb, Pd-Nb, Ag-Nb, Cd-Nb, La-Nb, Hf-Nb, Ta-Nb, W-Nb, Re-Nb, Os-Nb, Ir-Nb, Pt-Nb, Au-Nb, Hg-Nb, Ce-Nb, Pr-Nb, Nd-Nb, Pm-Nb, Sm-Nb, Eu-Nb, Gd-Nb, Tb-Nb, Dy-Nb, Ho-Nb, Er-Nb, Tm-Nb, Yb-Nb, Lu-Nb;

(continued)

| Table 4 - Combinations of elements for optional substitution of part or all of the Fe in the materials having the constituents as set out in table 2 - 3 in order to obtain quaternary or quinary combinations of constituent elements |
|---|
| Fe-Mo, Sc-Mo, Ti-Mo, V-Mo, Cr-Mo, Mn-Mo, Co-Mo, Ni-Mo, Cu-Mo, Zn-Mo, Y-Mo, Zr-Mo, Nb-Mo, Tc-Mo, Ru-Mo, Rh-Mo, Pd-Mo, Ag-Mo, Cd-Mo, La-Mo, Hf-Mo, Ta-Mo, W-Mo, Re-Mo, Os-Mo, Ir-Mo, Pt-Mo, Au-Mo, Hg-Mo, Ce-Mo, Pr-Mo, Nd-Mo, Pm-Mo, Sm-Mo, Eu-Mo, Gd-Mo, Tb-Mo, Dy-Mo, Ho-Mo, Er-Mo, Tm-Mo, Yb-Mo, Lu-Mo; |
| Fe-Tc, Sc-Tc, Ti-Tc, V-Tc, Cr-Tc, Mn-Tc, Co-Tc, Ni-Tc, Cu-Tc, Zn-Tc, Y-Tc, Zr-Tc, Nb-Tc, Mo-Tc, Ru-Tc, Rh-Tc, Pd-Tc, Ag-Tc, Cd-Tc, La-Tc, Hf-Tc, Ta-Tc, W-Tc, Re-Tc, Os-Tc, Ir-Tc, Pt-Tc, Au-Tc, Hg-Tc, Ce-Tc, Pr-Tc, Nd-Tc, Pm-Tc, Sm-Tc, Eu-Tc, Gd-Tc, Tb-Tc, Dy-Tc, Ho-Tc, Er-Tc, Tm-Tc, Yb-Tc, Lu-Tc; |
| FeRu, Sc-Ru, Ti-Ru, V-Ru, Cr-Ru, Mn-Ru, Co-Ru, Ni-Ru, Cu-Ru, Zn-Ru, Y-Ru, Zr-Ru, Nb-Ru, Mo-Ru, Tc-Ru, Rh-Ru, Pd-Ru, Ag-Ru, Cd-Ru, La-Ru, Hf-Ru, Ta-Ru, W-Ru, Re-Ru, Os-Ru, Ir-Ru, Pt-Ru, Au-Ru, Hg-Ru, Ce-Ru, Pr-Ru, Nd-Ru, Pm-Ru, Sm-Ru, Eu-Ru, Gd-Ru, Tb-Ru, Dy-Ru, Ho-Ru, Er-Ru, Tm-Ru, Yb-Ru, Lu-Ru; |
| Fe-Rh, Sc-Rh, Ti-Rh, V-Rh, Cr-Rh, Mn-Rh, Co-Rh, Ni-Rh, Cu-Rh, Zn-Rh, Y-Rh, Zr-Rh, Nb-Rh, Mo-Rh, Tc-Rh, Ru-Rh, Pd-Rh, Ag-Rh, Cd-Rh, La-Rh, Hf-Rh, Ta-Rh, W-Rh, Re-Rh, Os-Rh, Ir-Rh, Pt-Rh, Au-Rh, Hg-Rh, Ce-Rh, Pr-Rh, Nd-Rh, Pm-Rh, Sm-Rh, Eu-Rh, Gd-Rh, Tb-Rh, Dy-Rh, Ho-Rh, Er-Rh, Tm-Rh, Yb-Rh, Lu-Rh; |
| Fe-Pd, Sc-Pd, Ti-Pd, V-Pd, Cr-Pd, Mn-Pd, Co-Pd, Ni-Pd, Cu-Pd, Zn-Pd, Y-Pd, Zr-Pd, Nb-Pd, Mo-Pd, Tc-Pd, Ru-Pd, Rh-Pd, Ag-Pd, Cd-Pd, La-Pd, Hf-Pd, Ta-Pd, W-Pd, Re-Pd, Os-Pd, Ir-Pd, Pt-Pd, Au-Pd, Hg-Pd, Ce-Pd, Pr-Pd, Nd-Pd, Pm-Pd, Sm-Pd, Eu-Pd, Gd-Pd, Tb-Pd, Dy-Pd, Ho-Pd, Er-Pd, Tm-Pd, Yb-Pd, Lu-Pd; |
| Fe-Ag, Sc-Ag, Ti-Ag, V-Ag, Cr-Ag, Mn-Ag, Co-Ag, Ni-Ag, Cu-Ag, Zn-Ag, Y-Ag, Zr-Ag, Nb-Ag, Mo-Ag, Tc-Ag, Ru-Ag, Rh-Ag, Pd-Ag, Cd-Ag, La-Ag, Hf-Ag, Ta-Ag, W-Ag, Re-Ag, Os-Ag, Ir-Ag, Pt-Ag, Au-Ag, Hg-Ag, Ce-Ag, Pr-Ag, Nd-Ag, Pm-Ag, Sm-Ag, Eu-Ag, Gd-Ag, Tb-Ag, Dy-Ag, Ho-Ag, Er-Ag, Tm-Ag, Yb-Ag, Lu-Ag; |
| Fe-Cd, Sc-Cd, Ti-Cd, V-Cd, Cr-Cd, Mn-Cd, Co-Cd, Ni-Cd, Cu-Cd, Zn-Cd, Y-Cd, Zr-Cd, Nb-Cd, Mo-Cd, Tc-Cd, Ru-Cd, Rh-Cd, Pd-Cd, Ag-Cd, La-Cd, Hf-Cd, Ta-Cd, W-Cd, Re-Cd, Os-Cd, Ir-Cd, Pt-Cd, Au-Cd, Hg-Cd, Ce-Cd, Pr-Cd, Nd-Cd, Pm-Cd, Sm-Cd, Eu-Cd, Gd-Cd, Tb-Cd, Dy-Cd, Ho-Cd, Er-Cd, Tm-Cd, Yb-Cd, Lu-Cd; |
| Fe-La, Sc-La, Ti-La, V-La, Cr-La, Mn-La, Co-La, Ni-La, Cu-La, Zn-La, Y-La, Zr-La, Nb-La, Mo-La, Tc-La, Ru-La, Rh-La, Pd-La, Ag-La, Cd-La, Hf-La, Ta-La, W-La, Re-La, Os-La, Ir-La, Pt-La, Au-La, Hg-La, Ce-La, Pr-La, Nd-La, Pm-La, Sm-La, Eu-La, Gd-La, Tb-La, Dy-La, Ho-La, Er-La, Tm-La, Yb-La, Lu-La; |
| Fe-Hf, Sc-Hf, Ti-Hf, V-Hf, Cr-Hf, Mn-Hf, Co-Hf, Ni-Hf, Cu-Hf, Zn-Hf, Y-Hf, Zr-Hf, Nb-Hf, Mo-Hf, Tc-Hf, Ru-Hf, Rh-Hf, Pd-Hf, Ag-Hf, Cd-Hf, La-Hf, Ta-Hf, W-Hf, Re-Hf, Os-Hf, Ir-Hf, Pt-Hf, Au-Hf, Hg-Hf, Ce-Hf, Pr-Hf, Nd-Hf, Pm-Hf, Sm-Hf, Eu-Hf, Gd-Hf, Tb-Hf, Dy-Hf, Ho-Hf, Er-Hf, Tm-Hf, Yb-Hf, Lu-Hf; |
| Fe-Ta, Sc-Ta, Ti-Ta, V-Ta, Cr-Ta, Mn-Ta, Co-Ta, Ni-Ta, Cu-Ta, Zn-Ta, Y-Ta, Zr-Ta, Nb-Ta, Mo-Ta, Tc-Ta, Ru-Ta, Rh-Ta, Pd-Ta, Ag-Ta, Cd-Ta, La-Ta, Hf-Ta, W-Ta, Re-Ta, Os-Ta, Ir-Ta, Pt-Ta, Au-Ta, Hg-Ta, Ce-Ta, Pr-Ta, Nd-Ta, Pm-Ta, Sm-Ta, Eu-Ta, Gd-Ta, Tb-Ta, Dy-Ta, Ho-Ta, Er-Ta, Tm-Ta, Yb-Ta, Lu-Ta; |
| Fe-W, Sc-W, Ti-W, V-W, Cr-W, Mn-W, Co-W, Ni-W, Cu-W, Zn-W, Y-W, Zr-W, Nb-W, Mo-W, Tc-W, Ru-W, Rh-W, Pd-W, Ag-W, Cd-W, La-W, Hf-W, Ta-W, Re-W, Os-W, Ir-W, Pt-W, Au-W, Hg-W, Ce-W, Pr-W, Nd-W, Pm-W, Sm-W, Eu-W, Gd-W, Tb-W, Dy-W, Ho-W, Er-W, Tm-W, Yb-W, Lu-W; |
| Fe-Re, Sc-Re, Ti-Re, V-Re, Cr-Re, Mn-Re, Co-Re, Ni-Re, Cu-Re, Zn-Re, Y-Re, Zr-Re, Nb-Re, Mo-Re, Tc-Re, Ru-Re, Rh-Re, Pd-Re, Ag-Re, Cd-Re, La-Re, Hf-Re, Ta-Re, W-Re, Os-Re, Ir-Re, Pt-Re, Au-Re, Hg-Re, Ce-Re, Pr-Re, Nd-Re, Pm-Re, Sm-Re, Eu-Re, Gd-Re, Tb-Re, Dy-Re, Ho-Re, Er-Re, Tm-Re, Yb-Re, Lu-Re; |

(continued)

| Table 4 - Combinations of elements for optional substitution of part or all of the Fe in the materials having the constituents as set out in table 2 - 3 in order to obtain quaternary or quinary combinations of constituent elements |
| --- |
| Fe-Os, Sc-Os, Ti-Os, V-Os, Cr-Os, Mn-Os, Co-Os, Ni-Os, Cu-Os, Zn-Os, Y-Os, Zr-Os, Nb-Os, Mo-Os, Tc-Os, Ru-Os, Rh-Os, Pd-Os, Ag-Os, Cd-Os, La-Os, Hf-Os, Ta-Os, W-Os, Re-Os, Ir-Os, Pt-Os, Au-Os, Hg-Os, Ce-Os, Pr-Os, Nd-Os, Pm-Os, Sm-Os, Eu-Os, Gd-Os, Tb-Os, Dy-Os, Ho-Os, Er-Os, Tm-Os, Yb-Os, Lu-Os; |
| Fe-Ir, Sc-Ir, Ti-Ir, V-Ir, Cr-Ir, Mn-Ir, Co-Ir, Ni-Ir, Cu-Ir, Zn-Ir, Y-Ir, Zr-Ir, Nb-Ir, Mo-Ir, Tc-Ir, Ru-Ir, Rh-Ir, Pd-Ir, Ag-Ir, Cd-Ir, La-Ir, Hf-Ir, Ta-Ir, W-Ir, Re-Ir, Os-Ir, Pt-Ir, Au-Ir, Hg-Ir, Ce-Ir, Pr-Ir, Nd-Ir, Pm-Ir, Sm-Ir, Eu-Ir, Gd-Ir, Tb-Ir, Dy-Ir, Ho-Ir, Er-Ir, Tm-Ir, Yb-Ir, Lu-Ir; |
| Fe-Pt, Sc-Pt, Ti-Pt, V-Pt, Cr-Pt, Mn-Pt, Co-Pt, Ni-Pt, Cu-Pt, Zn-Pt, Y-Pt, Zr-Pt, Nb-Pt, Mo-Pt, Tc-Pt, Ru-Pt, Rh-Pt, Pd-Pt, Ag-Pt, Cd-Pt, La-Pt, Hf-Pt, Ta-Pt, W-Pt, Re-Pt, Os-Pt, Ir-Pt, Au-Pt, Hg-Pt, Ce-Pt, Pr-Pt, Nd-Pt, Pm-Pt, Sm-Pt, Eu-Pt, Gd-Pt, Tb-Pt, Dy-Pt, Ho-Pt, Er-Pt, Tm-Pt, Yb-Pt, Lu-Pt; |
| Fe-Au, Sc-Au, Ti-Au, V-Au, Cr-Au, Mn-Au, Co-Au, Ni-Au, Cu-Au, Zn-Au, Y-Au, Zr-Au, Nb-Au, Mo-Au, Tc-Au, Ru-Au, Rh-Au, Pd-Au, Ag-Au, Cd-Au, La-Au, Hf-Au, Ta-Au, W-Au, Re-Au, Os-Au, Ir-Au, Pt-Au, Hg-Au, Ce-Au, Pr-Au, Nd-Au, Pm-Au, Sm-Au, Eu-Au, Gd-Au, Tb-Au, Dy-Au, Ho-Au, Er-Au, Tm-Au, Yb-Au, Lu-Au; |
| Fe-Hg, Sc-Hg, Ti-Hg, V-Hg, Cr-Hg, Mn-Hg, Co-Hg, Ni-Hg, Cu-Hg, Zn-Hg, Y-Hg, Zr-Hg, Nb-Hg, Mo-Hg, Tc-Hg, Ru-Hg, Rh-Hg, Pd-Hg, Ag-Hg, Cd-Hg, La-Hg, Hf-Hg, Ta-Hg, W-Hg, Re-Hg, Os-Hg, Ir-Hg, Pt-Hg, Au-Hg, Ce-Hg, Pr-Hg, Nd-Hg, Pm-Hg, Sm-Hg, Eu-Hg, Gd-Hg, Tb-Hg, Dy-Hg, Ho-Hg, Er-Hg, Tm-Hg, Yb-Hg, Lu-Hg; |
| Fe-Ce, Sc-Ce, Ti-Ce, V-Ce, Cr-Ce, Mn-Ce, Co-Ce, Ni-Ce, Cu-Ce, Zn-Ce, Y-Ce, Zr-Ce, Nb-Ce, Mo-Ce, Tc-Ce, Ru-Ce, Rh-Ce, Pd-Ce, Ag-Ce, Cd-Ce, La-Ce, Hf-Ce, Ta-Ce, W-Ce, Re-Ce, Os-Ce, Ir-Ce, Pt-Ce, Au-Ce, Hg-Ce, Pr-Ce, Nd-Ce, Pm-Ce, Sm-Ce, Eu-Ce, Gd-Ce, Tb-Ce, Dy-Ce, Ho-Ce, Er-Ce, Tm-Ce, Yb-Ce, Lu-Ce; |
| Fe-Pr, Sc-Pr, Ti-Pr, V-Pr, Cr-Pr, Mn-Pr, Co-Pr, Ni-Pr, Cu-Pr, Zn-Pr, Y-Pr, Zr-Pr, Nb-Pr, Mo-Pr, Tc-Pr, Ru-Pr, Rh-Pr, Pd-Pr, Ag-Pr, Cd-Pr, La-Pr, Hf-Pr, Ta-Pr, W-Pr, Re-Pr, Os-Pr, Ir-Pr, Pt-Pr, Au-Pr, Hg-Pr, Ce-Pr, Nd-Pr, Pm-Pr, Sm-Pr, Eu-Pr, Gd-Pr, Tb-Pr, Dy-Pr, Ho-Pr, Er-Pr, Tm-Pr, Yb-Pr, Lu-Pr; |
| Fe-Nd, Sc-Nd, Ti-Nd, V-Nd, Cr-Nd, Mn-Nd, Co-Nd, Ni-Nd, Cu-Nd, Zn-Nd, Y-Nd, Zr-Nd, Nb-Nd, Mo-Nd, Tc-Nd, Ru-Nd, Rh-Nd, Pd-Nd, Ag-Nd, Cd-Nd, La-Nd, Hf-Nd, Ta-Nd, W-Nd, Re-Nd, Os-Nd, Ir-Nd, Pt-Nd, Au-Nd, Hg-Nd, Ce-Nd, Pr-Nd, Pm-Nd, Sm-Nd, Eu-Nd, Gd-Nd, Tb-Nd, Dy-Nd, Ho-Nd, Er-Nd, Tm-Nd, Yb-Nd, Lu-Nd; |
| Fe-Pm, Sc-Pm, Ti-Pm, V-Pm, Cr-Pm, Mn-Pm, Co-Pm, Ni-Pm, Cu-Pm, Zn-Pm, Y-Pm, Zr-Pm, Nb-Pm, Mo-Pm, Tc-Pm, Ru-Pm, Rh-Pm, Pd-Pm, Ag-Pm, Cd-Pm, La-Pm, Hf-Pm, Ta-Pm, W-Pm, Re-Pm, Os-Pm, Ir-Pm, Pt-Pm, Au-Pm, Hg-Pm, Ce-Pm, Pr-Pm, Nd-Pm, Sm-Pm, Eu-Pm, Gd-Pm, Tb-Pm, Dy-Pm, Ho-Pm, Er-Pm, Tm-Pm, Yb-Pm, Lu-Pm; |
| Fe-Sm, Sc-Sm, Ti-Sm, V-Sm, Cr-Sm, Mn-Sm, Co-Sm, Ni-Sm, Cu-Sm, Zn-Sm, Y-Sm, Zr-Sm, Nb-Sm, Mo-Sm, Tc-Sm, Ru-Sm, Rh-Sm, Pd-Sm, Ag-Sm, Cd-Sm, La-Sm, Hf-Sm, Ta-Sm, W-Sm, Re-Sm, Os-Sm, Ir-Sm, Pt-Sm, Au-Sm, Hg-Sm, Ce-Sm, Pr-Sm, Nd-Sm, Pm-Sm, Eu-Sm, Gd-Sm, Tb-Sm, Dy-Sm, Ho-Sm, Er-Sm, Tm-Sm, Yb-Sm, Lu-Sm; |
| Fe-Eu, Sc-Eu, Ti-Eu, V-Eu, Cr-Eu, Mn-Eu, Co-Eu, Ni-Eu, Cu-Eu, Zn-Eu, Y-Eu, Zr-Eu, Nb-Eu, Mo-Eu, Tc-Eu, Ru-Eu, Rh-Eu, Pd-Eu, Ag-Eu, Cd-Eu, La-Eu, Hf-Eu, Ta-Eu, W-Eu, Re-Eu, Os-Eu, Ir-Eu, Pt-Eu, Au-Eu, Hg-Eu, Ce-Eu, Pr-Eu, Nd-Eu, Pm-Eu, Sm-Eu, Gd-Eu, Tb-Eu, Dy-Eu, Ho-Eu, Er-Eu, Tm-Eu, Yb-Eu, Lu-Eu; |
| Fe-Gd, Sc-Gd, Ti-Gd, V-Gd, Cr-Gd, Mn-Gd, Co-Gd, Ni-Gd, Cu-Gd, Zn-Gd, Y-Gd, Zr-Gd, Nb-Gd, Mo-Gd, Tc-Gd, Ru-Gd, Rh-Gd, Pd-Gd, Ag-Gd, Cd-Gd, La-Gd, Hf-Gd, Ta-Gd, W-Gd, Re-Gd, Os-Gd, Ir-Gd, Pt-Gd, Au-Gd, Hg-Gd, Ce-Gd, Pr-Gd, Nd-Gd, Pm-Gd, Sm-Gd, Eu-Gd, Tb-Gd, Dy-Gd, Ho-Gd, Er-Gd, Tm-Gd, Yb-Gd, Lu-Gd; |

(continued)

| Table 4 - Combinations of elements for optional substitution of part or all of the Fe in the materials having the constituents as set out in table 2 - 3 in order to obtain quaternary or quinary combinations of constituent elements |
|---|
| Fe-Tb, Sc-Tb, Ti-Tb, V-Tb, Cr-Tb, Mn-Tb, Co-Tb, Ni-Tb, Cu-Tb, Zn-Tb, Y-Tb, Zr-Tb, Nb-Tb, Mo-Tb; Tc-Tb, Ru-Tb, Rh-Tb, Pd-Tb, Ag-Tb, Cd-Tb, La-Tb, Hf-Tb, Ta-Tb, W-Tb, Re-Tb, Os-Tb, Ir-Tb, Pt-Tb, Au-Tb, Hg-Tb, Ce-Tb, Pr-Tb, Nd-Tb, Pm-Tb, Sm-Tb, Eu-Tb, Gd-Tb, Dy-Tb, Ho-Tb, Er-Tb, Tm-Tb, Yb-Tb, Lu-Tb; |
| Fe-Dy, Sc-Dy, Ti-Dy, V-Dy, Cr-Dy, Mn-Dy, Co-Dy, Ni-Dy, Cu-Dy, Zn-Dy, Y-Dy, Zr-Dy, Nb-Dy, Mo-Dy, Tc-Dy, Ru-Dy, Rh-Dy, Pd-Dy, Ag-Dy, Cd-Dy, La-Dy, Hf-Dy, Ta-Dy, W-Dy, Re-Dy, Os-Dy, Ir-Dy, Pt-Dy, Au-Dy, Hg-Dy, Ce-Dy, Pr-Dy, Nd-Dy, Pm-Dy, Sm-Dy, Eu-Dy, Gd-Dy, Tb-Dy, Ho-Dy, Er-Dy, Tm-Dy, Yb-Dy, Lu-Dy; |
| Fe-Ho, Sc-Ho, Ti-Ho, V-Ho, Cr-Ho, Mn-Ho, Co-Ho, Ni-Ho, Cu-Ho, Zn-Ho, Y-Ho, Zr-Ho, Nb-Ho, Mo-Ho, Tc-Ho, Ru-Ho, Rh-Ho, Pd-Ho, Ag-Ho, Cd-Ho, La-Ho, Hf-Ho, Ta-Ho, W-Ho, Re-Ho, Os-Ho, Ir-Ho, Pt-Ho, Au-Ho, Hg-Ho, Ce-Ho, Pr-Ho, Nd-Ho, Pm-Ho, Sm-Ho, Eu-Ho, Gd-Ho, Tb-Ho, Dy-Ho, Er-Ho, Tm-Ho, Yb-Ho, Lu-Ho; |
| Fe-Er, Sc-Er, Ti-Er, V-Er, Cr-Er, Mn-Er, Co-Er, Ni-Er, Cu-Er, Zn-Er, Y-Er, Zr-Er, Nb-Er, Mo-Er, Tc-Er, Ru-Er, Rh-Er, Pd-Er, Ag-Er, Cd-Er, La-Er, Hf-Er, Ta-Er, W-Er, Re-Er, Os-Er, Ir-Er, Pt-Er, Au-Er, Hg-Er, Ce-Er, Pr-Er, Nd-Er, Pm-Er, Sm-Er, Eu-Er, Gd-Er, Tb-Er, Dy-Er, Ho-Er, Tm-Er, Yb-Er, Lu-Er; |
| Fe-Tm, Sc-Tm, Ti-Tm, V-Tm, Cr-Tm, Mn-Tm, Co-Tm, Ni-Tm, Cu-Tm, Zn-Tm, Y-Tm, Zr-Tm, Nb-Tm, Mo-Tm, Tc-Tm, Ru-Tm, Rh-Tm, Pd-Tm, Ag-Tm, Cd-Tm, La-Tm, Hf-Tm, Ta-Tm, W-Tm, Re-Tm, Os-Tm, Ir-Tm, Pt-Tm, Au-Tm, Hg-Tm, Ce-Tm, Pr-Tm, Nd-Tm, Pm-Tm, Sm-Tm, Eu-Tm, Gd-Tm, Tb-Tm, Dy-Tm, Ho-Tm, Er-Tm, Yb-Tm, Lu-Tm; |
| Fe-Yb, Sc-Yb, Ti-Yb, V-Yb, Cr-Yb, Mn-Yb, Co-Yb, Ni-Yb, Cu-Yb, Zn-Yb, Y-Yb, Zr-Yb, Nb-Yb, Mo-Yb, Tc-Yb, Ru-Yb, Rh-Yb, Pd-Yb, Ag-Yb, Cd-Yb, La-Yb, Hf-Yb, Ta-Yb, W-Yb, Re-Yb, Os-Yb, Ir-Yb, Pt-Yb, Au-Yb, Hg-Yb, Ce-Yb, Pr-Yb, Nd-Yb, Pm-Yb, Sm-Yb, Eu-Yb, Gd-Yb, Tb-Yb, Dy-Yb, Ho-Yb, Er-Yb, Tm-Yb, Lu-Yb; |
| Fe-Lu, Sc-Lu, Ti-Lu, V-Lu, Cr-Lu, Mn-Lu, Co-Lu, Ni-Lu, Cu-Lu, Zn-Lu, Y-Lu, Zr-Lu, Nb-Lu, Mo-Lu, Tc-Lu, Ru-Lu, Rh-Lu, Pd-Lu, Ag-Lu, Cd-Lu, La-Lu, Hf-Lu, Ta-Lu, W-Lu, Re-Lu, Os-Lu, Ir-Lu, Pt-Lu, Au-Lu, Hg-Lu, Ce-Lu, Pr-Lu, Nd-Lu, Pm-Lu, Sm-Lu, Eu-Lu, Gd-Lu, Tb-Lu, Dy-Lu, Ho-Lu, Er-Lu, Tm-Lu, Yb-Lu. |

Hence, for use according to the present invention, any combination of two elements as set out in table 4 above can be substituted partly or in full with respect to Fe appearing in the combinations of constituents of the materials as listed in table 2 or 3, leading to quaternary thermoelectric compositions comprising no iron, or quinary thermoelectric compositions comprising iron.

By way of illustration, it is seen that the use according to the present invention relates to a material having the combination of constituents: Fe-Mn-Sb-Te: Table 3, first group, combination 6 lists the combination of the constituents: Fe-Sb-Te. By fully substituting Fe in this combination with the combination Fe-Mn (as appearing in Table 4, sixth group, first combination, the result is a combination of the constituents Fe-Mn-Sb-Te.

In one embodiment, the use according to the present invention relates to a quaternary thermoelectric material comprising a combination of four different constituent elements, wherein said combination being selected from the group of combinations comprising:

Fe-Sb-C-S, Fe-Sb-C-Se, Fe-Sb-C-Te, Fe-Sb-Si-S, Fe-Sb-Si-Se, Fe-Sb-Si-Te, Fe-Sb-Ge-S, Fe-Sb-Ge-Se, Fe-Sb-Ge-Te, Fe-Sb-Sn-S, Fe-Sb-Sn-Se, Fe-Sb-Sn-Te, Fe-Sb-Pb-S, Fe-Sb-Pb-Se, Fe-Sb-Pb-Te.

In a preferred embodiment of such a quaternary composition, the element in the third position and the element in the fourth position are present in equal molar amounts.

In another embodiment, the use according to the present invention relates to a quaternary thermoelectric material comprising a combination of four different constituent elements, wherein said combination being selected from the group of combinations comprising:

Fe-Sb-B-S, Fe-Sb-B-Se, Fe-Sb-B-Te, Fe-Sb-Al-S, Fe-Sb-Al-Se, Fe-Sb-Al-Te, Fe-Sb-Ga-S, Fe-Sb-Ga-Se, Fe-Sb-Ga-Te, Fe-Sb-In-S, Fe-Sb-In-Se, Fe-Sb-In-Te, Fe-Sb-Tl-S, Fe-Sb-Tl-Se, Fe-Sb-Tl-Te.

In a preferred embodiment of such a quaternary composition, the ratio of the molar amount of the element in the third position to the molar amount of the element in the fourth position is 1:2.

Types of possible substitution of Fe and Sb in $FeSb_2$

The present invention originates from the Inventors' surprisingly findings that the semiconductor $FeSb_2$ exhibits an extremely high power factor at low temperature (the power factor $S^2\sigma$ is higher than 2000 $\mu$W/cmK$^2$ at approximately 10 K).

In fact it is impossible to predict the low-temperature thermoelectric properties in respect of each and every of the combinations of constituents elements making up the thermoelectric material for use according to the present invention.

However, in the section below it is substantiated that based on the newly discovered low-temperature thermo-electric properties of $FeSb_2$, it is highly plausible that substitution of part of or all Fe with an element selected form the group comprising: Sc, Ti, V, Cr, Mn, Co, Ni, Cu, Zn, Y, Zr, Nb, Mo, Tc, Ru, Rh, Pd, Ag, Cd, La, Hf, Ta, W, Re, Os, Ir, Pt, Au, Hg, Ce, Pr, Nd, Pm, Sm, Eu, Gd, Tb, Dy, Ho, Er, Tm, Yb, Lu and a vacancy; and/or substitution of part of or all Sb with one or more elements selected from the group comprising: P, As, Bi, S, Se, Te, B, Al, Ga, In, Tl, C, Si, Ge, Sn, Pb and a vacancy, will lead to thermoelectric materials having thermoelectric properties similar to those of $FeSb_2$

A prerequisite for good thermoelectric properties is a low charge carrier (e.g. electrons or holes) density which is obtained in semiconductors or semimetals. All $TX_2$, $TXY$ and $TY_2$, with the Marcasite, Pyrite or Arsenopyrite structure and with $T$ = Sc, Ti, V, Cr, Mn, Co, Ni, Cu, Zn, Y, Zr, Nb, Mo, Tc, Ru, Rh, Pd, Ag, Cd, La, Hf, Ta, W, Re, Os, Ir, Pt, Au, Hg and $X$ = P, As, Sb, Bi and $Y$ = S, Se, Te are, with a few exceptions, semiconductors (F. Hulliger and E. Mooser, J. Phys. Chem. Solids 26, 429 (1965); J. B. Goodenough, J. Solid State Chem. 5, 144 (1972)) and therefore potentially good thermoelectric materials.

Besides this new rare-earth (La, Ce, Pr, Nd, Pm. Sm, Eu, Gd, Tb, Dy, Ho, Er, Tm, Yb, Lu), actinide or transition metal (Sc, Ti, V, Cr, Mn, Co, Ni, Cu, Zn, Y, Zr, Nb, Mo, Tc, Ru, Rh, Pd, Ag, Cd, Hf, Ta, W, Re, Os, Ir, Pt, Au, Hg) containing semiconductors have received renewed attention within the past 10-15 years.

Some of these compounds show temperature dependent electronic properties and are referred to as strongly correlated semiconductors or Kondo insulators (G. Aeppli and Z. Fisk, Comments Cond. Mat. Phys. 16, 155 (1992); P. S. Riseborough, Adv. Phys. 49, 257 (2000)).They are characterised by a small hybridisation energy gap at the Fermi level from mixing of a broad conduction band with a narrow $d$- or $f$-band (G. Aeppli and Z. Fisk, Comments Cond. Mat. Phys. 16, 155 (1992); P. S. Riseborough, Adv. Phys. 49, 257 (2000)).

Concerning thermoelectric applications, much of the interest in strongly correlated semiconductors comes from the fact that strong Coulomb repulsion between the $d$- or $f$-electrons leads to a large (and asymmetric) electronic density of states at the band edges of hybridisation gap. This favours a large thermoelectric power factor (G. D. Mahan, in Solid State Physics, Vol 51, 1998), Vol. 51, p. 81).

Theoretically, strongly correlated semiconductors have been treated by dynamical mean field theory using the periodic Anderson model (M. J. Rozenberg, G. Kotliar and H. Kajueter, Phys. Rev. B 54, 8452 (1996)) and calculations of S have recently appeared (J. K. Freericks, D. O. Demchenko, A. V. Joura and V. Zlatic, Phys. Rev. 68,195120 (2003); T. Saso and K. Urasaki, J. Phys. Chem. Solids 63, 1475 (2002) and C. Grenzebach and G. Czycholl, Physica B 359, 732 (2005)). These results are model dependent but have shown that a large $S$ combined with reasonably low $\rho$ is possible at low temperatures (J. K. Freericks, D. O. Demchenko, A. V. Joura and V. Zlatic, Phys. Rev. 68,195120 (2003)). It is the opinion of the present Inventors that $FeSb_2$ is an example of a strongly correlated semiconductor.

It is well known that the electronic properties (e.g. Seebeck coefficient and electrical resistivity) are very similar among isoelectronic compounds and it is very likely that isoelectronic compounds like $FeSb_{2-x}Y_x$ [$Y$ = P, As, Sb, Bi], $FeSb_{2-2x}Y_xZ_x$ [$Y$ = Si, Ge, Sn, Pb and Z = S, Se, Te], $FeSb_{2-3x}Y_xZ_{2x}$ [$Y$ = Al, Ga, In, Tl and Z = S, Se, Te] exhibit similar properties. This appear to be the case for Kondo insulators/strongly correlated semiconductors too (G. Aeppli and Z. Fisk, Comments Cond. Mat. Phys. 16, 155 (1992)). It is in principle possible to make an isoelectronic substitution of Fe by transition elements (Ru, Os) as well, however, the valence of transition and rare-earth elements is not as well-defined as for the non $d$- and $f$-electron elements, potentially making any transition or rare-earth element substitution isoelectronic.

Besides this it well known that thermoelectric properties can be optimized by dop-ing/substitution for two reasons a) the charge carrier concentration can be varied and an optimum thermoelectric power factor can be found (G. A. Slack, CRC Handbook of Thermoelectrics (CRC Press LLC, 1995)), b) The lattice thermal conductivity can be reduced by increased disorder scattering (G. A. Slack, CRC Handbook of Thermoelectrics (CRC Press LLC, 1995)). Substitution of either Fe or Sb with any element has the potential to become a very good thermoelectric material.

Combining the facts that the $TX_2$, $TXY$ and $TY_2$ compounds are i) almost all semiconducting, ii) transition-metal containing and iii) that $FeSb_2$ is a strongly correlated semiconductor, all these compounds are potentially strongly correlated semiconductors with thermoelectric properties similar to $FeSb_2$.

At temperatures below 100 K the umklapp phonon scattering starts to diminish and the thermal conductivity of low charge carrier density materials starts to be determined by impurities, imperfection etc. in the material. By reducing the thermal conductivity the *ZT* value can be further improved. This is done by introducing imperfections (e.g. vacancies), disorder (e.g. elemental substitution, alloys), spatially extended objects (e.g. synthesizing the material as a nano- and/or micro-sized composite or thin film/super lattice).

Maximum degree of substitution of Fe and Sb in $FeSb_2$

With respect to all possible combinations of constituent elements making up the thermoelectric material for use according to the present invention, it is not possible to predict the maximum degree in which the Fe and/or Sb of the formula $FeSb_2$ can be substituted and the thermoelectric properties of the compositions can only be verified by experimental measurements.

It is obvious that minute substitutions of Fe and/or Sb in $FeSb_2$ will lead to only minute changes in the thermoelectric properties of a material having the formula $FeSb_2$ and comprising such substitution(s), compared to the properties of the $FeSb_2$-material itself. On the other hand, when Fe and/or Sb in $FeSb_2$ is substituted in large amounts (e.g. 50 - 75 mol%) it more likely that the thermoelectric properties of the resulting material deviates to a larger extent, as compared to the properties of the $FeSb_2$-material itself.

Accordingly, with respect to each specific combination of constituent elements of the materials for use according to the present invention, the exact composition which gives optimum performance as to thermoelectric properties must be determined experimentally.

In one embodiment of the use according to the present invention it is contemplated that the thermoelectric material is a material having the stoichiometric formula $FeSb_2$, wherein total ratio of substitution of the Fe atoms is 0.1 - 50 mol%, such as 0.2 - 40 mol%, e.g. 0.3 - 30 mol%, e.g. 0.5 - 25 mol%, such as 1.0 - 20 mol%, e.g. 2 - 15 mol%, such as 3 -10 mol%, e.g. 5 - 8 mol% in relation to the Fe content of $FeSb_2$. In another embodiment according to the present invention it is contemplated that the thermoelectric material is a material having the stoichiometric formula $FeSb_2$, wherein the total ratio of substitution of the Sb atoms is 0.1- 50 mol%, such as 0.2 - 40 mol%, for example 0.3 - 30 mol%, e.g. 0.5 - 25 mol%, such as 1.0 - 20 mol%, e.g. 2 - 15 mol%, such as 3 - 10 mol%, e.g. 5 - 8 mol% in relation to the Sb content of $FeSb_2$.

The above stated possible substitution degrees of Fe and Sb in $FeSb_2$ are applicable in respect of all stoichiometries of the thermoelectric materials for use according to claim 2.

Structural and functional features of the materials for use according to the present invention

It is preferred that the thermoelectric material of the use according to the present invention is a material having a structure corresponding or similar to that of pyrite, marcasite, or arsenopyrite.

It is preferred that the thermoelectric material of the use according to the present invention is a material having a single crystal structure.

In one embodiment according to the use according to the present invention the thermoelectric material comprises a nano- and/or micro-sized composite of two or more different materials mentioned in any of the claims 2 - 16 or 24 - 40. A nano- and/or micro-sized composite material is defined as consisting of two or more types of materials, mentioned in any of the claims 2 - 16 or 24 - 40 where the spatial extend of the grains of each material in the composite ranges from ~1 nm (= $1 \cdot 10^{-9}$ m) to ~10 $\mu$m (= $10 \cdot 10^{-6}$ m). A person skilled in the art of materials synthesis will know how to prepare such composites.

In another embodiment according to the use according to the present invention the thermoelectric material comprises a thin film/super lattice of two or more layers of any of the materials mentioned in any of the claims 2 - 16 or 24 - 40. A thin film/super lattice is defined as alternating layers of two or more types of the materials mentioned in any of the claims 2-14, where the thickness of each layer ranges from ~1 nm (= $1 \cdot 10^{-9}$ m) to ~10 $\mu$m (= $10 \cdot 10^{-6}$ m). A person skilled in the art of materials synthesis will know how to prepare such thin films and super lattices.

In a preferred embodiment according to the use according to the present invention, the thermoelectric properties of the thermoelectric material is utilised at a temperature of 125 K or less, most preferred at a temperature of 100 K or less, such as at a temperature of 50 K or less, for example at a temperature of 25 K or less, such as at a temperature of 15 K or less; or at 10 K or less.

In a preferred embodiment according to the use according to the present invention the thermoelectric material has a power factor ($S^2\sigma$) of 25 $\mu$W/cmK$^2$ or more at a temperature of 150 K or less, such as at a temperature of 125 K or less, most preferred at a temperature of 100 K or less, such as at a temperature of 50 K or less, for example at a temperature of 25 K or less, such as at a temperature of 15 K or less; or at 10 K or less.

It is preferred that the thermoelectric material at least at one of the temperatures indicated above exhibits a power factor ($S^2\sigma$) of 50 $\mu$W/cmK$^2$ or more, such as 100 $\mu$W/cmK$^2$ or more, for example 200 $\mu$W/cmK$^2$ or more, such as 500 $\mu$W/cmK$^2$ or more, e.g. 1000 $\mu$W/cmK$^2$ or more, preferably 1500 $\mu$W/cmK$^2$ or more, such as 2000 $\mu$W/cmK$^2$ or

more.

In one embodiment according to the use according to the present invention the thermoelectric purpose relates to thermoelectric cooling utilising the Peltier effect.

In another embodiment according to the use according to the present invention the thermoelectric purpose relates to thermoelectric temperature sensing utilising the Seebeck effect.

II - The thermoelectric materials according to the invention

In a second aspect the present invention relates to a thermoelectric material per se. The thermoelectric material according to the present invention is a material generally described as having a stoichiometry corresponding to the stoichiometric formula $FeSb_2$, wherein all or part of the Fe atoms optionally being substituted by one or more elements selected from the group comprising: Sc, Ti, V, Cr, Mn, Co, Ni, Cu, Zn, Y, Zr, Nb, Mo, Tc, Ru, Rh, Pd, Ag, Cd, La, Hf, Ta, W, Re, Os, Ir, Pt, Au, Hg, Ce, Pr, Nd, Pm, Sm, Eu, Gd, Tb, Dy, Ho, Er, Tm, Yb, Lu and a vacancy; and wherein all or part of the Sb atoms optionally being substituted by one or more elements selected from the group comprising: P, As, Bi, S, Se, Te, B, Al, Ga, In, Tl, C, Si, Ge, Sn, Pn and a vacancy; with the proviso that neither one of the elements Fe and Sb in the formula $FeSb_2$ is fully substituted with a vacancy; and with the proviso that the thermoelectric material is not a binary composition; and with the proviso that the thermoelectric material is not a non-alloy ternary composition of the stoichiometric formula: *TXY,* wherein *T* is an element selected from the group comprising: Sc, Ti, V, Cr, Mn, Fe, Co, Ni, Cu, Zn, Y, Zr, Nb, Mo, Tc, Ru, Rh, Pd, Ag, Cd, La, Hf, Ta, W, Re, Os, Ir, Pt, Au, Hg; and wherein *X* is an element selected from the group comprising: P, As, Sb, Bi; and wherein *Y* is an element selected from the group comprising: S, Se, Te.

By non-alloy it is meant that the elements are arranged in a periodically ordered manner on atomic scale and where one specific site can be assigned to one specific element.

The inventive thermoelectric material according to the present invention relates to all the compositions and/or compounds which are specifically mentioned in the section above relating to the use according to a fist aspect according to the present invention with the exception of binary compositions; and with the exception of non-alloy ternary compositions of the stoichiometric formula: *TXY,* wherein *T* is an element selected from the group comprising: Sc, Ti, V, Cr, Mn, Fe, Co, Ni, Cu, Zn, Y, Zr, Nb, Mo, Tc, Ru, Rh, Pd, Ag, Cd, La, Hf, Ta, W, Re, Os, Ir, Pt, Au, Hg; and wherein *X* is an element selected from the group comprising: P, As, Sb, Bi; and wherein *Y* is an element selected from the group comprising: S, Se, Te.

Accordingly, the present invention relates to all the combinations of constituent elements satisfying the general definitions above and which are:

- listed in table 2 or 3; or
- constructed from a composition as set out in table 2 or 3 by substituting Fe with one element elected from the group comprising: Sc, Ti, V, Cr, Mn, Co, Ni, Cu, Zn, Y, Zr, Nb, Mo, Tc, Ru, Rh, Pd, Ag, Cd, La, Hf, Ta, W, Re, Os, Ir, Pt, Au, Hg, Ce, Pr, Nd, Pm, Sm, Eu, Gd, Tb, Dy, Ho, Er, Tm, Yb, Lu; or
- constructed from a composition as set out in table 2 or 3 by partly or fully substituting Fe with a combination of constituent elements as set out in table 4.

Hence, depending on the number of different elements substituted for Fe and Sb respectively in the formula $FeSb_2$, different types of thermoelectric materials appear. Accordingly, the thermoelectric material according to the present invention may be ternary (i.e. consisting of three different elements), quaternary (i.e. consisting of four different elements), quinary (i.e. consisting of five different elements), or even of higher order (i.e. consisting of more than five different elements).

In one embodiment of the present invention, the thermoelectric material is a material of the general description above, wherein part of the Fe atoms optionally being substituted by one or more elements selected from the group comprising: Sc, Ti, V, Cr, Mn, Co, Ni, Cu, Zn, Y, Zr, Nb, Mo, Tc, Ru, Rh, Pd, Ag, Cd, La, Hf, Ta, W, Re, Os, Ir, Pt, Au and Hg and a vacancy; and wherein part of the Sb atoms optionally being substituted by one or more elements selected from the group comprising: P, As, Bi, S, Se, Te and a vacancy.

In another embodiment of the present invention, the thermoelectric material is a material of the general description above, wherein part of the Fe atoms optionally being substituted by one or more elements selected from the group comprising: Sc, Ti, V, Cr, Mn, Co, Ni, Cu, Zn, Y, Zr, Nb, Mo, Tc, Ru, Rh, Pd, Ag, Cd, La, Hf, Ta, W, Re, Os, Ir, Pt, Au and Hg and a vacancy; and wherein part of the Sb atoms optionally being substituted by one or more elements selected from the group comprising: B, Al, Ga, In, Tl, C, Si, Ge, Sn, Pb and a vacancy.

In still another embodiment of the present invention, the thermoelectric material is a material of the general description above, wherein part of the Fe atoms optionally being substituted by one or more elements selected from the group comprising: Ce, Pr, Nd, Pm, Sm, Eu, Gd, Tb, Dy, Ho, Er, Tm, Yb, Lu and a vacancy; and wherein part of the Sb atoms optionally being substituted by one or more elements selected from the group comprising: P, As, Bi, S, Se, Te and a vacancy.

In yet another embodiment of the present invention, the thermoelectric material is a material of the general description above, wherein part of the Fe atoms optionally being substituted by one or more elements selected from the group comprising: Ce, Pr, Nd, Pm, Sm, Eu, Gd, Tb, Dy, Ho, Er, Tm, Yb, Lu and a vacancy; and wherein part of the Sb atoms optionally being substituted by one or more elements selected from the group comprising: B, Al, Ga, In, Tl, C, Si, Ge, Sn, Pb and a vacancy.

In a preferred embodiment of the present invention, the thermoelectric material is a material of the general description above, wherein the thermoelectric material comprises three different elements.

In one embodiment of the present invention, the thermoelectric material is a ternary composition of the general description above, wherein part of or all the Fe optionally being substituted by one or two elements selected from the group comprising: Mn, Co, and Ru; and wherein part of or all the Sb optionally being substituted by one or two elements selected from the group comprising: Sb, Bi, As and P.

In a preferred embodiment of the present invention, the ternary composition of the general description above is composed of a combination of 3 different constituent elements, said combination being selected from the group of combinations comprising: Fe-Ru-Sb, Fe-Mn-Sb, Fe-Co-Sb, Fe-Sn-Se, Fe-Pb-Te, Fe-Sn-Te, Fe-Sb-Te, Fe-Sb-Sn, and Fe-Sb-As.

In one embodiment of the present invention, the thermoelectric material is a quaternary composition of the general description above, wherein the thermoelectric material is composed of a combination of 4 different constituent elements, said combination being selected from the group of combinations comprising: Fe-Sb-C-S, Fe-Sb-C-Se, Fe-Sb-C-Te, Fe-Sb-Si-S, Fe-Sb-Si-Se, Fe-Sb-Si-Te, Fe-Sb-Ge-S, Fe-Sb-Ge-Se, Fe-Sb-Ge-Te, Fe-Sb-Sn-S, Fe-Sb-Sn-Se, Fe-Sb-Sn-Te, Fe-Sb-Pb-S, Fe-Sb-Pb-Se, Fe-Sb-Pb-Te.

In a preferred embodiment according to the present invention such quaternary composition has a stoichiometry wherein the element in the third position and the element in the fourth position are present in equal molar amounts.

In another embodiment of the present invention, the thermoelectric material is a quaternary composition of the general description above, wherein the thermoelectric material is composed of a combination of 4 different constituent elements, said combination being selected from the group of combinations comprising: Fe-Sb-B-S, Fe-Sb-B-Se, Fe-Sb-B-Te, Fe-Sb-Al-S, Fe-Sb-Al-Se, Fe-Sb-Al-Te, Fe-Sb-Ga-S, Fe-Sb-Ga-Se, Fe-Sb- Ga-Te, Fe-Sb-In-S, Fe-Sb-In-Se, Fe-Sb-In-Te, Fe-Sb-Tl-S, Fe-Sb-Tl-Se, Fe-Sb-Tl-Te.

In a preferred embodiment according to the present invention such quaternary composition has a stoichiometry wherein the ratio of the molar amount of the element in the third position to the molar amount of the element in the fourth position is 1:2.

In one embodiment the thermoelectric material according to the present invention is a material having the stoichiometric formula $FeSb_2$, wherein the total ratio of substitution of the Fe atoms is 0.1 - 50 mol%, such as 0.2 - 40 mol%, e.g. 0.3 - 30 mol%, e.g. 0.5 - 25 mol%, such as 1.0 - 20 mol%, e.g. 2 -15 mol%, such as 3 -10 mol%, e.g. 5 - 8 mol% in relation to the Fe content of $FeSb_2$.

In another embodiment the thermoelectric material according to the present invention is a material having the stoichiometric formula $FeSb_2$, wherein the total ratio of substitution of the Sb atoms is 0.1 - 50 mol%, such as 0.2 - 40 mol%, e.g. 0.3 - 30 mol%, e.g. 0.5 - 25 mol%, such as 1.0 - 20 mol%, e.g. 2 -15 mol%, such as 3 -10 mol%, e.g. 5 - 8 mol% in relation to the Sb content of $FeSb_2$.

<u>Structural and functional features of the materials according to the present invention</u>

It is preferred that the thermoelectric material according to the present invention is a material having a structure corresponding or similar to that of pyrite, marcasite, or arsenopyrite.

It is preferred that the thermoelectric material according to the present invention has a single crystal structure.

In one embodiment according to the present invention the thermoelectric material comprises a nano- and/or micro-sized composite of two or more different materials mentioned in any of the claims 2 - 16 or 24 - 40. A nano- and/or micro-sized composite material is defined as consisting of two or more types of materials, mentioned in any of the claims 2 -16 or 24 - 40 where the spatial extend of the grains of each material in the composite ranges from ~1 nm (= $1 \cdot 10^{-9}$ m) to ~10 $\mu$m (= $10 \cdot 10^{-6}$ m).

In another embodiment according to the present invention the thermoelectric material comprises a thin film/ super lattice of two or more layers of any of the materials mentioned in any of the claims 2 - 16 or 24 - 40. A thin film/ super lattice is defined as alternating layers of two or more types of the materials mentioned in any of the claims 2 - 16 or 24 - 40, where the thickness of each layer ranges from ~1 nm (= $1 \cdot 10^{-9}$ m) to ~10 $\mu$m (= $10 \cdot 10^{-6}$ m).

In a preferred embodiment according to the present invention the thermoelectric material has a power factor ($S^2\sigma$) of 25 $\mu$W/cmK$^2$ or more at a temperature of 150 K or less, such as at a temperature of 125 K or less, most preferred at a temperature of 100 K or less, such as at a temperature of 50 K or less, for example at a temperature of 25 K or less, such as at a temperature of 15 K or less; or at 10 K or less.

It is preferred that the thermoelectric material at least at one of the temperatures indicated above exhibits a power factor ($S^2\sigma$) of 50 $\mu$W/cmK$^2$ or more, such as 100 $\mu$W/cmK$^2$ or more, for example 200 $\mu$W/cmK$^2$ or more, such as 500 $\mu$W/cmK$^2$ or more, e.g. 1000 $\mu$W/cmK$^2$ or more, preferably 1500 $\mu$W/cmK$^2$ or more, such as 2000 $\mu$W/cmK$^2$ or more.

<u>III - Method of manufacture of the thermoelectric materials according to the invention</u>

In a third aspect the present invention relates to a process for the manufacture of a thermoelectric material according to the invention.

<u>Single crystals (Pure materials and alloys)</u>

Single crystalline $FeSb_2$ samples are prepared by a flux method. The binary Fe-Sb phase diagram (T. Massalski, Binary Alloys Phase Diagrams, 2nd ed. (ASM International, 1996)) shows that the liquidus curve decreases with increasing Sb content in the Sb-rich region. There exists two peritectic points that connected to the composition $FeSb_2$ by a peritectoid at 88.8%, 99.2% Sb-molar % and at 738 $^\circ$C and 628 $^\circ$C, respectively. This suggests that $FeSb_2$ can be crystallized by mixing Fe and Sb in the molar ratio 11.2:88.8 ~ 1:7.9 and by cooling slowly from 738 $^\circ$C to 628 $^\circ$C. However, due to potential uncertainties in the phase diagram, the Sb content should be larger 1:7.9 (e.g. 1:11.5) in order to prevent other phases than $FeSb_2$ to crystallize. Besides this the ranges with slow cooling rates should be started at higher temperatures e.g. 775 $^\circ$C and ensures homogenous temperature conditions and cooling rates when the temperature decrease below the temperature at which $FeSb_2$ starts to crystallize. The minimum temperature of the slow cooling rates should be slightly larger than 628 $^\circ$C (e.g. 640 $^\circ$C) to prevent sudden crystallization of $FeSb_2$ when the peritectic point at 628 $^\circ$C is reached.

To prevent oxidation and unwanted reactions with air the elements should be placed in a sealed ampoule with an inert atmosphere (e.g. argon) or vacuum before heating. Remaining Sb-flux after the crystallization can be removed by heating the reactants to above the melting point of Sb (631 $^\circ$C) but below the melting point of $FeSb_2$ (738 $^\circ$C) (T. Massalski, Binary Alloys Phase Diagrams, 2nd ed. (ASM International, 1996)) and decant the liquid or by other methods separate the solid from the liquid.

To ensure homogenous thermal conditions the crucible is isolated thoroughly with e.g. mineral wool.

An alloy where either Fe or Sb is substituted with one or more elements is made in a similar way. It can be expected that the pseudo binary phase diagram is similar to that of Fe-Sb (liquidus curves and peritectic points are at the same temperatures and compositions) if the substitutions are small. Otherwise other phase diagrams that reflect the compositions of the alloy can be used for obtaining good temperature- and compositions-parameters can be used.

The actual composition of the alloy may deviate from the nominal composition and the actual composition can be tuned by either reducing or increasing the nominal composition.

<u>Alternative methods</u>

Single crystals can be gown by a gas-transport reaction method as described in A. K. L. Fan et al. J. Solid State Chem. 5, 136 (1972).

Single crystals can be pulled by a modified Czochralski method. Due to the incongruently melting $FeSb_2$ phase an off-stoichiometry melt with a surplus of antimony is used. Pulling crystals from a non-stoichiometric melt is described in e.g. M. Burianek et al. Journal of Crystal Growth, 166 (1-4), 361 (1996).

A similar technique is the Bridgeman technique. A temperature gradient is applied along a horizontal reaction vessel, the position of which is kept fixed. The temperature gradient is maintained but the average temperature is decreased. Precipitation of $FeSb_2$ will occur from Sb rich melts. This method was used to produce single crystalline $RuSb_2$ as described in T. Caillat et al. J. Phase Equilibria, 14(5), 576 (1993).

A variant of the Bridgeman technique is the Stockbarger method where the temperature and gradient are fixed. The reaction vessel is slowly pulled towards the cold end. See e.g. S. Elliott. The Physics and Chemistry of Solids, Chichester (1998).

Polycrystalline samples can be synthesized as described in A. Bentien et al. Phys. Rev. B 74, 205105 (2006).

Single crystalline and homogeneous polycrystalline samples are prepared using the zone refinement technique described in S. Elliott. The Physics and Chemistry of Solids, Chichester (1998).

<u>Composites</u>

Composite materials can be made from two or more materials that e.g. can be synthesized as described above under the heading *Single Crystals.* The powdering can be done by ball-milling the materials in an inert atmosphere until the wanted average grain-size is obtained. The compaction of the composite is performed with both pressure and/or heat e.g. spark plasma sintering or hot pressing. A person skilled in the art of materials synthesis will know how to prepare such composites.

### Thin films/super lattices

Thin films and super lattices are prepared by either sputtering, e-beam evaporation, pulsed laser deposition, thermal evaporation, electron beam evaporation, molecular beam epitaxy or similar methods (see e.g. Handbook of Thin-Film Deposition Processes and Techniques - Principles, Methods, Equipment and Applications (2nd edition), Ed. By K. Seshan, William Andrew Publishing/Noyes (2002)). A person skilled in the art of materials synthesis will know how to prepare such thin films and super lattices.

### IV - Thermocouples

In a fourth aspect, the present invention relates to a thermocouple. According to this aspect, the obtained thermoelectric material is used as one out of two legs in a thermocouple. By cutting this material in suitable sizes, or in other ways adjusting the dimension to the application, and arranging and connecting this together with a dissimilar thermoelectric material, a thermocouple is obtained in a way known per se. See for example "Frank Benhard; Technische Temperaturmessung; Springer Berlin, 2003; ISBN 3540626727".

### V - Use of a thermocouple for the manufacture of a thermoelectric device

In a fifth aspect according to the present invention the obtained thermocouple is used for the manufacture of a thermoelectric device.
Such uses are well-known for a person skilled in the art of thermoelectrics.

### VI - A thermoelectric device

A sixth aspect according to the present invention relates to a thermoelectric device per se. The device is obtained by combining one or more thermocouples. A person skilled in the art of thermoelectrics will know how to obtain such a thermoelectric device once he has obtained the thermocouple according to the present invention.

**Examples**

**Example 1 - 12 - Preparation of the thermoelectric materials**

### Example 1 - Preparation of the prior art composition $FeSb_2$ (in Sb flux)

Pure $FeSb_2$ samples are prepared by a flux method. 0.95882 g bulk Fe (Alfa Aesar Puratronic® 99.995% metals basis) and 24.04118 g bulk Sb (Alfa Aesar Puratronic® 99.9999% metals basis) are mixed in an alumina crucible which is sealed inside an evacuated quartz ampoule. The ampoule is isolated with mineral wool and heated fast (over approximately 6 hours) to 1050 °C and left there for 2 hours, followed by cooling to 775 °C over 14 hours and finally cooling to 640 °C over 15 days. The Sb-flux is removed by centrifuging at 690 °C on top of small broken quartz pieces inside an evacuated quartz ampoule. To remove any remaining Sb-flux on the $FeSb_2$ samples they are cleaned in an ultra sonic bath of Aqua Regia for 3-8 minutes. Relatively large single crystals are obtained. The resulting samples can be seen in Fig. 1 - 3.

### Example 2 - Preparation of the prior art composition $FeSb_2$ (in Bi flux)

The samples are prepared by a flux method using a melt with nominal stoichiometry $Fe_8Sb_{16.1}Bi_{75.9}$. 0.61137 g bulk Fe (Alfa Aesar Puratronic® 99.995% metals basis) and 2.68264 g bulk Sb (Alfa Aesar Puratronic® 99.9999% metals basis) and 21.70598 g bulk Bi (Strem chemicals 99.999+ % metals basis) are mixed in an alumina crucible which is sealed inside an evacuated quartz ampoule. The ampoule is isolated with mineral wool and heated fast (over approximately 6 hours) to 1450 °C and left there for 2 hours, followed by cooling to 775 °C over 14 hours and finally cooling to 640 °C over 15 days. The flux is removed by centrifuging at 690 °C on top of small broken quartz pieces inside an evacuated quartz ampoule.

Example 3 - Preparation of the composition FeSb$_{2-2x}$Pb$_x$Se$_x$ x = 0.1, 0.5 according to the present invention

FeSb$_{2-2x}$Pb$_x$Se$_x$, x = 0.1, 0.5 is prepared by a flux synthesis. Bulk Fe (Alfa Aesar 99.98 % metals basis), bulk Sb (ESPI metals 99.9999% metals basis), bulk Pb (ESPI metals 99.99 9% metals basis) and bulk Se (ESPI metals 99.999 % metals basis) are mixed in an alumina crucible which is sealed inside an evacuated quartz ampoule. The ampoule is isolated with mineral wool and heated fast (over approximately 6 hours) to 1050 ˚C and left there for 2 hours, followed by cooling to 800 ˚C over 14 hours and finally cooling to 600 ˚C over with a cooling rate of 1 ˚Ch$^{-1}$. The flux is removed by centrifuging at 690 ˚C on top of small broken quartz pieces inside an evacuated quartz ampoule. To remove any remaining flux on the samples they are cleaned in an ultra sonic bath of Aqua Regia for 3-8 minutes. Relatively large single crystals are obtained.
Compositions having the stoichiometries as set out in the table below were made.

| Element | x = 0.1 | x = 0.5 |
|---------|---------|---------|
| Fe | 0.56577 g | 0.53062 g |
| Sb | 12.76726 g | 6.65229 g |
| Pb | 1.20701 g | 5.66013 g |
| Se | 0.45997 g | 2.15697 g |

Example 4 - Preparation of the composition Fe$_{1-x}$Ru$_x$Sb$_2$; x = 0.03, 0.1 according to the present invention

The samples are prepared by a flux method. Bulk Fe (Alfa Aesar Puratronic® 99.995% metals basis), bulk Ru (Chempur 99.95% metals basis) and bulk Sb (Alfa Aesar Puratronic® 99.9999% metals basis) are mixed in an alumina crucible which is sealed inside an evacuated quartz ampoule. The ampoule is isolated with mineral wool and heated fast (over approximately 6 hours) to 1050 ˚C and left there for 2 hours, followed by cooling to 775 ˚C over 14 hours and finally cooling to 640 ˚C over 15 days. The flux is removed by centrifuging at 690 ˚C on top of small broken quartz pieces inside an evacuated quartz ampoule. To remove any remaining flux on the samples they are cleaned in an ultra sonic bath of Aqua Regia for 3-8 minutes. Relatively large single crystals are obtained.
Compositions having the stoichiometries as set out in the table below were made.

| Element | x = 0.03 | x = 0.1 |
|---------|----------|---------|
| Fe | 0.92919 g | 0.86027 g |
| Sb | 24.01880 g | 23.96674 g |
| Ru | 0.05201 g | 0.17299 g |

Example 5 - Preparation of the composition Fe$_{1-x}$Mn$_x$Sb$_2$; x = 0.003, 0.01, 0.03, 0.1 according to the present invention

The samples are prepared by a flux method. Bulk Fe (Alfa Aesar Puratronic® 99.995% metals basis) and bulk Sb (Alfa Aesar Puratronic® 99.9999% metals basis) and bulk Mn (Alfa Aesar 99.99 % metals basis) are mixed in an alumina crucible which is sealed inside an evacuated quartz ampoule. The ampoule is isolated with mineral wool and heated fast (over approximately 6 hours) to 1050 ˚C and left there for 2 hours, followed by cooling to 775 ˚C over 14 hours and finally cooling to 640 ˚C over 15 days. The Sb-flux is removed by centrifuging at 690 ˚C on top of small broken quartz pieces inside an evacuated quartz ampoule. To remove any remaining flux on the samples they are cleaned in an ultra sonic bath of Aqua Regia for 3-8 minutes. Relatively large single crystals are obtained.
Compositions having the stoichiometries as set out in the table below were made.

| Element | x = 0.003 | x = 0.01 | x = 0.03 | x = 0.1 |
|---------|-----------|----------|----------|---------|
| Fe | 0.95595 g | 0.94924 g | 0.93007 g | 0.86299 g |
| Sb | 24.04122 g | 24.04133 g | 24.04163 g | 24.04268 g |
| Mn | 0.00283 g | 0.00943 g | 0.02830 g | 0.09433 g |

Example 6 - Preparation of the composition $Fe_{1-x}Co_xSb_2$; $x = 0.003, 0.01, 0.03, 0.1$ according to the present invention

Pure $FeSb_2$ samples are prepared by a flux method. Bulk Fe (Alfa Aesar Puratronic® 99.995 % metals basis) and bulk Sb (Alfa Aesar Puratronic® 99.9999 % metals basis) and bulk Co (Alfa Aesar Puratronic® 99.995 % metals basis) are mixed in an alumina crucible which is sealed inside an evacuated quartz ampoule. The ampoule is isolated with mineral wool and heated fast (over approximately 6 hours) to 1050 ˚C and left there for 2 hours, followed by cooling to 775 ˚C over 14 hours and finally cooling to 640 ˚C over 15 days. The Sb-flux is removed by centrifuging at 690 ˚C on top of small broken quartz pieces inside an evacuated quartz ampoule. To remove any remaining flux on the samples they are cleaned in an ultra sonic bath of Aqua Regia for 3-8 minutes. Relatively large single crystals are obtained.

Compositions having the stoichiometries as set out in the table below were made.

| Element | $x = 0.003$ | $x = 0.01$ | $x = 0.03$ | $x = 0.1$ |
|---------|-------------|------------|------------|-----------|
| Fe | 0.95594 g | 0.94921 g | 0.93000 g | 0.86276 g |
| Sb | 24.04103 g | 24.04067 g | 24.03965 g | 24.03608 g |
| Co | 0.00304 g | 0.01012 g | 0.03035 g | 0.10116 g |

Example 7 - Preparation of the composition $FeSb_{2-2x}Sn_xSe_x$; $x = 0.1, 0.5$ according to the present invention

$FeSb_{2-2x}Sn_xSe_x$, $x = 0.1, 0.5$ is prepared by a flux synthesis. Bulk Fe (Alfa Aesar 99.98 % metals basis), bulk Sb (ESPI metals 99.9999% metals basis), bulk Sn (ESPI metals 99.999% metals basis) and bulk Se (ESPI metals 99.999 % metals basis) are mixed in an alumina crucible which is sealed inside an evacuated quartz ampoule. The ampoule is isolated with mineral wool and heated fast (over approximately 6 hours) to 1050 ˚C and left there for 2 hours, followed by cooling to 800 ˚C over 14 hours and finally cooling to 600 ˚C over with a cooling rate of 1 ˚Ch⁻¹. The flux is removed by centrifuging at 690 ˚C on top of small broken quartz pieces inside an evacuated quartz ampoule. To remove any remaining flux on the samples they are cleaned in an ultra sonic bath of Aqua Regia for 3-8 minutes. Relatively large single crystals are obtained.

Compositions having the stoichiometries as set out in the table below were made.

| Element | $x = 0.1$ | $x = 0.5$ |
|---------|-----------|-----------|
| Fe | 0.58590 g | 0.63256 g |
| Sn | 0.71614 g | 3.86582 g |
| Se | 0.47634 g | 2.57135 g |
| Sb | 13.22163 g | 7.93028 g |

Example 8 - Preparation of the composition $FeSb_{2-2x}Pb_xTe_x$; $x = 0.1, 0.5$ according to the present invention

$FeSb_{2-2x}Pb_xTe_x$, $x = 0.1, 0.5$ is prepared by a flux synthesis. Bulk Fe (Alfa Aesar 99.98 % metals basis), bulk Sb (ESPI metals 99.9999% metals basis), bulk Pb (ESPI metals 99.999% metals basis) and bulk Te (ESPI metals 99.999 % metals basis) are mixed in an alumina crucible which is sealed inside an evacuated quartz ampoule. The ampoule is isolated with mineral wool and heated fast (over approximately 6 hours) to 1050 ˚C and left there for 2 hours, followed by cooling to 800 ˚C over 14 hours and finally cooling to 600 ˚C over with a cooling rate of 1 ˚Ch⁻¹. The flux is removed by centrifuging at 690 ˚C on top of small broken quartz pieces inside an evacuated quartz ampoule. To remove any remaining flux on the samples they are cleaned in an ultra sonic bath of Aqua Regia for 3-8 minutes. Relatively large single crystals are obtained.

Compositions having the stoichiometries as set out in the table below were made.

| Element | $x = 0.1$ | $x = 0.5$ |
|---------|-----------|-----------|
| Fe | 0.55528 g | 0.48744 g |
| Pb | 1.18463 g | 5.19955 g |
| Te | 0.72953 g | 3.20204 g |
| Sb | 12.53056 g | 6.11097 g |

Example 9 - Preparation of the composition $FeSb_{2-2x}Sn_xTe_x$; $x$ = 0.1, 0.5 according to the present invention

$FeSb_{2-2x}Sn_xTe_x$, $x$ = 0.1, 0.5 is prepared by a flux synthesis. Bulk Fe (Alfa Aesar 99.98 % metals basis), bulk Sb (ESPI metals 99.9999% metals basis), bulk Sn (ESPI metals 99.999% metals basis) and bulk Te (ESPI metals 99.999 % metals basis) are mixed in an alumina crucible which is sealed inside an evacuated quartz ampoule. The ampoule is isolated with mineral wool and heated fast (over approximately 6 hours) to 1050 ˚C and left there for 2 hours, followed by cooling to 800 ˚C over 14 hours and finally cooling to 600 ˚C over with a cooling rate of 1 ˚Ch⁻¹. The flux is removed by centrifuging at 690 ˚C on top of small broken quartz pieces inside an evacuated quartz ampoule. To remove any remaining flux on the samples they are cleaned in an ultra sonic bath of Aqua Regia for 3-8 minutes. Relatively large single crystals are obtained.
Compositions having the stoichiometries as set out in the table below were made.

| Element | $x$ = 0.1 | $x$ = 0.5 |
|---------|-----------|-----------|
| Fe | 0.57466 g | 0.57214 g |
| Sn | 0.70240 g | 3.49658 g |
| Te | 0.75500 g | 3.75844 g |
| Sb | 12.96795 g | 7.17284 g |

Example 10 - Preparation of the composition $FeSb_{2-x}Te_x$; $x$ = 0.02 according to the present invention

The samples are prepared by a flux method. 0.95838 g bulk Fe (Alfa Aesar Puratronic® 99.995% metals basis) and 23.78979 g bulk Sb (Alfa Aesar Puratronic® 99.9999% metals basis) and 0.25183 g bulk Te (Alfa Aesar 99.999 % metals basis) are mixed in an alumina crucible which is sealed inside an evacuated quartz ampoule. The ampoule is isolated with mineral wool and heated fast (over approximately 6 hours) to 1050 ˚C and left there for 2 hours, followed by cooling to 775 ˚C over 14 hours and finally cooling to 640 ˚C over 15 days. The flux is removed by centrifuging at 690 ˚C on top of small broken quartz pieces inside an evacuated quartz ampoule.

Example 11 - Preparation of the composition $FeSb_{2-x}Sn_x$; $x$ = 0.02 according to the present invention

The samples are prepared by a flux method. 0.95905 g bulk Fe (Alfa Aesar Puratronic® 99.995% metals basis) and 23.80650 g bulk Sb (Alfa Aesar Puratronic® 99.9999% metals basis) and 0.23445 g bulk Sn (Chempur 99.9999 % metals basis) are mixed in an alumina crucible which is sealed inside an evacuated quartz ampoule. The ampoule is isolated with mineral wool and heated fast (over approximately 6 hours) to 1050 ˚C and left there for 2 hours, followed by cooling to 775 ˚C over 14 hours and finally cooling to 640 ˚C over 15 days. The flux is removed by centrifuging at 690 ˚C on top of small broken quartz pieces inside an evacuated quartz ampoule.

Example 12 - Preparation of the composition $FeSb_{2-x}As_x$; $x$ = 0.3, 0.8 according to the present invention

The samples are prepared by a flux method. Bulk Fe (Alfa Aesar Puratronic® 99.995% metals basis), bulk Sb (Alfa Aesar Puratronic® 99.9999% metals basis) and bulk As (Chempur 99.9999 % metals basis) are mixed in a glassy carbon crucible which is sealed inside an evacuated quartz ampoule. The ampoule is isolated with mineral wool and heated fast (over approximately 6 hours) to 850 ˚C and left there for 12 hours, followed by cooling to 775 ˚C over 14 hours and finally cooling to 600 ˚C over 15 days. The flux is removed by centrifuging at 690 ˚C on top of small broken quartz pieces inside an evacuated quartz ampoule.
Compositions having the stoichiometries as set out in the table below were made.

| Element | $x$ = 0.3 | $x$ = 0.8 |
|---------|-----------|-----------|
| Fe | 0.40606 g | 0.45013 g |
| Sb | 8.65421 g | 6.77192 g |
| As | 0.93973 g | 2.77794 g |

**Example 13 - 18: Experimental results; thermoelectric measurements**

<u>Example 13 - Orientation of samples and measurement of thermoelectric properties</u>

The crystal are oriented by a combination of Laue photos and measuring the reflection X-ray intensity on a powder diffractometer using $\theta$, $2\theta$ geometry (see Fig. 4). $\rho(T)$, $S(T)$ and $\kappa(T)$ were measured on a Physical Properties Measurement System (PPMS) from Quantum Design. $\rho(T)$ is determined with a normal four point AC method.

Due to the large thermal conductivity and relatively small sample dimensions, the thermal resistivity of the sample can be small compared with the thermal resistivity between the sample and sample holder. This leads to a sample heating ($\Delta T_2$) that can be considerable compared to the sample temperature difference ($\Delta T_1$) across the sample. To diminish $\Delta T_2$, a special sample holder has been constructed in which the sample can be very tightly screwed/mounted to the sample holder. This is seen in Fig. 5 showing the situation before and after mounting of a sample.

Cernox thermometers and the heater are mounted directly with N-grease onto the thermometer and heater holders, respectively. 50 $\mu$m manganin wires are used for connecting the heater and thermometers, and they are approximately 20 cm long. This reduces the thermal conductance from heater and the thermometers to the sample holder by a factor of at least 10, compared to the original setup in the TTO (Thermal Transport Option) sample holder to the PPMS from Quantum Design.

Because of the large thermal mass of the sample-holder pieces (thermometer, holders etc.) compared to the sample, the approximations regarding the relaxation times used in the algorithm in the quasi-static measurement of $S$ and $\kappa$ (O. Maldonado, Cryogenics 32, 908-912 (1992)) in the PPMS no longer apply. Instead a steady state technique up to 45 K is used, and the data are analysed separately by software developed by the inventors. Fig. 6 shows details of a typical measurement of $S$ and $\kappa$ at two different temperatures.

<u>Example 14 - Thermoelectric properties of FeSb$_2$</u>

Pure FeSb$_2$ has very promising thermoelectric properties. Fig. 7 shows all the important thermoelectric parameters. FeSb$_2$ has an orthorhombic atomic arrangement meaning that the physical properties potentially can be different depending on the direction in which they are measured in (anisotropy). In Fig. 7, *a, b* and *c* refer to different spatial directions of measurements.

One striking feature is the extremely large negative peak in $S(T)$ observed at 10 K - 20 K, the magnitude of $S$ being 10-100 times larger than in classical semiconductors. The most important part of Fig. 7 is the plot of the power factor, as can be seen it reaches a value of almost 2500 $\mu$Wcm$^{-1}$K$^2$ along the c-direction. This value is more than 10 times larger than highest value ever measured and is approximately 50 times larger than that of the Bi$_2$Te$_3$-Sb$_2$Te$_3$ alloys.

However, for pure FeSb$_2$ $k(T)$ is as large as 500 WK$^{-1}$m$^{-1}$ and degrades the maximum $ZT$-value to 0.005 at 15 K. Nonetheless, in thin films, alloys and composites etc. $k \sim 1$ WK$^{-1}$m$^{-1}$ and if this is inserted in $ZT = (S^2/\rho)\cdot k^{-1}\cdot T \sim 1$-3 in the temperature range from 10 K - 30 K thus emphasizing the potential of FeSb$_2$ as thermoelectric material at the these low temperatures.

The thermoelectric properties have been measured on several samples along all directions. Along the c-direction data is shown for two different samples from the same batch, and represents the two samples with the largest differences. The Inventors believe that this difference is due to tiny differences in samples (e.g. tiny differences, of the order <1%, in composition, quality etc.). The data show that the maximum of $|S(T)|$($S_{max}$), among all samples, increases with $\rho(T)$ at anomalous bump in the temperature range from 10 K to 30 K. This indicates anisotropy plays a minor role on the size of $S_{max}$ and it is determined by the same parameters as the differences between the two samples measured along the c-direction.

However, at 300 K anisotropy in the Seebeck coefficient and lattice thermal conductivity ($\kappa_L$) is always observed where $S_a \sim S_b \sim 40$ $\mu$VK$^{-1}$, $S_c \sim 0$ $\mu$VK$^{-1}$ and , $\kappa_{L,a} \sim \kappa_{L,b} \sim 4.5$ Wm$^{-1}$K$^{-1}$, $\kappa_{L,c} \sim 6.5$ Wm$^{-1}$K$^{-1}$ where the subscript refers to the direction.

<u>Example 15 - Thermoelectric properties of Fe$_{1-x}$Mn$_x$Sb$_2$ and Fe$_{1-x}$Co$_x$Sb$_2$</u>

In the following the thermoelectric properties of some of these samples are presented.

Figs. 8, 9 and 11 shows the thermoelectric properties of Fe$_{1-x}$Mn$_x$Sb$_2$ $x$ = 0.003, 0.01, 0.03, 0.1. Compared to the pure ($x$ = 0) it is seen that $\rho(T)$ at the lowest temperatures $(T < 5$ K) has a tendency to increase for the samples with $x$ = 0.003 and 0.01 whereas it decreases significantly for the $x$ = 0.1 sample. In the temperature range (10 K to 30 K) of the anomaly in $\rho(T)$ it is seen that $\rho(T)$ decreases smoothly with increasing $x$. At room temperature $\rho(T)$ is similar for all $x$.

For the $x$ = 0.003 samples $S(T)$ is similar to the pure samples although $|S_{max}|$ is smaller. As $x$ increases it is seen that $S(T)$ becomes more monotonic and the positive peak observed around 35 K is suppressed. At room temperature $S(T)$ is anisotropic and similar for all samples. Since $\rho(T)$ is decreased, $S(T)$ becomes more monotonic and $S_{max}$ is

shifted to higher temperatures the *PF* has a tendency to become broader as *x* increases. For the *x* = 0.01 sample the $PF > 100$ $\mu Wcm^{-1}K^{-2}$ below 50 K. As expected, $\kappa_L(T)$ is reduced upon doping. The large variance of $\kappa_L(T)$ for the *x* = 0.003 samples could be erroneous due to geometry factor determinations or bad sample quality. However, for the *x* = 0.01 sample a small bump in $\kappa_L(T)$ appears around 15 K to 40 K, and for the *x* = 0.1 sample a significant reduction is seen whole temperature range below 100 K.

Fig. 12 shows the thermoelectric properties of the $Fe_{1-x}Co_xSb_2$ *x* = 0.003 samples. Compared to the pure (*x* = 0) sample it is seen that $\rho(T)$ at temperatures below the anomaly is increased and in one sample (*//a*) the anomaly has almost disappeared. For all sample $|S_{max}|$ has decreased compared to the pure samples. It is interesting to note that for the *//a*-sample where $\rho(T)$ is largest and the $\rho(T)$-anomaly is almost disappeared $|S_{max}|$ is also the smallest. However, the positive peak in $S(T)$ above 30 K for the *//α*-sample is much larger than for the other samples. Besides this a positive peak is also observed for the *//c*-sample as opposed to the pure *//c*-samples where $S(T) < 0$ in the whole temperature range.

Since both $S(T)$ is reduced and $\rho(T)$ is increased the *PF* is decreased compared to the pure samples. $\kappa_L(T)$ has a tendency to decrease, but the Co amount is too small to make significant reduction.

Substitution with both Mn and Co appear to decrease $|S_{max}|$ Above approximately 30 K to 50 K they appear to have opposite effect. Mn substitution leads to a more negative $S(T)$ while Co substitution leads to a more positive $S(T)$. At room temperature $S(T)$ is unchanged compared to the pure samples. For both Mn and Co substitution $\kappa_L(T)$ is decreased and thereby favouring improved thermoelectric properties. However, only substitution with Mn appears reasonable since it can shift the maximum of the *PF* to higher temperature.

### Example 16 - Thermoelectric properties of $Fe_{1-x}Ru_xSb_2$

Fig. 13 shows the thermoelectric properties of $Fe_{1-x}Ru_xSb_2$ *x* = 0.1 samples. The $\rho(T)$ curves appear similar although $\rho(T)$ appear to be increased compared to the pure $FeSb_2$ in the temperature range anomaly. For all $Fe_{1-x}Ru_xSb_2$ *x* = 0.1 samples $|S_{max}|$ is decreased compared to the pure $FeSb_2$ samples. The local maximum observed above 35 K for the pure samples has disappeared and instead $S(T)$ increases monotonically. At room temperature $S(T)$ is unchanged compared to the pure samples. Because of the lower the change of $S(T)$ the maximum of the *PF* has been shifted to much higher temperatures. Again also $\kappa_L(T)$ is significantly reduced at lower temperatures.

### Example 17 - Thermoelectric properties of $FeSb_{2-x}Te_x$ and $FeSb_{2-x}Sn_x$

Figs. 14 and 15 shows the thermoelectric properties of $FeSb_{2-x}Sn_x$ and $FeSb_{2-x}Te_x$ along the *a, c*- and the *a, b*-directions respectively. For the $FeSb_{2-x}Sn_x$ samples a relatively large variation in the properties between the two samples is observed. However, in both cases $\rho(T)$ remains semiconducting-like upon substitution with Sn. At lowest temperatures, where $\rho(T)$ varies little with temperature, the region has been extended to higher temperatures. $S(T)$ for the $FeSb_{2-x}Sn_x$ samples becomes positive in the temperature range where the pure $FeSb_2$ samples exhibit the colossal negative Seebeck coefficient. This opens the possibility to make both *p*- and *n*-type elements. The thermoelectric properties are relatively poor due to a relatively low Seebeck coefficient and relatively large resistivity. As expected $\kappa_L(T)$ is significantly reduced at lower temperatures.

For the $FeSb_{2-x}Te_x$ the effect of substitution is different. In particular $\rho(T)$ becomes metal-like with decreasing $\rho(T)$ as the temperature decreases below approximately 150 K. A similar effect is seen in $S(T)$ where the magnitude of the negative peak is decreased compared to the pure $FeSb_2$ samples. The *PF* and *ZT*-value is broadened and the maximum is shifted to higher temperatures are of relatively large values. $\kappa_L(T)$ is significantly reduced at lower temperatures and of the same magnitude as observed for the $FeSb_{2-x}Sn_x$ samples.

### Example 18 - Thermoelectric properties of $FeSb_{2-2x}Pb_xSe_x$ and $FeSb_{2-2x}Sn_xSe_x$

This type of substitution is also referred to as compensated doping or substitution, because the electronic configuration does not change in $FeSb_{2-2x}V_xA_x$, where *V* = C, Si, Ge, Sn, Pb and Z = P, As, Sb, Bi, since *Y* has one electron less and Z has one electron more than Sb.

Figs. 16 and 17 shows the thermoelectric properties of $FeSb_{2-2x}Pb_xSe_x$ *x* = 0.5 and $FeSb_{2-2x}Sn_xSe_x$ *x* = 0.5, respectively. For all samples $\rho(T)$ has become metal-like and increases with temperature in the whole temperature range. $S(T)$ is fundamentally different compared to the pure samples and a maximum close to 100 K is seen. Because of this the maximum of the *PF* has become very broad and shifted to approximately 100 K. For all samples the magnitude of $\kappa_L(T)$ has been reduced significantly and is of the order 1-10 $Wm^{-1}K^{-1}$. The metal-like behaviour of the electronic transport properties indicates that the substitution of the Sb with Pb, Se and Sn, Se is not equal and that the proper formulas are $FeSb_{2-x-y}Pb_xSe_y$ and $FeSb_{2-x-y}Sn_xSe_y$, but where *x* and *y* are of similar magnitude.

Compensated doping appears to be attractive in order to improve the thermoelectric properties of $FeSb_2$. The

above results ($Fe_{1-x}Mn_xSb_2$, $Fe_{1-x}Co_xSb_2$, $Fe_{1-x}Ru_xSb_2$) have shown that normal substitution leads to a decrease of the PF because the magnitude of $S(T)$ decreases without improving $\rho(T)$. The compensated doping can reduce $\kappa_L(T)$ significantly as seen from figs. 16 and 17, and when $x$ and $y$ in $FeSb_{2-x-y}V_xZ_y$ are balanced by increasing/decreasing the relative amounts the large $PF$ of $FeSb_2$ can be obtained.

**Claims**

1.  Use of a thermoelectric material for a thermoelectric purpose at a temperature of 150 K or less.

2.  Use according to claim 1, wherein the thermoelectric material is a material corresponding to the stoichiometric formula $FeSb_2$, wherein all or part of the Fe atoms optionally being substituted by one or more elements selected from the group comprising: Sc, Ti, V, Cr, Mn, Co, Ni, Cu, Zn, Y, Zr, Nb, Mo, Tc, Ru, Rh, Pd, Ag, Cd, La, Hf, Ta, W, Re, Os, Ir, Pt, Au, Hg, Ce, Pr, Nd, Pm, Sm, Eu, Gd, Tb, Dy, Ho, Er, Tm, Yb, Lu and a vacancy; and wherein all or part of the Sb atoms optionally being substituted by one or more elements selected from the group comprising: P, As, Bi, S, Se, Te, B, Al, Ga, In, Tl, C, Si, Ge, Sn, Pb and a vacancy; with the proviso that neither one of the elements Fe and Sb in the formula $FeSb_2$ is fully substituted with a vacancy.

3.  Use according to claim 2, wherein the thermoelectric material comprises two different elements.

4.  Use according to claim 3, wherein the thermoelectric material is $FeSb_2$, $FeBi_2$, $FeAs_2$ or $FeP_2$.

5.  Use according to claim 2, wherein the thermoelectric material comprises three different elements.

6.  Use according to claim 5, wherein the thermoelectric material is a material, wherein part of or all Fe optionally being substituted by one or two elements selected from the group comprising: Mn, Co, and Ru; and wherein part of or all Sb optionally being substituted by one or two elements selected from the group comprising: Sb, Bi, As and P.

7.  Use according to claim 6, wherein the thermoelectric material is composed of a combination of 3 different constituent elements, said combination being selected from the group of combinations comprising:

    Fe-Ru-Sb, Fe-Mn-Sb, Fe-Co-Sb, Fe-Sn-Se, Fe-Pb-Te, Fe-Sn-Te, Fe-Sb-Te, Fe-Sb-Sn, and Fe-Sb-As.

8.  Use according to claim 2, wherein the thermoelectric material comprises four dif ferent elements.

9.  Use according to claim 8, wherein the thermoelectric material is composed of a combination of 4 different constituent elements, said combination being selected from the group of combinations comprising:

    Fe-Sb-C-S, Fe-Sb-C-Se, Fe-Sb-C-Te, Fe-Sb-Si-S, Fe-Sb-Si-Se, Fe-Sb-Si-Te, Fe-Sb-Ge-S, Fe-Sb-Ge-Se, Fe-Sb-Ge-Te, Fe-Sb-Sn-S, Fe-Sb-Sn-Se, Fe-Sb-Sn-Te, Fe-Sb-Pb-S, Fe-Sb-Pb-Se, Fe-Sb-Pb-Te.

10. Use according to claim 8, wherein the thermoelectric material is composed of a combination of 4 different constituent elements, said combination being selected from the group of combinations comprising:

    Fe-Sb-B-S, Fe-Sb-B-Se, Fe-Sb-B-Te, Fe-Sb-Al-S, Fe-Sb-Al-Se, Fe-Sb-Al-Te, Fe-Sb-Ga-S, Fe-Sb-Ga-Se, Fe-Sb-Ga-Te, Fe-Sb-In-S, Fe-Sb-In-Se, Fe-Sb-In-Te, Fe-Sb-Tl-S, Fe-Sb-Tl-Se, Fe-Sb-Tl-Te.

11. Use according to claim 9, wherein the element in the third position and the element in the fourth position are present in equal molar amounts.

12. Use according to claim 10, wherein the ratio of the molar amount of the element in the third position to the molar amount of the element in the fourth position is 1:2.

13. Use according to claim 2 - 3 or 5 - 8, wherein the total ratio of substitution of the Fe atoms is 0.1 - 50 mol%, such as 0.2 - 40 mol%, for example 0.3 - 30 mol%, e.g. 0.5 - 25 mol%, such as 1.0 - 20 mol%, for example 2 -15 mol%, such as 3 -10 mol%, e.g. 5 - 8 mol% in relation to the Fe content of $FeSb_2$.

14. Use according to claim 2 - 3 or 5 -12, wherein the total ratio of substitution of the Sb atoms is 0.1 - 50 mol%, such as 0.2 - 40 mol%, for example 0.3 - 30 mol%, e.g. 0.5 - 25 mol%, such as 1.0 - 20 mol%, for example 2 -15 mol%, such as 3 -10 mol%, e.g. 5 -8 mol% in relation to the Sb content of $FeSb_2$.

15. Use according to any of the claims 2 - 14, wherein the material having a structure corresponding to that of pyrite, marcasite, or arsenopyrite.

16. Use according to any of the claims 2 - 15, wherein the thermoelectric material has a single crystal structure.

17. Use according to any of the claims 2 - 15, wherein the thermoelectric material comprises a composite of two or more different micro- and/or nano-sized materials mentioned in any of the claims 2 - 16.

18. Use according to any of claims 2 - 15, wherein the thermoelectric material comprises a thin film/super lattice of two or more layers of any of the materials mentioned in any of the claims 2-16.

19. Use according to any of the preceding claims at a temperature of 125 K or less, most preferred at a temperature of 100 K or less, such as at a temperature of 50 K or less, for example at a temperature of 25 K or less, such as at a temperature of 15 K or less; or at 10 K or less.

20. Use according to any of the preceding claims, wherein the thermoelectric material has a power factor ($S^2\sigma$) of 25 $\mu$W/cmK$^2$ or more at a temperature of 150 K or less, such as at a temperature of 125 K or less, most preferred at a temperature of 100 K or less, such as at a temperature of 50 K or less, for example at a temperature of 25 K or less, such as at a temperature of 15 K or less; or at 10 K or less.

21. Use according to claim 20, wherein the thermoelectric material at least at one of the indicated temperatures exhibits a power factor ($S^2\sigma$) of 50 $\mu$W/cmK$^2$ or more, such as 100 $\mu$W/cmK$^2$ or more, for example 200 $\mu$W/cmK$^2$ or more, such as 500 $\mu$W/cmK$^2$ or more, e.g. 1000 $\mu$W/cmK$^2$ or more, preferably 1500 $\mu$W/cmK$^2$ or more, such as 2000 $\mu$W/cmK$^2$ or more.

22. Use according to any of the preceding claims, wherein the thermoelectric purpose relates to thermoelectric cooling utilising the Peltier effect.

23. Use according to any of the claims 1-21, wherein the thermoelectric purpose relates to thermoelectric temperature sensing utilising the Seebeck effect.

24. A thermoelectric material having a stoichiometry corresponding to the stoichiometric formula $FeSb_2$, wherein all or part of the Fe atoms optionally being substituted by one or more elements selected from the group comprising: Sc, Ti, V, Cr, Mn, Co, Ni, Cu, Zn, Y, Zr, Nb, Mo, Tc, Ru, Rh, Pd, Ag, Cd, La, Hf, Ta, W, Re, Os, Ir, Pt, Au, Hg, Ce, Pr, Nd, Pm, Sm, Eu, Gd, Tb, Dy, Ho, Er, Tm, Yb, Lu and a vacancy; and wherein all or part of the Sb atoms optionally being substituted by one or more elements selected from the group comprising: P, As, Bi, S, Se, Te, B, Al, Ga, In, Tl, C, Si, Ge, Sn, Pn and a vacancy; with the proviso that neither one of the elements Fe and Sb in the formula $FeSb_2$ is fully substituted with a vacancy; and with the proviso that the thermoelectric material is not a binary composition; and with the proviso that the thermoelectric material is not a non-alloy ternary composition of the stoichiometric formula: *TXY*, wherein *T* is an element selected from the group comprising: Sc, Ti, V, Cr, Mn, Fe, Co, Ni, Cu, Zn, Y, Zr, Nb, Mo, Tc, Ru, Rh, Pd, Ag, Cd, La, Hf, Ta, W, Re, Os, Ir, Pt, Au, Hg; and wherein *X* is an element selected from the group comprising: P, As, Sb, Bi; and wherein *Y* is an element selected from the group comprising: S, Se, Te.

25. A thermoelectric material according to claim 24, wherein the thermoelectric material comprises three different elements.

26. A thermoelectric material according to claim 25, wherein the thermoelectric material is a material, wherein part of or all the Fe optionally being substituted by one or two elements selected from the group comprising: Mn, Co, and Ru; and wherein part of or all the Sb optionally being substituted by one or two elements selected from the group comprising: Sb, Bi, As and P.

27. A thermoelectric material according to claim 26, wherein the thermoelectric material is composed of a combination of 3 different constituent elements, said combination being selected from the group of combinations comprising: Fe-Ru-Sb, Fe-Mn-Sb, Fe-Co-Sb, Fe-Sn-Se, Fe-Pb-Te, Fe-Sn-Te, Fe-Sb-Te, Fe-Sb-Sn, and Fe-Sb-As.

**28.** A thermoelectric material according to claim 24, wherein the thermoelectric material comprises four different elements.

**29.** A thermoelectric material according to claim 28, wherein the thermoelectric material is composed of a combination of 4 different constituent elements, said combination being selected from the group of combinations comprising:

Fe-Sb-C-S, Fe-Sb-C-Se, Fe-Sb-C-Te, Fe-Sb-Si-S, Fe-Sb-Si-Se, Fe-Sb-Si-Te, Fe-Sb-Ge-S, Fe-Sb-Ge-Se, Fe-Sb-Ge-Te, Fe-Sb-Sn-S, Fe-Sb-Sn-Se, Fe-Sb-Sn-Te, Fe-Sb-Pb-S, Fe-Sb-Pb-Se, Fe-Sb-Pb-Te.

**30.** A thermoelectric material according to claim 28, wherein the thermoelectric material is composed of a combination of 4 different constituent elements, said combination being selected from the group of combinations comprising:

Fe-Sb-B-S, Fe-Sb-B-Se, Fe-Sb-B-Te, Fe-Sb-Al-S, Fe-Sb-Al-Se, Fe-Sb-Al-Te, Fe-Sb-Ga-S, Fe-Sb-Ga-Se, Fe-Sb- Ga-Te, Fe-Sb-In-S, Fe-Sb-In-Se, Fe-Sb-In-Te, Fe-Sb-Tl-S, Fe-Sb-Tl-Se, Fe-Sb-Tl-Te.

**31.** A thermoelectric material according to claim 29, wherein the element in the third position and the element in the fourth position are present in equal molar amounts.

**32.** A thermoelectric material according to claim 30, wherein the ratio of the molar amount of the element in the third position to the molar amount of the element in the fourth position is 1:2.

**33.** A thermoelectric material according to claim 24 - 28, wherein the total ratio of substitution of the Fe atoms is 0.1-50 mol%, such as 0.2 - 40 mol%, for example 0.3 - 30 mol%, e.g. 0.5 - 25 mol%, such as 1.0 - 20 mol%, for example 2-15 mol%, such as 3 -10 mol%, e.g. 5 -8 mol% in relation to the Fe content of $FeSb_2$.

**34.** A thermoelectric material according to claim 24 - 33, wherein the total ratio of substitution of the Sb atoms is 0.1 - 50 mol%, such as 0.2 - 40 mol%, for example 0.3 - 30 mol%, e.g. 0.5 - 25 mol%, such as 1.0 - 20 mol%, for example 2 -15 mol%, such as 3 -10 mol%, e.g. 5 -8 mol% in relation to the Sb content of $FeSb_2$.

**35.** A thermoelectric material according to any of the claims 24 - 34, wherein the material has a structure corresponding to that of pyrite, marcasite, or arsenopyrite.

**36.** A thermoelectric material according to any of the claims 24 - 35, wherein the thermoelectric material has a single crystal structure.

**37.** A thermoelectric material comprising a composite of two or more different micro- and/or nano-sized materials mentioned in any of the claims 2 - 16 or 24 - 36.

**38.** A thermoelectric material comprising a thin film/super lattice of two or more layers of materials mentioned in any of the claims 2 - 16 or 24 - 26.

**39.** A thermoelectric material according to any of the claims 24 - 38, wherein the thermoelectric material exhibits a power factor ($S^2\sigma$) of 25 $\mu$W/cmK$^2$ or more at a temperature of 150 K or less, such as at a temperature of 125 K or less, most preferred at a temperature of 100 K or less, such as at a temperature of 50 K or less, for example at a temperature of 25 K or less, such as at a temperature of 15 K or less; or at 10 K or less.

**40.** A thermoelectric material according to claim 39, wherein the thermoelectric material at least at one of the indicated temperatures exhibits a power factor ($S^2\sigma$) of 50 $\mu$W/cmK$^2$ or more, such as 100 $\mu$W/cmK$^2$ or more, for example 200 $\mu$W/cmK$^2$ or more, such as 500 $\mu$W/cmK$^2$ or more, e.g. 1000 $\mu$W/cmK$^2$ or more, preferably 1500 $\mu$W/cmK$^2$ or more, such as 2000 $\mu$W/cmK$^2$ or more.

**41.** A process for the preparation of a thermoelectric material comprising three or more constituent elements according to any of the claims 24 - 36 or 39 - 40, comprising the steps:

i) weighing out a desired amount of each constituent element; and mixing these elements:
ii) heating the mixture of constituent elements in an ampoule in order to obtain a melt; and
iii) cooling the melt obtained in ii) in order to obtain the thermoelectric material.

**42.** A process according to claim 41, wherein the process is a flux synthesis process.

**43.** A process according to claim 41, wherein the process is Czochralski process.

**44.** A process according to claim 41, wherein the process is a Bridgeman process.

**45.** A process according to claim 41, wherein the process is a Zone refinement process.

**46.** A thermocouple comprising one or more thermoelectric materials mentioned in any of the claims 2 - 21 or 24 - 40.

**47.** Use of a thermocouple according to claim 46 for the manufacture of a thermoelectric device.

**48.** A thermoelectric device comprising one or more thermocouples according to claim 46.

[001]

(110)

(b)

Fig. 1

a [100]

Fig. 2

Fig. 3

Fig. 4

Fig. 5

Fig. 6

Fig. 7

Fig. 8

Fig. 9

Fig. 10

Fig. 11

Fig. 12

Fig. 13

Fig. 14

Fig. 15

Fig. 16

Fig. 17

# EP 1 930 960 A1

**European Patent Office**

## EUROPEAN SEARCH REPORT

Application Number

EP 06 12 5354

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 0 506 958 A1 (KOMATSU MFG CO LTD [JP]) 7 October 1992 (1992-10-07) | 1 | INV. H01L35/18 |
| Y | * the whole document * | 46-48 | |
| X,D | BENTIEN A ET AL: "Experimental and theoretical investigations of strongly correlated FeSb2-xSnx" PHYSICAL REVIEW B (CONDENSED MATTER AND MATERIALS PHYSICS) APS THROUGH AIP USA, vol. 74, no. 20, 15 November 2006 (2006-11-15), pages 205105-1, XP002437248 ISSN: 1098-0121 | 1-45 | |
| Y | * the whole document * | 46-48 | |
| X | BENTIEN A ET AL: "Thermoelectric properties of hole doped FeSb2" THERMOELECTRICS, 2005. ICT 2005. 24TH INTERNATIONAL CONFERENCE ON CLEMSEN, SC, USA 19-23 JUNE 2005, PISCATAWAY, NJ, USA,IEEE, 19 June 2005 (2005-06-19), pages 186-188, XP010842890 ISBN: 0-7803-9552-2 | 1-45 | |
| Y | * the whole document * | 46-48 | TECHNICAL FIELDS SEARCHED (IPC) H01L C22C C01G |
| X,D | CHUNG D-Y ET AL: "CSBI4TE6: A HIGH-PERFORMANCE THERMOELECTRIC MATERIAL FOR LOW-TEMPERATURE APPLICATIONS" SCIENCE, AMERICAN ASSOCIATION FOR THE ADVANCEMENT OF SCIENCE,, US, vol. 287, 11 February 2000 (2000-02-11), pages 1024-1027, XP000953586 ISSN: 0036-8075 * figure 3 * | 1 | |
| X | US 2001/052234 A1 (VENKATASUBRAMANIAN RAMA [US]) 20 December 2001 (2001-12-20) | 1 | |
| Y | * the whole document * | 46-48 | |

-/--

The present search report has been drawn up for all claims

| Place of search | Date of completion of the search | Examiner |
|---|---|---|
| The Hague | 12 June 2007 | Kirkwood, Jonathan |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

........................................................................................
& : member of the same patent family, corresponding document

EPO FORM 1503 03.82 (P04C01)

**European Patent Office**

**EUROPEAN SEARCH REPORT**

Application Number

EP 06 12 5354

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 5 747 728 A (FLEURIAL JEAN-PIERRE [US] ET AL) 5 May 1998 (1998-05-05)<br>* the whole document *<br>----- | 1-48 | |
| A | EP 1 102 334 A (BASF AG [DE])<br>23 May 2001 (2001-05-23)<br>* column 3, line 15 *<br>----- | 1-48 | |

TECHNICAL FIELDS SEARCHED    (IPC)

The present search report has been drawn up for all claims

| Place of search | Date of completion of the search | Examiner |
|---|---|---|
| The Hague | 12 June 2007 | Kirkwood, Jonathan |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

........................................................................................................
& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 06 12 5354

This annex lists the patent family members relating to the patent documents cited in the above-mentioned European search report.
The members are as contained in the European Patent Office EDP file on
The European Patent Office is in no way liable for these particulars which are merely given for the purpose of information.

12-06-2007

| Patent document cited in search report | | Publication date | Patent family member(s) | | Publication date |
|---|---|---|---|---|---|
| EP 0506958 | A1 | 07-10-1992 | JP | 2267239 A | 01-11-1990 |
| | | | JP | 2729964 B2 | 18-03-1998 |
| | | | WO | 9207387 A1 | 30-04-1992 |
| US 2001052234 | A1 | 20-12-2001 | US | 2003126865 A1 | 10-07-2003 |
| US 5747728 | A | 05-05-1998 | AU | 7515394 A | 28-02-1995 |
| | | | DE | 69426233 D1 | 07-12-2000 |
| | | | DE | 69426233 T2 | 21-06-2001 |
| | | | EP | 0712537 A1 | 22-05-1996 |
| | | | JP | 3845803 B2 | 15-11-2006 |
| | | | JP | 10510677 T | 13-10-1998 |
| | | | WO | 9504377 A1 | 09-02-1995 |
| EP 1102334 | A | 23-05-2001 | CA | 2326232 A1 | 19-05-2001 |
| | | | DE | 19955788 A1 | 23-05-2001 |
| | | | JP | 2001223392 A | 17-08-2001 |
| | | | US | 6444894 B1 | 03-09-2002 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6458319 B1


**Non-patent literature cited in the description**

- CRC Handbook of Thermoelectrics. CRC Press, 1995
- Thermoelectrics - Basic Principles and new Materials Developments. Springer Verlag, 2001
- **ROWE D.M.** *MTS Journal,* 1997, vol. 27 (3), 43-48
- **DUCK-YOUNG CHUNG et al.** *Science,* 2000, vol. 287, 1024
- **MAHAN, G. D.** *Solid State Physics,* 1998, vol. 51, 81-157
- Thermoelectrics Handbook, Macro to Nano. CRC Press, 2005
- **VENKATASUBRAMANIAN et al.** *Nature,* 2001, vol. 413, 597-602
- **F. HULLIGER ; E. MOOSER.** *J. Phys. Chem. Solids,* 1965, vol. 26, 429
- **B. GOODENOUGH.** *J. Solid State Chem.,* 1972, vol. 5, 144
- **G. AEPPLI ; Z. FISK.** *Comments Cond. Mat. Phys.,* 1992, vol. 16, 155
- **P. S. RISEBOROUGH.** *Adv. Phys.,* 2000, vol. 49, 257
- **G. D. MAHAN.** *Solid State Physics,* 1998, vol. 51, 81
- **M. J. ROZENBERG ; G. KOTLIAR ; H. KAJUETER.** *Phys. Rev. B,* 1996, vol. 54, 8452
- **J. K. FREERICKS ; D. O. DEMCHENKO ; A. V. JOURA ; V. ZLATIC.** *Phys. Rev.,* 2003, vol. 68, 195120
- **T. SASO ; K. URASAKI.** *J. Phys. Chem. Solids,* 2002, vol. 63, 1475
- **C. GRENZEBACH ; G. CZYCHOLL.** *Physica B,* 2005, vol. 359, 732
- **G. A. SLACK.** CRC Handbook of Thermoelectrics. CRC Press LLC, 1995
- **T. MASSALSKI.** Binary Alloys Phase Diagrams. ASM International, 1996
- **A. K. L. FAN et al.** *J. Solid State Chem,* 1972, vol. 5, 136
- **M. BURIANEK et al.** *Journal of Crystal Growth,* 1996, vol. 166 (1-4), 361
- **T. CAILLAT et al.** *J. Phase Equilibria,* 1993, vol. 14 (5), 576
- **S. ELLIOTT.** The Physics and Chemistry of Solids. 1998
- **A. BENTIEN et al.** *Phys. Rev. B,* 2006, vol. 74, 205105
- Handbook of Thin-Film Deposition Processes and Techniques - Principles, Methods, Equipment and Applications. William Andrew Publishing/Noyes, 2002
- **FRANK BENHARD.** Technische Temperaturmessung. Springer, 2003
- **O. MALDONADO.** *Cryogenics,* 1992, vol. 32, 908-912